(19) Europäisches Patentamt
European Patent Office
Office européen des brevets

(11) EP 4 369 886 A1

(12) **EUROPEAN PATENT APPLICATION**
published in accordance with Art. 153(4) EPC

(43) Date of publication:
**15.05.2024 Bulletin 2024/20**

(21) Application number: **22837640.6**

(22) Date of filing: **04.07.2022**

(51) International Patent Classification (IPC):
***H10K 50/00*** *(2023.01)* ***C09K 11/06*** *(2006.01)*

(52) Cooperative Patent Classification (CPC):
**C09K 11/06**

(86) International application number:
**PCT/JP2022/026567**

(87) International publication number:
**WO 2023/282224 (12.01.2023 Gazette 2023/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.07.2021 JP 2021112401**

(71) Applicant: **Kyulux, Inc.**
**Fukuoka-shi, Fukuoka 819-0388 (JP)**

(72) Inventors:
- **YOSHIZAKI Makoto**
**Fukuoka-shi, Fukuoka 819-0388 (JP)**
- **ENDO Ayataka**
**Fukuoka-shi, Fukuoka 819-0388 (JP)**
- **YOSHIZAKI Asuka**
**Fukuoka-shi, Fukuoka 819-0388 (JP)**

(74) Representative: **Zimmermann & Partner Patentanwälte mbB**
**Postfach 330 920**
**80069 München (DE)**

(54) **ORGANIC LIGHT-EMITTING ELEMENT AND DESIGN METHOD THEREFOR**

(57) An organic light emitting device including a light emitting layer containing a first organic compound, a second organic compound as a delayed fluorescent material, and a third organic compound, having lowest excited singlet energy Esi satisfying $E_{S1}(1) > E_{S1}(2) > E_{S1}(3)$. The S value of the light emitting layer is smaller than the S value of the reference light emitting layer containing other light emitting layer components than the second organic compound.

*FIG. 2*

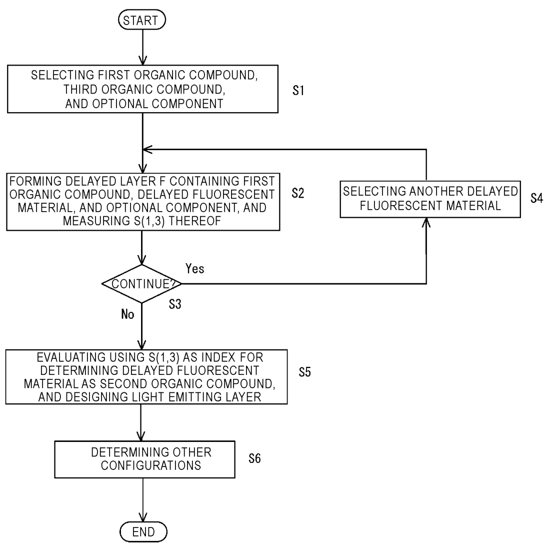


EP 4 369 886 A1

## Description

### Technical Field

The present invention relates to an organic light emitting device using a delayed fluorescent material and a method for designing the organic light emitting device. The present invention also relates to a program and a database for practicing the designing method.

### Background Art

Studies for enhancing the light emission efficiency of organic light-emitting devices such as organic electroluminescent devices (organic EL devices) are being made actively. In particular, various kinds of efforts have been made for increasing light emission efficiency by newly developing and combining an electron transporting material, a hole transporting material, a host material and a light emitting material to constitute an organic electroluminescent device. Among them, there are seen studies relating to an organic light emitting device that utilizes a delayed fluorescent material.

A delayed fluorescent material is a material which, in an excited state, after having undergone reverse intersystem crossing from an excited triplet state to an excited singlet state, emits fluorescence when returning back from the excited singlet state to a ground state thereof. Fluorescence through the route is observed later than fluorescence from the excited singlet state directly occurring from the ground state (ordinary fluorescence), and is therefore referred to as delayed fluorescence. Here, for example, in the case where a light-emitting compound is excited through carrier injection thereinto, the occurring probability of the excited singlet state to the excited triplet state is statistically 25%/75%, and therefore improvement of light emission efficiency by the fluorescence alone from the directly occurring excited singlet state is limited. On the other hand, in a delayed fluorescent material, not only the excited singlet state thereof but also the excited triplet state can be utilized for fluorescent emission through the route via the above-mentioned reverse intersystem crossing, and therefore as compared with an ordinary fluorescent material, a delayed fluorescent material can realize a higher emission efficiency.

As such a delayed fluorescent material, there has been proposed a benzene derivative having a heteroaryl group such as a carbazolyl group or a diphenylamino group, and at least two cyano groups, and it has been confirmed that an organic EL device using the benzene derivative in a light emitting layer provides a high emission efficiency (see PTL 1).

Also, NPL 1 reports that a carbazolyldicyanobenzene derivative (4CzTPN) is a thermally activated delayed fluorescent material and that an organic electroluminescent device using the carbazolyldicyanobenzene derivative attained a high internal EL quantum efficiency.

On the other hand, using a delayed fluorescent material in a light emitting layer as an assist dopant but not as a light emitting material therein has been reported (see PTL 2). This describes adding, in addition to a host material and a fluorescent material, a delayed fluorescent material having an intermediate lowest excited singlet energy between the host material and the fluorescent light emitting material to the light emitting layer to improve emission efficiency.

### Citation List

#### Patent Literature

PTL 1: JP2014-43541A

PTL 2: JP2015-179809A

#### Non-Patent Literature

NPL 1: H. Uoyama, et al., Nature 492, 234 (2012)

### Summary of Invention

#### Technical Problem

As described above, various investigations are being made for an organic electroluminescent device having a light emitting layer of a three-component system further including a delayed fluorescent material added thereto, instead

of a light emitting layer of a two-component system including a host material and a fluorescent material. However, the simple addition of a delayed fluorescent material to the light emitting layer of the two-component system cannot directly result in a good light emission capability. Therefore, even a light emitting material showing good light emission characteristics in the light emitting layer of the two-component system often fails to exert the light emission characteristics thereof in the light emitting layer containing a delayed fluorescent material as an assist dopant.

Under the circumstances, the present inventors have made earnest investigations for achieving the object, i.e., the enhancement of the light emission capability of an organic light emitting device having a light emitting layer containing a delayed fluorescent material as an assist dopant.

Solution to Problem

As a result of the earnest investigations for achieving the object, the present inventors have found that the light emission characteristics of the organic light emitting device can be enhanced through the enhancement of the orientation of the light emitting material in the light emitting layer, by selecting a delayed fluorescent material that satisfies a particular condition in relation to the light emitting material. The present invention is proposed based on the knowledge, and specifically has the following configurations.

[1] An organic light emitting device including a light emitting layer containing a first organic compound, a second organic compound, a third organic compound, and an optional component,

the second organic compound being a delayed fluorescent material,
the organic light emitting device satisfying the relationship of the following expression (a) and expression (b):

$$E_{S1}(1) > E_{S1}(2) > E_{S1}(3) \qquad (a)$$

$$S(1,2,3) < S(1,3) \qquad (b)$$

wherein

$E_{S1}(1)$ represents lowest excited singlet energy of the first organic compound,
$E_{S1}(2)$ represents lowest excited singlet energy of the second organic compound,
$E_{S1}(3)$ represents lowest excited singlet energy of the third organic compound,
S(1,2,3) represents an S value of the light emitting layer, and
S(1,3) represents an S value of a layer obtained by replacing the light emitting layer by a layer containing the first organic compound, the third organic compound, and the optional component.

[2] The organic light emitting device according to the item [1], wherein S(1,2,3) is smaller than S(1,3) by 0.03 or more.
[3] The organic light emitting device according to the item [1], wherein S(1,2,3) is smaller than S(1,3) by 0.05 or more.
[4] The organic light emitting device according to any one of the items [1] to [3], wherein the organic light emitting device satisfies the relationship of the following expression (c):

$$S(1,2) < S(1,3) \qquad (c)$$

wherein

S(1,2) represents an S value of a layer obtained by replacing the light emitting layer by a layer containing the first organic compound, the second organic compound, and the optional component, and
S(1,3) represents an S value of a layer obtained by replacing the light emitting layer by a layer containing the first organic compound, the third organic compound, and the optional component.

[5] The organic light emitting device according to any one of the items [1] to [4], wherein S(1,2) is -0.25 or less.
[6] The organic light emitting device according to any one of the items [1] to [5], wherein the light emitting layer has a concentration of the third organic compound of 6% by weight or less.
[7] The organic light emitting device according to any one of the items [1] to [6], wherein the third organic compound

is a compound having a multiple resonance effect of a boron atom and a nitrogen atom.

[8] The organic light emitting device according to any one of the items [1] to [6], wherein the third organic compound is a compound including a 4,4-difluoro-4-bora-3a,4a-diaza-s-indacene structure.

[9] The organic light emitting device according to any one of the items [1] to [8], wherein the second organic compound is a compound including a structure including a benzene ring having an acceptor group containing a nitrogen-containing heteroaryl group or a cyano group and a donor group containing a diarylamino group (in which two aryl groups constituting the diarylamino group may be bonded to each other), which are bonded to the benzene ring.

[10] The organic light emitting device according to any one of the items [1] to [9], wherein the first organic compound is a compound including two or more structures selected from the group consisting of a carbazole ring, a dibenzofuran ring, and a dibenzothiophene ring.

[11] The organic light emitting device according to any one of the items [1] to [10], wherein the organic light emitting device is an organic electroluminescent device.

[12] A method for designing an organic light emitting device including a light emitting layer containing a first organic compound, a second organic compound, and a third organic compound that satisfy the relationship of the following expression (a), and an optional component,

the method including examining and selecting a delayed fluorescent material as a candidate of the second organic compound using S(1,3) as an index and S(1,2,3) as a reference:

$$E_{S1}(1) > E_{S1}(2) > E_{S1}(3) \qquad (a)$$

wherein

$E_{S1}(1)$ represents lowest excited singlet energy of the first organic compound,
$E_{S1}(2)$ represents lowest excited singlet energy of the second organic compound,
$E_{S1}(3)$ represents lowest excited singlet energy of the third organic compound,
S(1,2,3) represents an S value of a layer containing the first organic compound, the delayed fluorescent material examined as a candidate, the third organic compound, and the optional component, as the light emitting layer, and
S(1,3) represents an S value of a layer containing the first organic compound, the third organic compound, and the optional component, as the light emitting layer.

[13] The designing method according to the item [12], wherein the designing method includes examining and selecting a delayed fluorescent material that satisfies the relationship of the following expression (c) as a candidate of the second organic compound:

$$S(1,2) < S(1,3) \qquad (c)$$

wherein

S(1,2) represents an S value of a layer containing the first organic compound, the delayed fluorescent material examined as a candidate, and the optional component, as the light emitting layer, and
S(1,3) represents an S value of a layer containing the first organic compound, the third organic compound, and the optional component, as the light emitting layer.

[14] A program including instructions for performing the method according to the item [12] or [13].

[15] A database including data of the relationship between the delayed fluorescent material and S(1,2,3) in the item [12].

[16] The database according to the item [15], wherein the database further includes data of S(1,2).

Advantageous Effects of Invention

The organic light emitting device of the present invention contains a light emitting material having a high orientation in a light emitting layer containing a delayed fluorescent material. The use of the designing method, the program, or the database of the present invention enables the convenient design of an organic light emitting device having a light emitting layer having a high orientation.

Brief Description of Drawings

Fig. 1 is a schematic cross sectional view showing an example of a layer configuration of an organic electroluminescent device.

Fig. 2 is a flow chart describing the method for designing an organic light emitting device of the present invention.

Description of Embodiment

The contents of the present invention will be described in detail below. The description of the constitutional elements described below may be made with reference to representative embodiments or specific examples of the present invention in some cases, but the present invention is not limited to the embodiments and the examples. In the description herein, the numeral range expressed by using "to" means a range that encompasses the numerals described before and after "to" as the lower limit value and the upper limit value. In the description herein, the expression "consisting of" means that only the items described before "consisting of" are contained, but no other item is contained. A part or the whole of the hydrogen atoms existing in the molecule of the compound used in the present invention may be replaced by a deuterium atom ($^2H$ or D). In the chemical structural formulae in the description herein, a hydrogen atom is shown by H, or the presence thereof is omitted. For example, the position of a benzene ring where the presence of an atom bonded to the ring skeleton-forming carbon atom thereof is omitted means that H is bonded to the ring skeleton-forming carbon atom. In the description herein, the term "substituent" means an atom or an atomic group other than a hydrogen atom and a deuterium atom. The expression "substituted or unsubstituted" means that a hydrogen atom may be replaced by a deuterium atom or a substituent.

(Features of Organic Light Emitting Device)

The organic light emitting device of the present invention has a light emitting layer containing a first organic compound, a second organic compound, a third organic compound, and an optional component. The first organic compound, the second organic compound, and the third organic compound satisfy the relationship of the following expression (a), and the second organic compound is a delayed fluorescent material.

$$E_{S1}(1) > E_{S1}(2) > E_{S1}(3) \qquad (a)$$

In the expression (a), $E_{S1}(1)$ represents lowest excited singlet energy of the first organic compound, $E_{S1}(2)$ represents lowest excited singlet energy of the second organic compound, and $E_{S1}(3)$ represents lowest excited singlet energy of the third organic compound. The present invention uses eV as the unit therefor. The lowest excited singlet energy can be obtained by preparing a thin film or a toluene solution (concentration: $10^{-5}$ mol/L) of the target compound to be measured, and measuring the fluorescent spectrum thereof at ordinary temperature (300 K) (in more detail, reference may be made to the measurement method of the lowest excited singlet energy in the description of the second organic compound).

The present invention satisfies the relationship of the expression (a), and therefore among the first organic compound, the second organic compound, and the third organic compound contained in the light emitting layer, the lowest excited singlet energy of the first organic compound is the largest, that of the second organic compound is the next largest, and that of the third organic compound is the smallest. For example, the value of $E_{S1}(1)$-$E_{S1}(2)$ may be in a range of 0.20 eV or more, may be in a range of 0.40 eV or more, or may be in a range of 0.60 eV or more, and may be in a range of 1.50 eV or less, may be in a range of 1.20 eV or less, or may be in a range of 0.80 eV or less. For example, the value of $E_{S1}(2)$-$E_{S1}(3)$ may be in a range of 0.05 eV or more, may be in a range of 0.10 eV or more, or may be in a range of 0.15 eV or more, and may be in a range of 0.50 eV or less, may be in a range of 0.30 eV or less, or may be in a range of 0.20 eV or less. For example, the value of $E_{S1}(1)$-$E_{S1}(3)$ may be in a range of 0.25 eV or more, may be in a range of 0.45 eV or more, or may be in a range of 0.65 eV or more, and may be in a range of 2.00 eV or less, may be in a range of 1.70 eV or less, or may be in a range of 1.30 eV or less.

The concentrations Conc(1), Conc(2), and Conc(3) of the first organic compound, the second organic compound, and the third organic compound, respectively, in the light emitting layer of the organic electroluminescent device of the present invention preferably satisfy the relationship of the following expression (d).

$$\mathrm{Conc}(1) > \mathrm{Conc}\ (2) > \mathrm{Conc}\ (3) \qquad (d)$$

Conc(1) is preferably 30% by weight or more, may be in a range of 50% by weight or more, or may be in a range of 60% by weight or more, and may be in a range of 99% by weight or less, may be in a range of 85% by weight or less, or may be in a range of 70% by weight or less.

Conc(2) is preferably 5% by weight or more, may be in a range of 15% by weight or more, or may be in a range of 30% by weight or more, and may be in a range of 45% by weight or less, may be in a range of 40% by weight or less, or may be in a range of 35% by weight or less.

Conc(3) is preferably 6% by weight or more, and more preferably 3% by weight or less. Conc(3) may be in a range of 0.01% by weight or more, may be in a range of 0.1% by weight or more, or may be in a range of 0.3% by weight or more, and may be in a range of 2% by weight or less, or may be in a range of 1% by weight or less.

Conc(1)/Conc(3) may be in a range of 10 or more, may be in a range of 50 or more, or may be in a range of 90 or more, and may be in a range of 10,000 or less, may be in a range of 1,000 or less, or may be in a range of 200 or less.

Conc(2)/Conc(3) may be in a range of 5 or more, may be in a range of 10 or more, may be in a range of 20 or more, may be in a range of 30 or more, or may be in a range of 50 or more, and may be in a range of 500 or less, may be in a range of 300 or less, or may be in a range of 100 or less.

The light emitting layer of the present invention may further contain or may not further contain a component in addition to the first organic compound, the second organic compound, and the third organic compound. In the case where the light emitting layer contains the first organic compound, the second organic compound, the third organic compound, and an optional component, the S value of the light emitting layer (which is shown by S(1,2,3)) is smaller than the S value of the layer containing the first organic compound, the third organic compound, and the optional component (which is referred to as a fluorescent layer F) (the S value of the fluorescent layer F is shown by S(1,3)). The fluorescent layer F is a layer obtained by excluding the second organic compound from the components constituting the light emitting layer. In this case, S(1,3) is measured by setting the concentration (% by weight) of the third organic compound in the fluorescent layer F to 6% by weight, and the result is compared to S(1,2,3). However, S(1,3) is decreased by lowering the concentration of the third organic compound in the fluorescent layer F to less than 6% by weight, and therefore, as a simplified method, it is possible that S(1,3) is measured with a concentration of the third organic compound in the fluorescent layer F of less than 6% by weight (for example, 0.5% by weight), and the result is compared to S(1,2,3) for determining the magnitude relationship thereof. In the case where S(1,2,3) is smaller than S(1,3) that is measured with a concentration of the third organic compound in the fluorescent layer F of less than 6% by weight (for example, 0.5% by weight), S(1,2,3) is also smaller than S(1,3) that is measured with a concentration of the third organic compound in the fluorescent layer F of 6% by weight. S(1,2,3) of the light emitting layer is preferably smaller than S(1,3) that is measured with a concentration of the third organic compound in the fluorescent layer F of 6% by weight by 0.03 or more, and more preferably smaller by 0.05 or more, and for example, smaller by 0.10 or more, smaller by 0.20 or more, or smaller by 0.30 or more.

The S value is also referred to as an orientation parameter or an orientation value, and is an index showing the extent of orientation of the light emitting material in the light emitting layer. A larger negative value (i.e., a smaller value) thereof means a higher orientation. The S value can be determined by the method described in Scientific Reports, 2017, 7, 8405.

The S value of the layer containing the first organic compound, the second organic compound, and the optional component (which is referred to as a delayed layer T) (the S value of the delayed layer T is shown by S(1,2)) is smaller than S(1,3), which is the S value of the fluorescent layer F containing the first organic compound, the third organic compound, and the optional component. The concentration of the second organic compound in the delayed layer T is the same as the concentration of the second organic compound in the light emitting layer. While the comparison to S(1,3) may be performed by setting the concentration of the third organic compound in the fluorescent layer F to 6% by weight, the comparison may also be performed by setting the concentration thereof to less than 6% by weight according to the same basis as described above. S(1,2) of the delayed layer T is preferably smaller than S(1,3) of the fluorescent layer F containing the third organic compound in an amount of 6% by weight by 0.05 or more, and more preferably smaller by 0.10 or more, and for example, smaller by 0.20 or more, smaller by 0.30 or more, or smaller by 0.40 or more. S(1,2) of the delayed layer T is preferably -0.20 or less, more preferably -0.25 or less, further preferably -0.30 or less, still further preferably -0.35 or less, still more further preferably -0.40 or less, and particularly preferably -0.45 or less.

The S value of the light emitting layer of the organic light emitting device of the present invention is preferably less than 0, more preferably -0.10 or less, further preferably -0.20 or less, and still further preferably -0.25 or less, and for example, may be -0.30 or less, or may be -0.40 or less.

(First Organic compound)

The first organic compound used in the light emitting layer of the organic light emitting device of the present invention is selected from compounds that have lowest excited singlet energy that is larger than the second organic compound and the third organic compound. The first organic compound preferably has a function of a host material

assuming transportation of a carrier. The first organic compound preferably has a function confining the energy of a compound that mainly emits light in the light emitting layer. According to the configuration, the compound emitting light can convert the energy generated through recombination of a hole and an electron within the molecule and the energy received from the first organic compound to light emission with high efficiency.

The first organic compound is preferably an organic compound that has a hole transporting function and an electron transporting function, prevents the light emission from becoming a longer wavelength, and has a high glass transition temperature. In one preferred embodiment of the present invention, the first organic compound is selected from a compound that does not emit delayed fluorescent light. The light emission from the first organic compound is preferably less than 1%, and more preferably less than 0.1%, for example, may be less than 0.01%, of the light emission from the organic light emitting device of the present invention, and may be the detection limit or less.

The first organic compound preferably contains no metal atom. For example, a compound consisting of atoms selected from the group consisting of a carbon atom, a hydrogen atom, a nitrogen atom, an oxygen atom, and a sulfur atom may be selected as the first organic compound. For example, a compound consisting of atoms selected from the group consisting of a carbon atom, a hydrogen atom, a nitrogen atom, and an oxygen atom may be selected as the first organic compound. For example, a compound consisting of atoms selected from the group consisting of a carbon atom, a hydrogen atom, and a nitrogen atom may be selected as the first organic compound.

In one preferred embodiment of the present invention, a compound including a carbazole structure is selected. In one preferred embodiment of the present invention, a compound including two or more selected from the group consisting of a carbazole structure, a dibenzofuran structure, and a dibenzothiophene structure, can be selected as the first organic compound, for example, a compound having two of these structures, or a compound having three of these structures can also be selected. In one preferred embodiment of the present invention, a compound including a 1,3-phenylene structure can be selected as the first organic compound. In one preferred embodiment of the present invention, a compound including a biphenylene structure can be selected as the first organic compound. In one preferred embodiment of the present invention, a compound having 5 to 8 benzene rings included in the molecule thereof can be selected as the first organic compound, for example, a compound having 5 benzene rings, a compound having 6 benzene rings, or a compound having 7 benzene rings can also be selected.

Preferred compounds that can be used as the first organic compound are shown below.

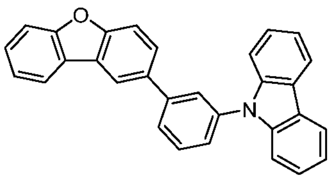

H1

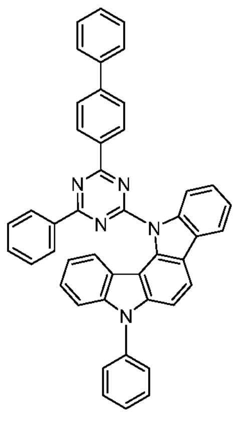

H2

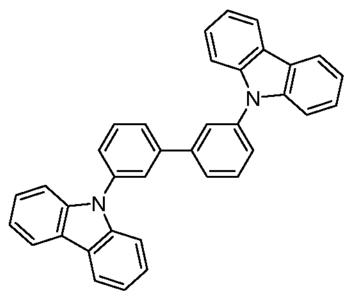

H3

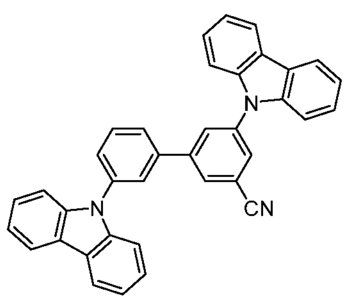

H4

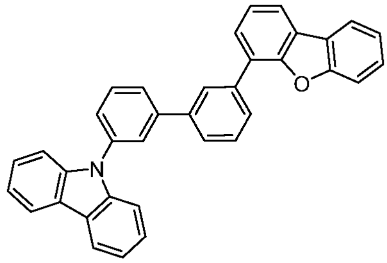

H5

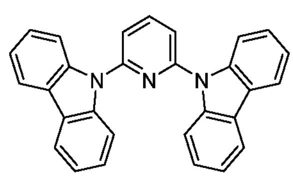

H6

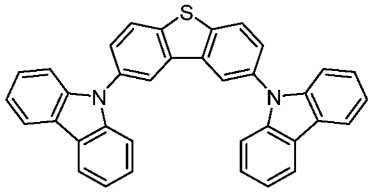

H7

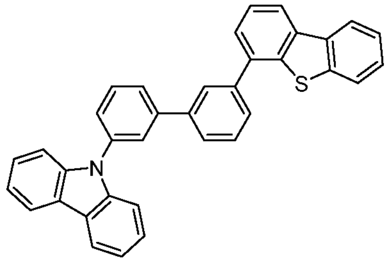

H8

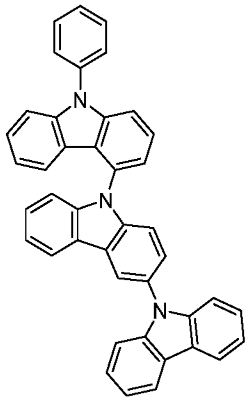

H9

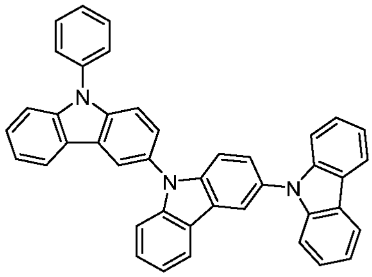

H10

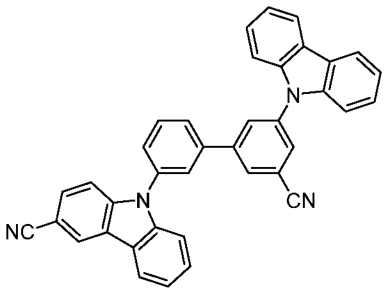

H11

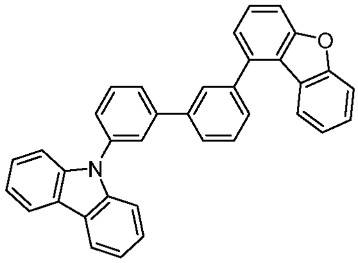

H12

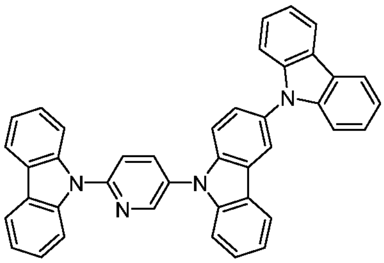

H13

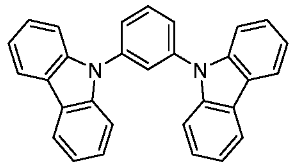

H14

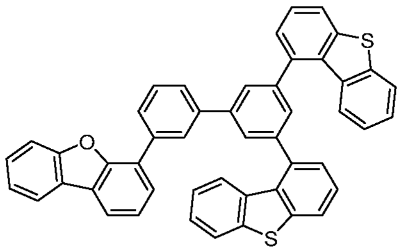

H15

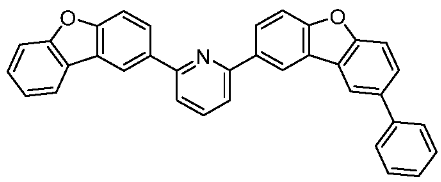

H16

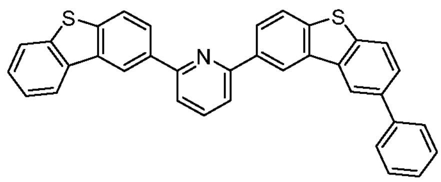

H17

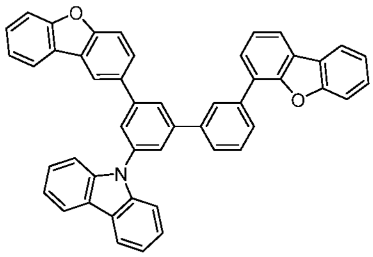

H18

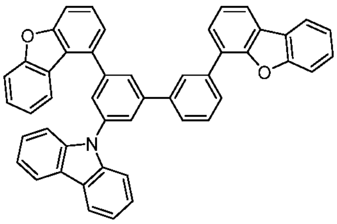

H19

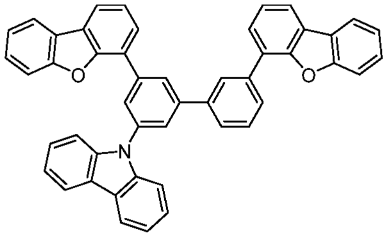

H20

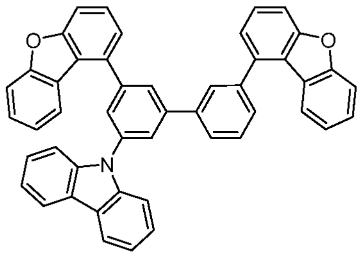

H21

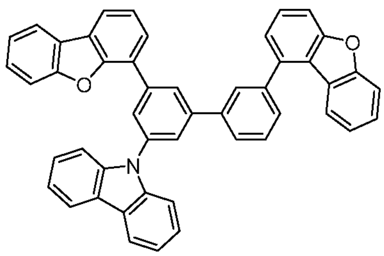

H22

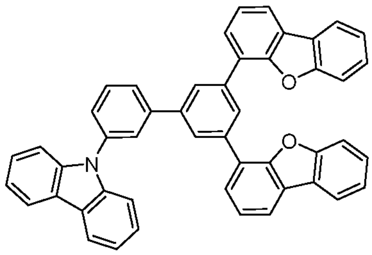

H23

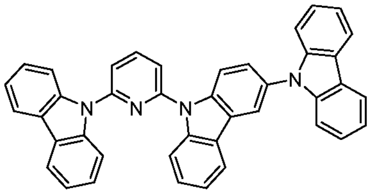

H24

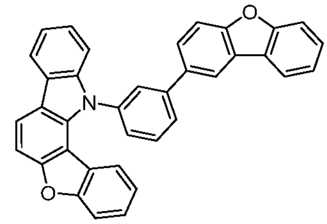

H25

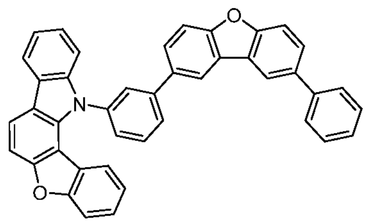

H26

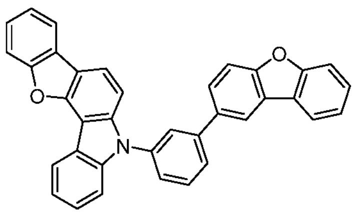

H27

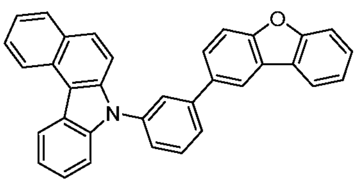

H28

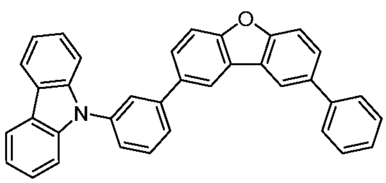

H29

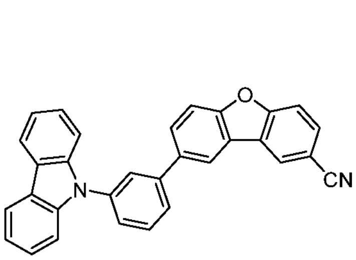

H30

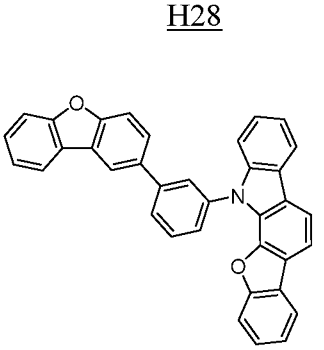

H31

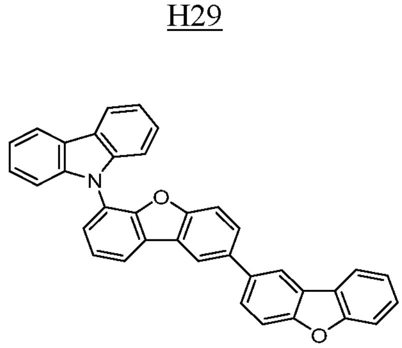

H32

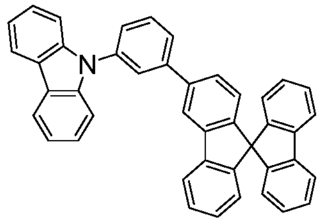
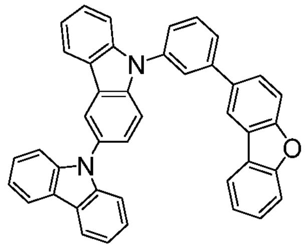
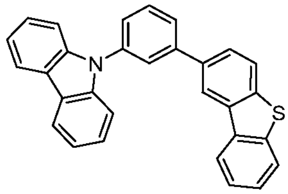

H33 H34 H35

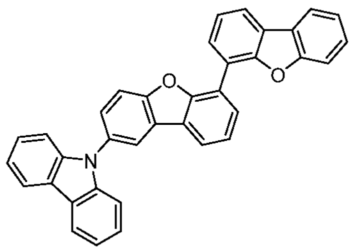
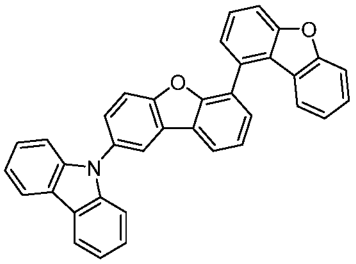

H36 H37

(Second Organic compound)

The second organic compound used in the light emitting layer of the organic light emitting device of the present invention is a delayed fluorescent material that has lowest excited singlet energy that is smaller than the first organic compound, and has lowest excited singlet energy that is larger than the third organic compound. The "delayed fluorescent material" in the present invention is an organic compound that causes reverse intersystem crossing from the excited triplet state to the excited singlet state in the excited state, and emits fluorescent light (delayed fluorescent light) in returning the excited singlet state to the ground state. In the present invention, a compound emitting fluorescent light having a light emission lifetime of 100 ns (nanosecond) or more observed when measured by a fluorescent lifetime measurement system (such as a streak camera system available from Hamamatsu Photonics K.K.) is referred to as the delayed fluorescent material. The second organic compound is a material capable of emitting delayed fluorescent light, but it is not essential to emit delayed fluorescent light derived from the second organic compound used in the organic light emitting device of the present invention. The light emission from the second organic compound is preferably less than 10%, for example, may be less than 1%, may be less than 0.1%, or may be less than 0.01%, of the light emission from the organic light emitting device of the present invention, and may be the detection limit or less.

In the organic light emitting device of the present invention, the second organic compound transitions to the excited singlet state through reception of energy from the first organic compound in the excited singlet state. The second organic compound may transition to the excited triplet state through reception of energy from the first organic compound in the excited triplet state. The second organic compound has a small difference ($\Delta E_{ST}$) between the excited singlet energy and the excited triplet energy, and therefore the second organic compound in the excited triplet state is likely to cause reverse intersystem crossing to the second organic compound in the excited singlet state. The second organic compound in the excited singlet state formed via these routes donates energy to the third organic compound, so as to allow the third organic compound to transition to the excited singlet state.

The second organic compound preferably has a difference $\Delta E_{ST}$ between the lowest excited singlet energy and the lowest excited triplet energy at 77 K of 0.3 eV or less, more preferably 0.25 eV or less, further preferably 0.2 eV or less, still further preferably 0.15 eV or less, still more further preferably 0.1 eV or less, even further preferably 0.07 eV or less, even still further preferably 0.05 eV or less, even still more further preferably 0.03 eV or less, and particularly preferably 0.01 eV or less.

With smaller $\Delta E_{ST}$, the reverse intersystem crossing is likely to occur from the excited singlet state to the excited triplet state through reception of heat energy, and therefore the second organic compound functions as a heat activation type delayed fluorescent material. The heat activation type delayed fluorescent material relatively easily causes reverse intersystem crossing from the excited triplet state to the excited singlet state through reception of heat generated by the device, and can allow the excited triplet energy to contribute to the light emission efficiently.

In the present invention, the lowest excited singlet energy ($E_{S1}$) and the lowest excited triplet energy ($E_{T1}$) of the compound are values that are obtained in the following procedure. $\Delta E_{ST}$ is a value that is obtained by calculating

$E_{S1}$-$E_{T1}$.

## (1) Lowest Excited Singlet Energy ($E_{S1}$)

A thin film or a toluene solution (concentration: $10^{-5}$ mol/L) of the target compound to be measured is prepared and designated as a specimen. The specimen was measured for the fluorescent spectrum at ordinary temperature (300 K). The fluorescent spectrum has an ordinate as the light emission and an abscissa as the wavelength. A tangent line is drawn to the rise on the short wavelength side of the light emission spectrum, and the wavelength value $\lambda_{edge}$ (nm) at the intersection point of the tangent line and the abscissa is obtained. The wavelength value is converted to the energy value according to the following conversion expression, and is designated as $E_{S1}$.

$$\text{Conversion expression: } E_{S1}\ (\text{eV}) = 1239.85/\lambda_{edge}$$

The measurement of the light emission spectrum in the examples described later is performed by using an LED light source (M300L4, available from Thorlabs, Inc.) as the excitation light source and a detector (PMA-12 Multichannel Spectroscope C10027-01, available from Hamamatsu Photonics K.K.).

## (2) Lowest Excited Triplet Energy ($E_{T1}$)

The same specimen as used in the measurement of the lowest excited singlet energy ($E_{S1}$) is cooled to 77 (K) with liquid nitrogen, the specimen for measuring phosphorescent light is irradiated with excitation light (300 nm), and the phosphorescent light is measured with a detector. The light emission after 100 ms or later from the irradiation of excitation light is designated as a phosphorescent light spectrum. A tangent line is drawn to the rise on the short wavelength side of the phosphorescent light spectrum, and the wavelength value $\lambda_{edge}$ (nm) at the intersection point of the tangent line and the abscissa is obtained. The wavelength value is converted to the energy value according to the following conversion expression, and is designated as $E_{T1}$.

$$\text{Conversion expression: } E_{T1}\ (\text{eV}) = 1239.85/\lambda_{edge}$$

The tangent line to the rise on the short wavelength side of the phosphorescent light spectrum is drawn in the following manner. In moving on the spectrum curve to the maximum value on the shortest wavelength side among the maximum values of the spectrum from the short wavelength side of the phosphorescent light spectrum, tangent lines to points on the curve are considered toward the long wavelength side. The tangent lines increase the gradient as the curve rises (i.e., as the ordinate increases). The tangent line that is drawn on the point where the gradient value becomes maximum is designated as the tangent line to the rise on the short wavelength side of the phosphorescent light spectrum.

A maximum value having a peak intensity of 10% or less of the maximum peak intensity of the spectrum is not included in the aforementioned maximum value on the shortest wavelength side, and the tangent line drawn on the point where the gradient value becomes maximum that is closest to the maximum value on the shortest wavelength side is designated as the tangent line to the rise on the short wavelength side of the phosphorescent light spectrum.

The second organic compound preferably contains no metal atom. For example, a compound consisting of atoms selected from the group consisting of a carbon atom, a hydrogen atom, a deuterium atom, a nitrogen atom, an oxygen atom, and a sulfur atom may be selected as the second organic compound. For example, a compound consisting of atoms selected from the group consisting of a carbon atom, a hydrogen atom, a deuterium atom, a nitrogen atom, and an oxygen atom may be selected as the second organic compound. For example, a compound consisting of atoms selected from the group consisting of a carbon atom, a hydrogen atom, a deuterium atom, and a nitrogen atom may be selected as the second organic compound. For example, a compound consisting of atoms selected from the group consisting of a carbon atom, a hydrogen atom, and a nitrogen atom may be selected as the second organic compound.

In one preferred embodiment of the present invention, a compound including a carbazole structure can be selected as the second organic compound. In one preferred embodiment of the present invention, a compound including one or more structures selected from a dibenzofuran structure and a dibenzothiophene structure is selected as the second organic compound.

Typical examples of the second organic compound include a compound including a structure including a benzene ring having bonded thereto one or two acceptor groups and at least one donor group. Preferred examples of the acceptor group include a cyano group, a nitrogen-containing heteroaryl group containing a nitrogen atom as a ring

skeleton-forming atom, such as a triazinyl group, and a group containing these. Preferred examples of the donor group include a diarylamino group (in which two aryl groups constituting the diarylamino group may be bonded to each other), such as a substituted or unsubstituted carbazol-9-yl group. Examples of the compound include a compound including a benzene ring having bonded thereto 3 or more substituted or unsubstituted carbazol-9-yl groups, and a compound including a carbazol-9-yl group, at least one of the two benzene ring of which is condensed with a 5-membered ring of any of a substituted or unsubstituted benzofuran ring, a substituted or unsubstituted benzothiophene ring, a substituted or unsubstituted indole ring, a substituted or unsubstituted indene ring, and a substituted or unsubstituted silaindene ring.

In the description herein, the acceptor group is a group that attracts an electron from the ring to which the acceptor group is bonded, and for example, can be selected from groups having a positive Hammett's $\sigma_p$ value. In the description herein, the donor group is a group that donates an electron from the ring to which the donor group is bonded, and for example, can be selected from groups having a negative Hammett's $\sigma_p$ value.

The "Hammett's $\sigma_p$ value" is one propounded by L. P. Hammett, and is one to quantify the influence of a substituent on the reaction rate or the equilibrium of a para-substituted benzene derivative. Specifically, the value is a constant ($\sigma_p$) peculiar to the substituent in the following equation that is established between a substituent and a reaction rate constant or an equilibrium constant in a para-substituted benzene derivative:

$$\log(k/k_0) = \rho\sigma_p$$

or

$$\log(K/K_0) = \rho\sigma_p$$

In the above equations, k represents a rate constant of a benzene derivative not having a substituent; $k_0$ represents a rate constant of a benzene derivative substituted with a substituent; K represents an equilibrium constant of a benzene derivative not having a substituent; $K_0$ represents an equilibrium constant of a benzene derivative substituted with a substituent; ρ represents a reaction constant to be determined by the kind and the condition of reaction. Regarding the description relating to the "Hammett's $\sigma_p$ value" and the numerical value of each substituent, reference may be made to the description relating to $\sigma_p$ value in Hansch, C. et. al., Chem. Rev., 91, 165-195 (1991).

Specific examples of the acceptor group include a cyano group, and also include the following groups, in which * represents the bonding position, and D represents a deuterium atom. In the following specific examples, a hydrogen atom may be substituted by an alkyl group. A substituted or unsubstituted benzene ring may be further condensed thereto. A part or the entire of hydrogen atoms may be replaced by a deuterium atom.

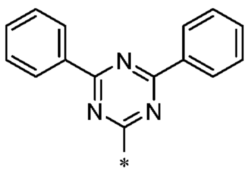
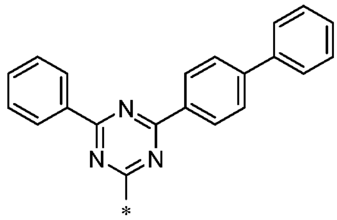
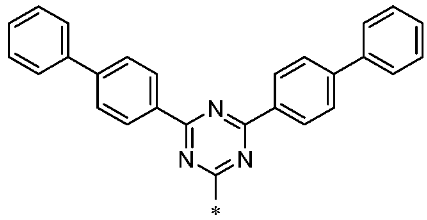

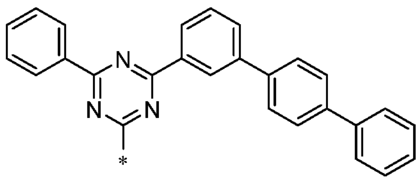
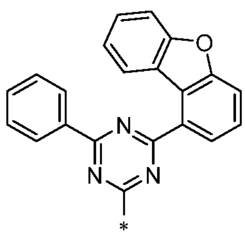
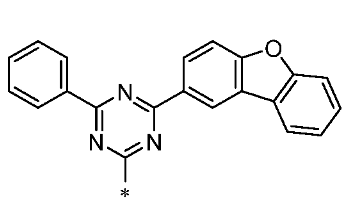

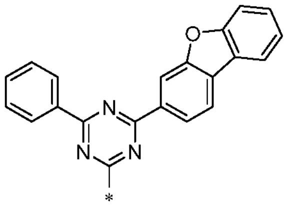 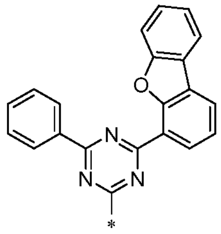 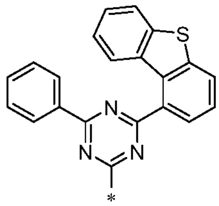 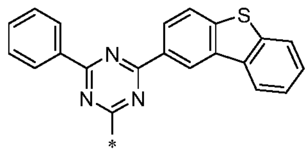

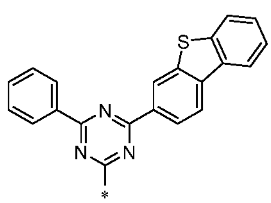 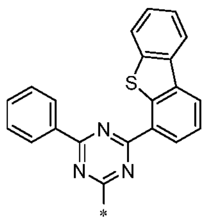 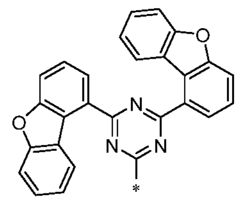 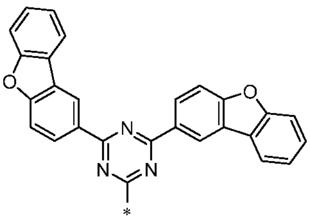

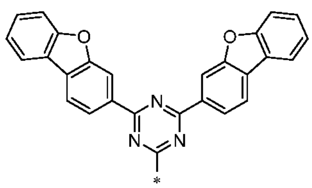 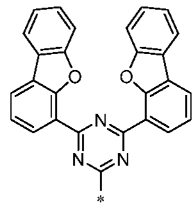 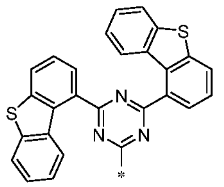 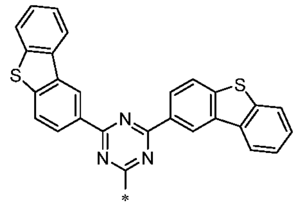

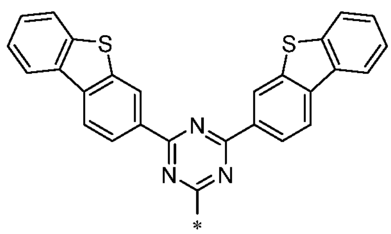 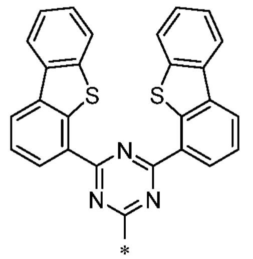 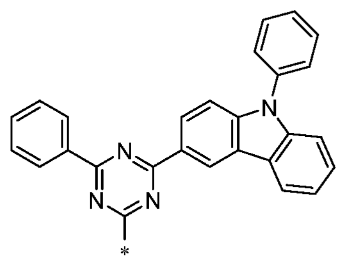

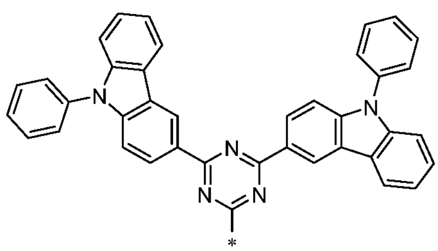 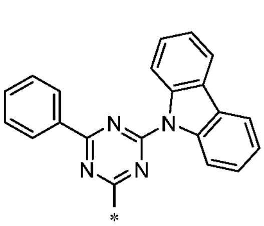 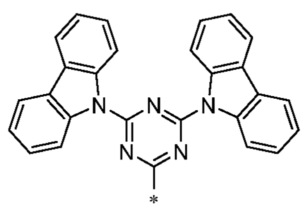

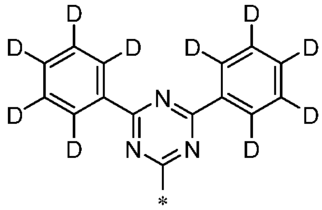 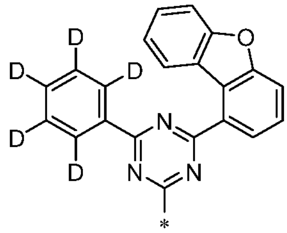 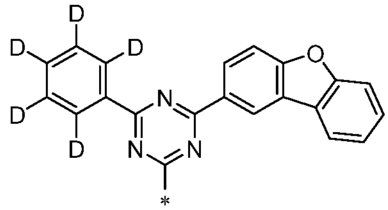

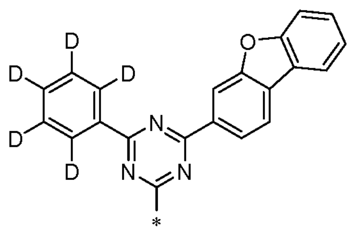 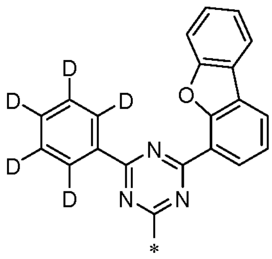

Specific examples of the donor group include the following groups, in which * represents the bonding position, and D represents a deuterium atom. In the following specific examples, a hydrogen atom may be substituted by an alkyl group. A substituted or unsubstituted benzene ring may be further condensed thereto. A part or the entire of hydrogen atoms may be replaced by a deuterium atom.

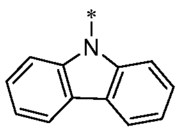 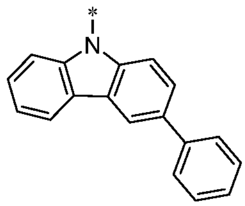 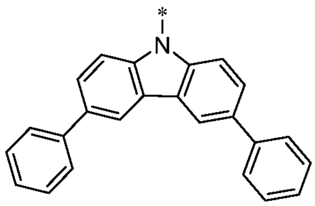 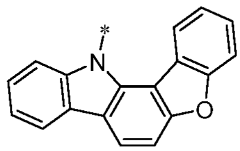

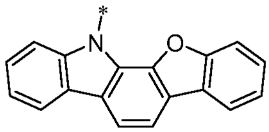 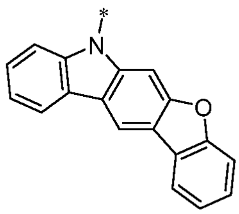 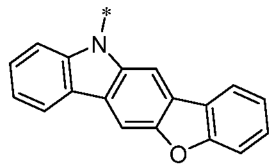 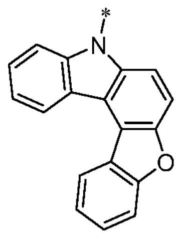

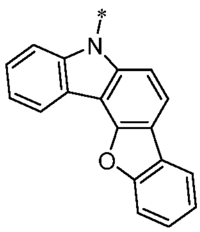 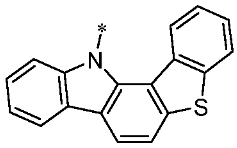 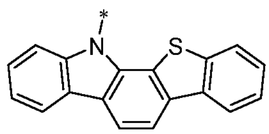 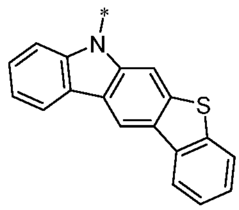

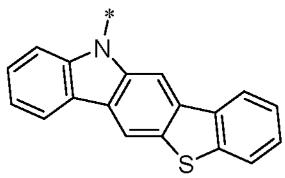 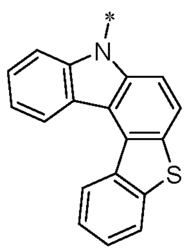 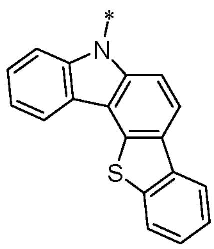 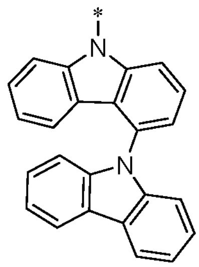

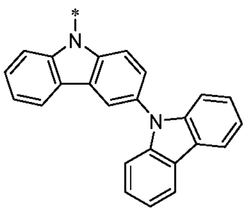 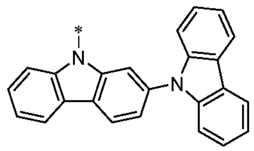 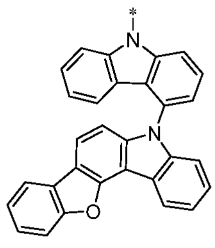 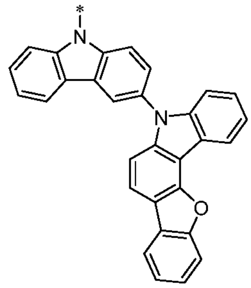

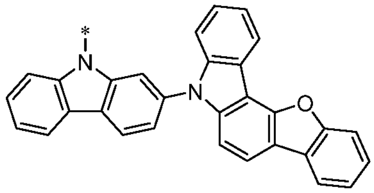 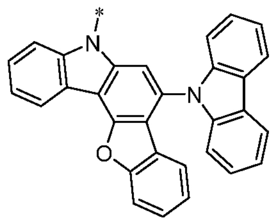 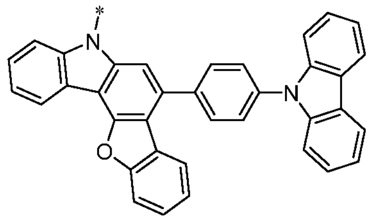

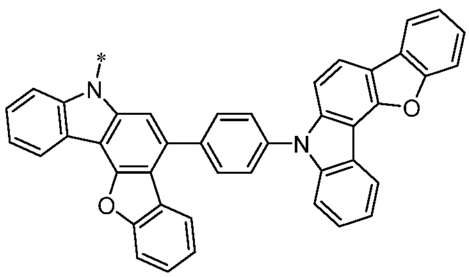 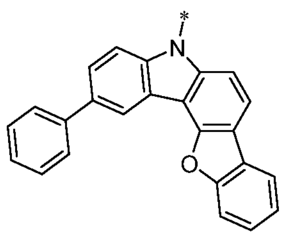 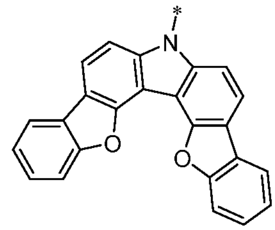

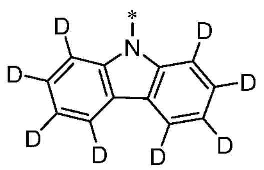 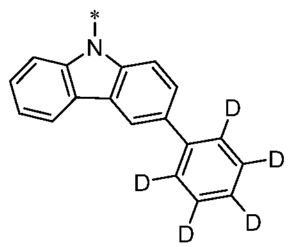 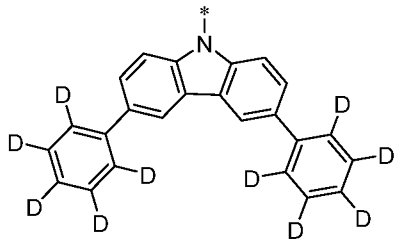

The second organic compound used is preferably a compound represented by the following general formula (1) emitting delayed fluorescent light.

General Formula (1)

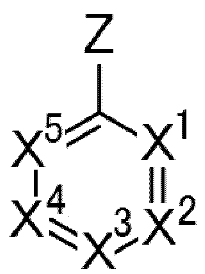

In the general formula (1), $X^1$ to $X^5$ each represent N or C-R, in which R represents a hydrogen atom, a deuterium atom, or a substituent. In the case where two or more of $X^1$ to $X^5$ represent C-R, the groups represented by C-R may be the same as or different from each other. At least one of $X^1$ to $X^5$ represents C-D (wherein D represents a donor

group). In the case where all $X^1$ to $X^5$ represent C-R, Z represents an acceptor group.

The compound represented by the general formula (1) is particularly preferably a compound represented by the following general formula (2).

General Formula (2)

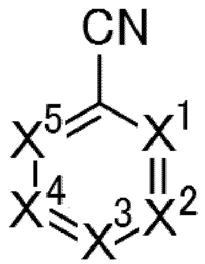

In the general formula (2), $X^1$ to $X^5$ each represent N or C-R, in which R represents a hydrogen atom, a deuterium atom, or a substituent. In the case where two or more of $X^1$ to $X^5$ represent C-R, the groups represented by C-R may be the same as or different from each other. At least one of $X^1$ to $X^5$ represents C-D (wherein D represents a donor group).

In one preferred embodiment of the present invention, all $X^1$ to $X^5$ do not represent C-CN, which accordingly provides a compound including a structure including a benzene ring having bonded thereto one cyano group and at least one donor group. In another preferred embodiment of the present invention, only $X^2$ represents C-CN, and $X^1$ and $X^3$ to $X^5$ do not represent C-CN, which accordingly provides a compound including a structure including a benzene ring of isophthalonitrile having bonded thereto at least one donor group. In still another embodiment of the present invention, only $X^3$ represents C-CN, and $X^1$, $X^2$, $X^4$, and $X^5$ do not represent C-CN, which accordingly provides a compound including a structure including a benzene ring of terephthalonitrile having bonded thereto at least one donor group.

In the general formulae (1) and (2), $X^1$ to $X^5$ each represent N or C-R, and at least one of which represents C-D. The number of N in $X^1$ to $X^5$ is 0 to 4, and examples thereof include cases where $X^1$, $X^3$, and $X^5$ are N, $X^1$ and $X^3$ are N, $X^1$ and $X^4$ are N, $X^2$ and $X^3$ are N, $X^1$ and $X^5$ are N, $X^2$ and $X^4$ are N, only $X^1$ is N, only $X^2$ is N, and only $X^3$ is N. The number of C-D in $X^1$ to $X^5$ is 1 to 5, and more preferably 2 to 5, and examples thereof include cases where $X^1$, $X^2$, $X^3$, $X^4$, and $X^5$ are C-D, $X^1$, $X^2$, $X^4$, and $X^5$ are C-D, $X^1$, $X^2$, $X^3$, and $X^4$ are C-D, $X^1$, $X^3$, $X^4$, and $X^5$ are C-D, $X^1$, $X^3$, and $X^5$ are C-D, $X^1$, $X^2$, and $X^5$ are C-D, $X^1$, $X^2$, and $X^4$ are C-D, $X^1$, $X^3$, and $X^4$ are C-D, $X^1$ and $X^3$ are C-D, $X^1$ and $X^4$ are C-D, $X^2$ and $X^3$ are C-D, $X^1$ and $X^5$ are C-D, $X^2$ and $X^4$ are C-D, only $X^1$ is C-D, only $X^2$ is C-D, and only $X^3$ is C-D. At least one of $X^1$ to $X^5$ may be C-A, in which A represents an acceptor group. The number of C-A in $X^1$ to $X^5$ is preferably 0 to 2, and more preferably 0 or 1. Preferred examples of A in C-A include a cyano group and a heterocyclic aromatic group having an unsaturated nitrogen atom. $X^1$ to $X^5$ each independently may represent C-D or C-A.

In the case where adjacent two of $X^1$ to $X^5$ represent C-R, two groups of R may be bonded to each other to form a cyclic structure. The cyclic structure formed by bonding to each other may be an aromatic ring or an aliphatic ring, and may contain a hetero atom, and the cyclic structure may also be a condensed ring of two or more rings. The hetero atom herein is preferably selected from the group consisting of a nitrogen atom, an oxygen atom, and a sulfur atom. Examples of the cyclic structure formed include a benzene ring, a naphthalene ring, a pyridine ring, a pyridazine ring, a pyrimidine ring, a pyrazine ring, a pyrrole ring, an imidazole ring, a pyrazole ring, an imidazoline ring, an oxazole ring, an isoxazole ring, a thiazole ring, an isothiazole ring, a cyclohexadiene ring, a cyclohexene ring, a cyclopentaene ring, a cycloheptatriene ring, a cycloheptadiene ring, a cycloheptaene ring, a furan ring, a thiophene ring, a naphthyridine ring, a quinoxaline ring, and a quinoline ring. For example, a ring including multiple rings condensed each other, such as a phenanthrene ring and a triphenylene ring, may also be formed.

The donor group D in the general formula (1) and the general formula (2) is preferably a group represented by, for example, the following general formula (3).

General Formula (3)

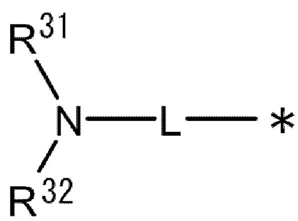

In the general formula (3), $R^{31}$ and $R^{32}$ each independently represent a substituted or unsubstituted alkyl group, a substituted or unsubstituted alkenyl group, a substituted or unsubstituted aryl group, or a substituted or unsubstituted heteroaryl group. $R^{31}$ and $R^{32}$ can bond to each other to form a cyclic structure. L represents a single bond, a substituted or unsubstituted arylene group, or a substituted or unsubstituted heteroarylene group. The substituent that can be introduced into the arylene group or the heteroarylene group of L can be a group including a structure represented by the general formula (1) or the general formula (2), or can be a group represented by the general formulae (4) to (6) to be mentioned hereinunder. These groups can be introduced in an amount up to the maximum number of the substituents capable of being introduced into L. In the case where plural groups are introduced, these substituents can be the same as or different from each other. * indicates the bonding position to the carbon atom (C) that constitutes the ring skeleton of the ring in the general formula (1) or the general formula (2).

The substituent means a monovalent group capable of substituting a hydrogen atom, and for example, can be selected from the substituent group A described later, can be selected from the substituent group B described later, can be selected from the substituent group C described later, and can be selected from the substituent group D described later.

The group represented by the general formula (3) is preferably a group represented by any of the following general formulae (4) to (6).

General Formula (4)

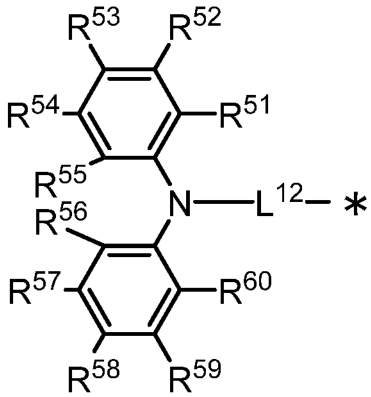

General Formula (5)

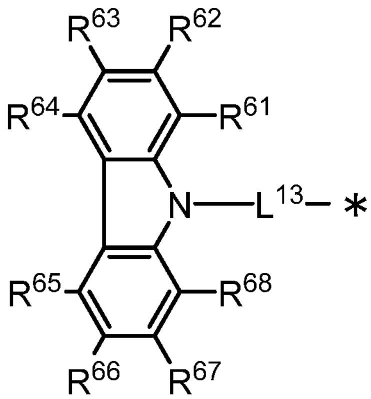

General Formula (6)

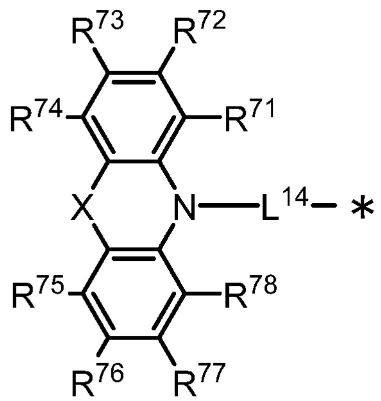

In the general formulae (4) to (6), $R^{51}$ to $R^{60}$, $R^{61}$ to $R^{68}$, and $R^{71}$ to $R^{78}$ each independently represent a hydrogen atom, a deuterium atom, or a substituent. For the description and the preferred ranges of the substituent herein, reference may be made to the description and the preferred ranges for the substituent in the general formulae (5a) to (5f) described later. $R^{51}$ to $R^{60}$, $R^{61}$ to $R^{68}$, and $R^{71}$ to $R^{78}$ each independently preferably represent a group represented by any of the general formulae (4) to (6). The number of the substituent in the general formulae (4) to (6) is not limited. The case completely unsubstituted (i.e., all are hydrogen atoms or deuterium atoms) is also preferred. In the case where two or more substituents exist in the general formulae (4) to (6), the substituents may be the same as or different from each other. In the case where a substituent exists in the general formulae (4) to (6), the substituent is preferably any of $R^{52}$ to $R^{59}$ for the general formula (4), any of $R^{62}$ to $R^{67}$ for the general formula (5), and any of $R^{72}$ to $R^{77}$ for the general formula (6).

In the general formula (6), X represents an oxygen atom, a sulfur atom, a substituted or unsubstituted nitrogen atom, a substituted or unsubstituted carbon atom, a substituted or unsubstituted silicon atom or a carbonyl group that is divalent and has a linking chain length of one atom, or represents a substituted or unsubstituted ethylene group, a substituted or unsubstituted vinylene group, a substituted or unsubstituted o-arylene group or a substituted or unsubstituted o-heteroarylene group that is divalent and has a linking chain length of two atoms. For example, the substituent can be selected from the substituent group A described later, can be selected from the substituent group B described later, can be selected from the substituent group C described later, or can be selected from the substituent group D described later.

In the general formulae (4) to (6), $L^{12}$ to $L^{14}$ each represent a single bond, a substituted or unsubstituted arylene group or a substituted or unsubstituted heteroarylene group. Regarding the description and the preferred range of the arylene group and the heteroarylene group that $L^{12}$ to $L^{14}$ represent, reference can be made to the description and the preferred range of the arylene group and the heteroarylene group that L represents. $L^{12}$ to $L^{14}$ each are preferably a single bond, or a substituted or unsubstituted arylene group. Here the substituent for the arylene group and the heteroarylene group can be the group represented by the general formulae (4) to (6). The group represented by the general formulae (4) to (6) can be introduced into $L^{12}$ to $L^{14}$ in an amount up to the maximum number of the substituents that can be introduced thereinto. In the case where plural groups of the general formulae (4) to (6) are introduced, these substituents can be the same as or different from each other. * indicates the bonding position to the carbon atom (C) that constitutes the ring skeleton of the ring in the general formula (1) or the general formula (2).

In the general formulae (4) to (6), $R^{51}$ and $R^{52}$, $R^{52}$ and $R^{53}$, $R^{53}$ and $R^{54}$, $R^{54}$ and $R^{55}$, $R^{55}$ and $R^{56}$, $R^{56}$ and $R^{57}$, $R^{57}$ and $R^{58}$, $R^{58}$ and $R^{59}$, $R^{59}$ and $R^{60}$, $R^{61}$ and $R^{62}$, $R^{62}$ and $R^{63}$, $R^{63}$ and $R^{64}$, $R^{65}$ and $R^{66}$, $R^{66}$ and $R^{67}$, $R^{67}$ and $R^{68}$, $R^{71}$ and $R^{72}$ , $R^{72}$ and $R^{73}$, $R^{73}$ and $R^{74}$, $R^{75}$ and $R^{76}$, $R^{76}$ and $R^{77}$, and $R^{77}$ and $R^{78}$ each may be bonded to each other to form a cyclic structure. For the description and the preferred ranges of the cyclic structure, reference may be made to the description and the preferred ranges for the cyclic structure of $X^1$ to $X^5$ in the general formulae (1) and (2).

Preferred examples of the cyclic structure include a structure including a substituted or unsubstituted benzofuran ring, a substituted or unsubstituted benzothiophene ring, a substituted or unsubstituted indole ring, a substituted or unsubstituted indene ring, or a substituted or unsubstituted silaindene ring that is condensed to at least one benzene rings of the general formulae (4) to (6). More preferred examples thereof include a group represented by any of the following general formulae (5a) to (5f) obtained by condensing to the general formula (5).

General Formula (5a)

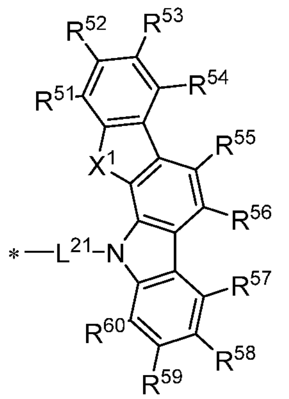

General Formula (5b)

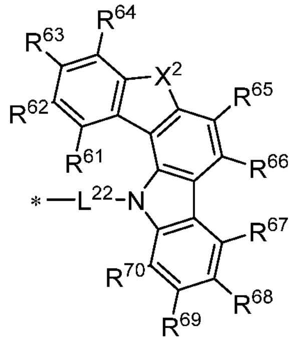

General Formula (5c)

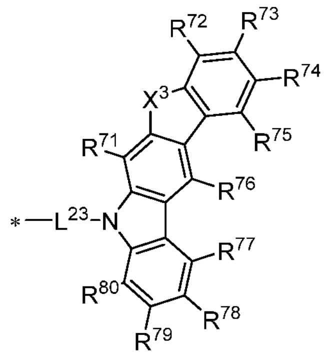

General Formula (5d)

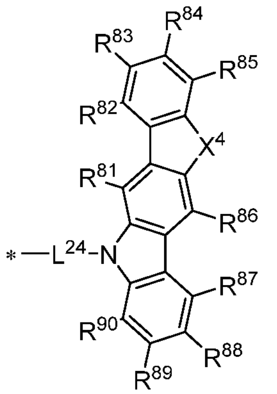

General Formula (5e)

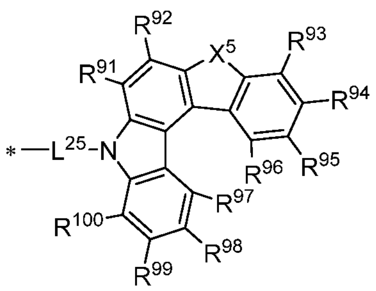

General Formula (5f)

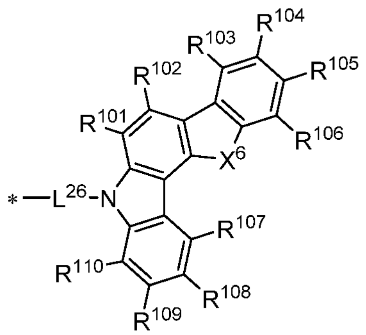

In the general formulae (5a) to (5f), $L^{11}$ and $L^{21}$ to $L^{26}$ each represent a single bond or a divalent linking group. For the description and the preferred ranges of $L^{11}$ and $L^{21}$ to $L^{26}$, reference may be made to the description and the preferred ranges for $L^2$ described above.

In the general formulae (5a) to (5f), $R^{41}$ to $R^{110}$ each independently represent a hydrogen atom or a substituent. $R^{41}$ and $R^{42}$, $R^{42}$ and $R^{43}$, $R^{43}$ and $R^{44}$, $R^{44}$ and $R^{45}$, $R^{45}$ and $R^{46}$, $R^{46}$ and $R^{47}$, $R^{47}$ and $R^{48}$ , $R^{51}$ and $R^{52}$, $R^{52}$ and $R^{53}$, $R^{53}$ and $R^{54}$, $R^{54}$ and $R^{55}$, $R^{55}$ and $R^{56}$, $R^{56}$ and $R^{57}$, $R^{57}$ and $R^{58}$, $R^{58}$ and $R^{59}$, $R^{59}$ and $R^{60}$, $R^{61}$ and $R^{62}$, $R^{62}$ and $R^{63}$, $R^{63}$ and $R^{64}$, $R^{65}$ and $R^{66}$, $R^{66}$ and $R^{67}$, $R^{67}$ and $R^{68}$, $R^{68}$ and $R^{69}$, $R^{69}$ and $R^{70}$, $R^{72}$ and $R^{73}$, $R^{73}$ and $R^{74}$, $R^{74}$ and $R^{75}$, $R^{75}$ and $R^{76}$, $R^{76}$ and $R^{77}$, $R^{77}$ and $R^{78}$, $R^{78}$ and $R^{79}$, $R^{79}$ and $R^{80}$, $R^{81}$ and $R^{82}$, $R^{82}$ and $R^{83}$, $R^{83}$ and $R^{84}$, $R^{84}$ and $R^{85}$, $R^{86}$ and $R^{17}$, $R^{87}$ and $R^{88}$, $R^{88}$ and $R^{89}$, $R^{89}$ and $R^{90}$, $R^{91}$ and $R^{92}$, $R^{93}$ and $R^{94}$, $R^{94}$ and $R^{95}$, $R^{95}$ and $R^{96}$, $R^{96}$ and $R^{97}$ , $R^{97}$ and $R^{98}$, $R^{99}$ and $R^{100}$, $R^{101}$ and $R^{102}$, $R^{102}$ and $R^{103}$, $R^{103}$ and $R^{104}$, $R^{104}$ and $R^{105}$, $R^{105}$ and $R^{106}$, $R^{107}$ and $R^{108}$, $R^{108}$ and $R^{109}$, and $R^{109}$ and $R^{110}$ each may be bonded to each other to form a cyclic structure. The cyclic structure formed by bonding to each other may be an aromatic ring or an aliphatic ring, and may contain a hetero atom, and the cyclic structure may also be a condensed ring of two or more rings. The hetero atom herein is preferably selected from the group consisting of a nitrogen atom, an oxygen atom, and a sulfur atom. Examples of the cyclic structure formed include a benzene ring, a naphthalene ring, a pyridine ring, a pyridazine ring, a pyrimidine ring, a pyrazine ring, a pyrrole ring, an imidazole ring, a pyrazole ring, an imidazoline ring, an oxazole ring, an isoxazole ring, a thiazole ring, an isothiazole ring, a cyclohexadiene ring, a cyclohexene ring, a cyclopentaene ring, a cycloheptatriene ring, a cycloheptadiene ring, a cycloheptaene ring, a furan ring, a thiophene ring, a naphthyridine ring, a quinoxaline ring, and a quinoline ring. For example, a ring including multiple rings condensed each other, such as a phenanthrene ring and a triphenylene ring, may also be formed. The number of rings contained in the group represented by the general formula (6) may be selected from a range of 3 to 5, and may be selected from a range of 5 to 7. The number of rings contained in the group represented by the general formulae (5a) to (5f) may be selected from a range of 5 to 7, and may be 5.

The substituent that $R^{41}$ to $R^{110}$ each can represent can be selected from the groups of the substituent group B described later, can be selected from the groups of the substituent group C described later, and can be selected from the groups of the substituent group D described later. The substituent is preferably an unsubstituted alkyl group having

1 to 10 carbon atoms, and an aryl group having 6 to 10 carbon atoms, which may be substituted by an unsubstituted alkyl group having 1 to 10 carbon atoms. In one preferred embodiment of the present invention, $R^{41}$ to $R^{110}$ each represent a hydrogen atom or an unsubstituted alkyl group having 1 to 10 carbon atoms. In one preferred embodiment of the present invention, $R^{41}$ to $R^{110}$ each represent a hydrogen atom or an unsubstituted aryl group having 6 to 10 carbon atoms. In one preferred embodiment of the present invention, all $R^{41}$ to $R^{110}$ represent hydrogen atoms.

In the general formulae (5a) to (5f), the carbon atoms, to which $R^{41}$ to $R^{110}$ are bonded, (i.e., ring skeleton-forming carbon atoms) each independently may be replaced by a nitrogen atom. Accordingly, in the general formulae (5a) to (5f), C-$R^{41}$ to C-$R^{110}$ each independently may be replaced by N. The number of a carbon atom that is replaced by a nitrogen atom is preferably 0 to 4, and more preferably 1 to 2, in the group represented by the general formulae (5a) to (5f). In one embodiment of the present invention, the number of a carbon atom that is replaced by a nitrogen atom is 0. In the case where 2 or more carbon atoms are replaced by nitrogen atoms, the number of a nitrogen atom that is substituted in one ring is preferably 1.

In the general formulae (5a) to (5f), $X^1$ to $X^6$ each represent an oxygen atom, a sulfur atom, or N-R. In one embodiment of the present invention, $X^1$ to $X^6$ represent oxygen atoms. In one embodiment of the present invention, $X^1$ to $X^6$ represent sulfur atoms. In one embodiment of the present invention, $X^1$ to $X^6$ represent N-R. R represents a hydrogen atom or a substituent, and preferably represents a substituent. The substituent can be selected from the groups of the substituent group A described later, can be selected from the groups of the substituent group B described later, can be selected from the groups of the substituent group C described later, or can be selected from the groups of the substituent group D described later. Preferred examples thereof used include an unsubstituted phenyl group and a phenyl group substituted by one group selected from an alkyl group and an aryl group, or a group combining two or more thereof.

In the general formulae (5a) to (5f), * indicates the bonding position.

In the present invention, a compound represented by the following general formula (7) emitting delayed fluorescent light is particularly preferably used as the delayed fluorescent material. In a preferred embodiment of the present invention, a compound represented by the general formula (7) may be used as the second organic compound.

General Formula (7)

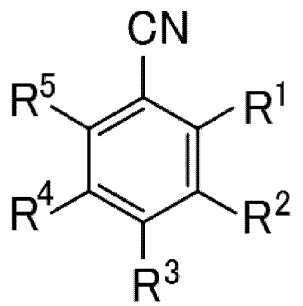

In the general formula (7), 0 to 4 of $R^1$ to $R^5$ represent a cyano group, at least one of $R^1$ to $R^5$ represent a substituted amino group, and the rest of $R^1$ to $R^5$ represent a hydrogen atom, a deuterium atom, or a substituent other than a cyano group and a substituted amino group.

The substituted amino group herein is preferably a substituted or unsubstituted diarylamino group, in which two aryl groups constituting the substituted or unsubstituted diarylamino group may be bonded to each other. The aryl groups may be bonded via a single bond (resulting in a carbazole ring in this case), or may be bonded via a linking group, such as -O-, -S-, -N($R^6$)-, -C($R^7$)($R^8$)-, and Si($R^9$)($R^{10}$)-, wherein $R^6$ to $R^{10}$ each represent a hydrogen atom, a deuterium atom, or a substituent, and $R^7$ and $R^8$, and $R^9$ and $R^{10}$ each may be bonded to each other to form a cyclic structure.

The substituted amino group may be any of $R^1$ to $R^5$, and for example, $R^1$ and $R^2$; $R^1$ and $R^3$; $R^1$ and $R^4$; $R^1$ and $R^5$; $R^2$ and $R^3$; $R^2$ and $R^4$; $R^1$ and $R^2$ and $R^3$; $R^1$, $R^2$, and $R^4$; $R^1$, $R^2$, and $R^5$; $R^1$, $R^3$, and $R^4$; $R^1$, $R^3$, and $R^5$; $R^2$, $R^3$, and $R^4$; $R^1$, $R^2$, $R^3$, and $R^4$; $R^1$, $R^2$, $R^3$, and $R^5$; $R^1$, $R^2$, $R^4$, and $R^5$; or $R^1$, $R^2$, $R^3$, $R^4$, and $R^5$ may be a substituted amino group. The cyano group may also be any of $R^1$ to $R^5$, and for example, $R^1$; $R^2$; $R^3$; $R^1$ and $R^2$; $R^1$ and $R^3$; $R^1$ and $R^4$; $R^1$ and $R^5$; $R^2$ and $R^3$; $R^2$ and $R^4$; $R^1$, $R^2$, and $R^3$; $R^1$, $R^2$, and $R^4$; $R^1$, $R^2$, and $R^5$; $R^1$, $R^3$, and $R^4$; $R^1$, $R^3$, and $R^5$; or $R^2$, $R^3$, and $R^4$ may be a cyano group.

$R^1$ to $R^5$ that are not a cyano group and a substituted amino group represent a hydrogen atom, a deuterium atom, or a substituent. Examples of the substituent herein include the substituent group A described later. Preferred examples of the substituent in the case where the aryl group of the diarylamino group is substituted include the groups of the substituent group A, and also include a cyano group and a substituted amino group. Instead of the substituent

group A, the substituent can be selected from the substituent group B, can be selected from the substituent group C, or can be selected from the substituent group D.

For the specific examples of the compound group and the compounds encompassed in the general formula (7), reference may be made to WO 2013/154064, paragraphs 0008 to 0048; WO 2015/080183, paragraphs 0009 to 0030; WO 2015/129715, paragraphs 0006 to 0019; JP 2017-119663 A, paragraphs 0013 to 0025; and JP 2017-119664 A, paragraphs 0013 to 0026, which are incorporated as a part of this description by reference.

A compound represented by the following general formula (8) emitting delayed fluorescent light is also particularly preferably used as the delayed fluorescent material in the present invention. In a preferred embodiment of the present invention, a compound represented by the general formula (8) may be used as the second organic compound.

General Formula (8)

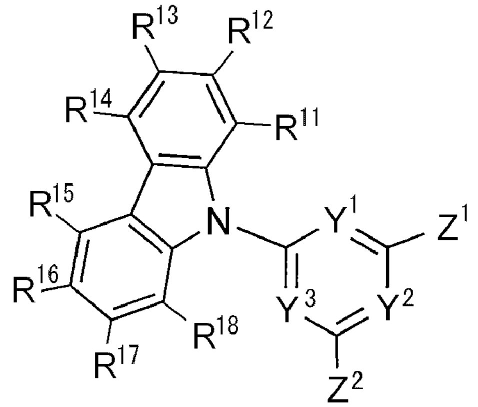

In the general formula (8), any two of $Y^1$, $Y^2$, and $Y^3$ represent nitrogen atoms, and the remaining one thereof represents a methine group, or all $Y^1$, $Y^2$, and $Y^3$ represent nitrogen atoms. $Z^1$ and $Z^2$ each independently represent a hydrogen atom, a deuterium atom, or a substituent. $R^{11}$ to $R^{18}$ each independently represent a hydrogen atom, a deuterium atom, or a substituent, in which at least one of $R^{11}$ to $R^{18}$ preferably represents a substituted or unsubstituted arylamino group or a substituted or unsubstituted carbazolyl group. The benzene ring constituting the arylamino group and the benzene ring constituting the carbazolyl group each may form a single bond or a linking group with $R^{11}$ to $R^{18}$. The compound represented by the general formula (8) includes at least two carbazole structures in the molecule thereof. For example, the substituent that $Z^1$ and $Z^2$ can be selected from the substituent group A described later, can be selected from the substituent group B described later, can be selected from the substituent group C described later, and can be selected from the substituent group D described later. Specific examples of the substituent that $R^{11}$ to $R^{18}$, the arylamino group, and the carbazolyl group can have include the substituents of the substituent group A described later, a cyano group, a substituted arylamino group, and a substituted alkylamino group. $R^{11}$ and $R^{12}$, $R^{12}$ and $R^{13}$, $R^{13}$ and $R^{14}$, $R^{15}$ and $R^{16}$, $R^{16}$ and $R^{17}$, and $R^{17}$ and $R^{18}$ each may be bonded to each other to form a cyclic structure.

In the compound represented by the general formula (8), a compound represented by the following general formula (9) is particularly useful.

General Formula (9)

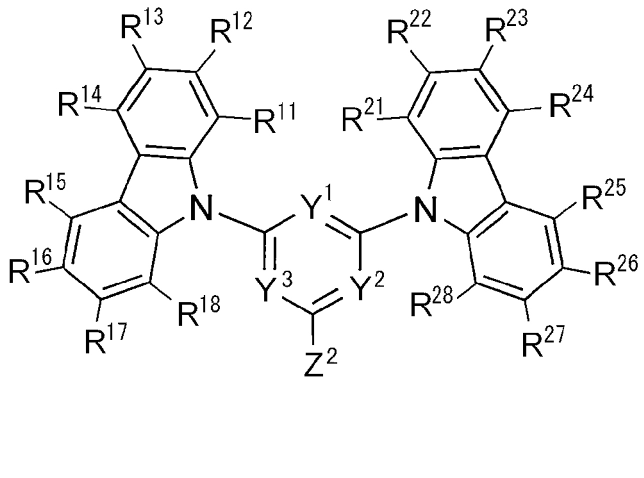

In the general formula (9), any two of $Y^1$, $Y^2$, and $Y^3$ represent nitrogen atoms, and the remaining one thereof represents a methine group, or all $Y^1$, $Y^2$, and $Y^3$ represent nitrogen atoms. $Z^2$ represents a hydrogen atom, a deuterium atom, or a substituent. $R^{11}$ to $R^{18}$ and $R^{21}$ to $R^{28}$ each independently represent a hydrogen atom, a deuterium atom, or a substituent, in which at least one of $R^{11}$ to $R^{18}$ and/or at least one of $R^{21}$ to $R^{28}$ preferably represents a substituted or unsubstituted arylamino group or a substituted or unsubstituted carbazolyl group. The benzene ring constituting the arylamino group and the benzene ring constituting the carbazolyl group each may form a single bond or a linking group with $R^{11}$ to $R^{18}$ or $R^{21}$ to $R^{28}$. Examples of the substituent that $Z^2$ can represent include the substituents of the substituent group A described later, the substituents of the substituent group B described later, the substituents of the substituent group C described later, and the substituents of the substituent group D described later. Specific examples of the substituent that $R^{11}$ to $R^{18}$, $R^{21}$ to $R^{28}$, the arylamino group, and the carbazolyl group can have include the substituents of the substituent group A described later, a cyano group, a substituted arylamino group, and a substituted alkylamino group. $R^{11}$ and $R^{12}$, $R^{12}$ and $R^{13}$, $R^{13}$ and $R^{14}$, $R^{15}$ and $R^{16}$, $R^{16}$ and $R^{17}$, $R^{17}$ and $R^{18}$, $R^{21}$ and $R^{22}$, $R^{22}$ and $R^{23}$, $R^{23}$ and $R^{24}$, $R^{25}$ and $R^{26}$, $R^{26}$ and $R^{27}$, and $R^{27}$ and $R^{28}$ each may be bonded to each other to form a cyclic structure.

For the specific examples of the compound group and the compounds encompassed in the general formula (9), reference may be made to the compounds described in WO 2013/081088, paragraphs 0020 to 0062, and Appl. Phys. Let., 98, 083302 (2011), which are incorporated as a part of this description by reference.

A compound represented by the following general formula (10) emitting delayed fluorescent light is also particularly preferably used as the delayed fluorescent material in the present invention.

General Formula (10)

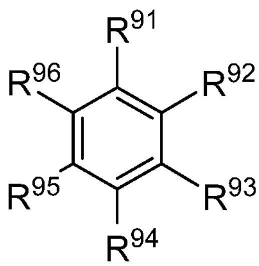

In the general formula (10), $R^{91}$ to $R^{96}$ each independently represent a hydrogen atom, a deuterium atom, a donor group, or an acceptor group, in which at least one thereof is the donor group, and at least two thereof are the acceptor groups. The substitution positions of the at least two acceptor groups are not particularly limited, and it is preferred that two acceptor groups that are respectively in meta-positions are contained. For example, in the case where $R^{91}$ represents the donor group, preferred examples of the structure include a structure where at least $R^{92}$ and $R^{94}$ represent the acceptor groups, and a structure where at least $R^{92}$ and $R^{96}$ represent the acceptor groups. The acceptor groups existing in the molecule may be the same as or different from each other, and a structure where all the groups are the same may be employed. The number of the acceptor groups is preferably 2 to 3, and for example, 2 may be selected therefor. Two or more donor groups may exist, and in this case, the donor groups may be the same as or different from each other. The number of donor group is preferably 1 to 3, and for example, may be 1, or may be 2. For the description and the preferred ranges of the donor group and the acceptor group, reference may be made to the corresponding description and the corresponding preferred ranges in the general formula (1). In the general formula (10), in particular, the donor group is preferably a group represented by the general formula (3), and the acceptor group is preferably a cyano group or a group represented by the following general formula (11).

General Formula (11)

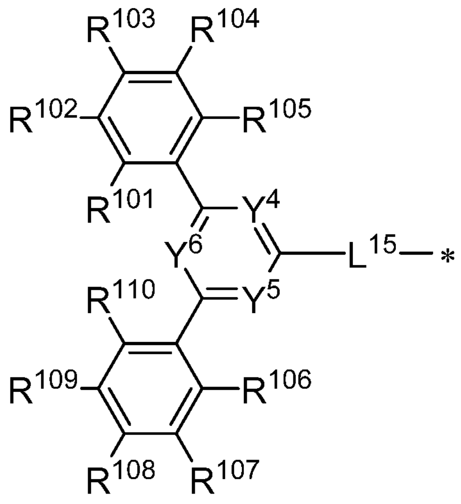

In the general formula (11), $Y^4$ to $Y^6$ each represent a nitrogen atom or a methine group, in which at least one thereof represents a nitrogen atom, and all thereof preferably represent nitrogen atoms. $R^{101}$ to $R^{110}$ each independently represent a hydrogen atom, a deuterium atom, or a substituent, in which at least one thereof preferably represents an alkyl group. For the description and the preferred ranges of the substituent herein, reference may be made to the description and the preferred ranges for the substituent in the general formula (7). $L^{15}$ represents a single bond or a linking group, and therefor, reference may be made to the description and the preferred ranges for L in the general formula (3). In one preferred embodiment of the present invention, $L^{15}$ in the general formula (11) represents a single bond. * indicates the bonding position to the carbon atom (C) constituting the ring skeleton of the ring in the general formula (10).

Preferred examples of the compound that can be used as the second organic compound are shown below. In the following structural formulae of the example compounds, t-Bu represents a tert-butyl group.

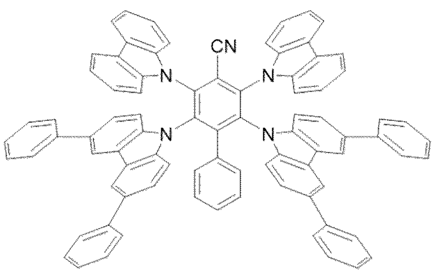

T1

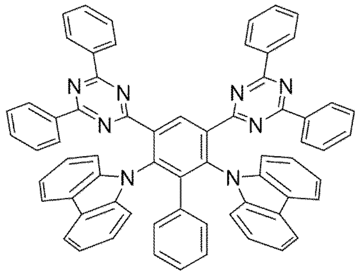

T2

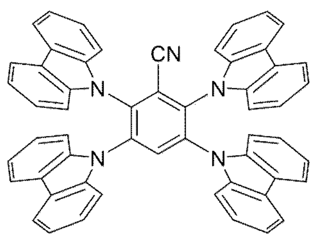

T3

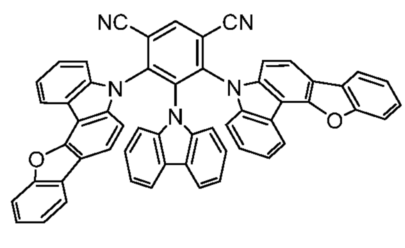

T4

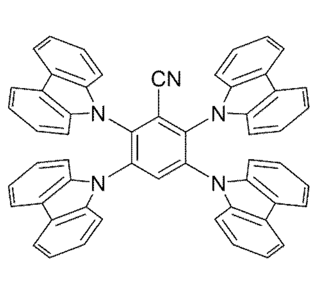

T5

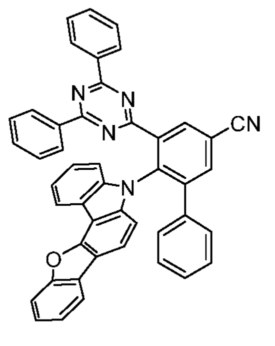

T6

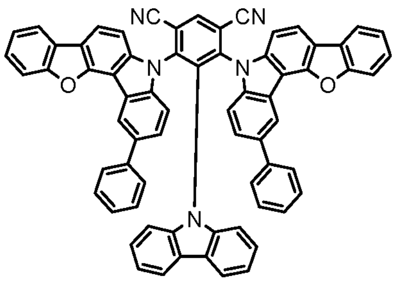

T7

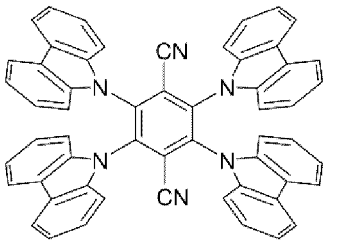

T8

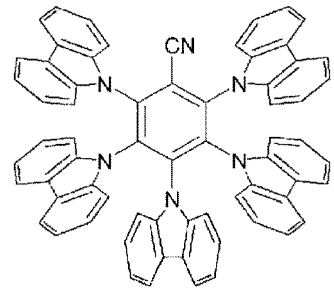

T9

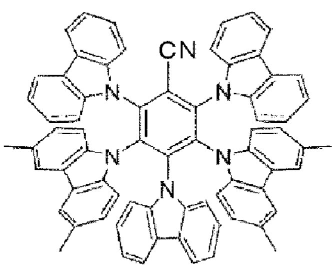

T10

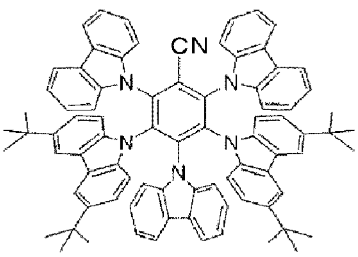

T11

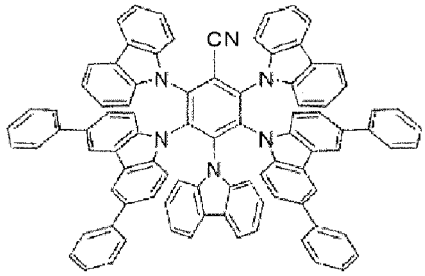

T12

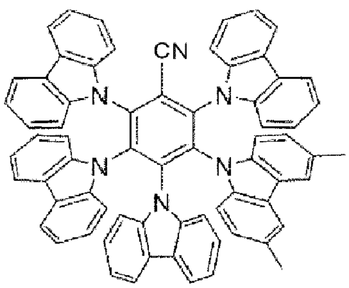

T13

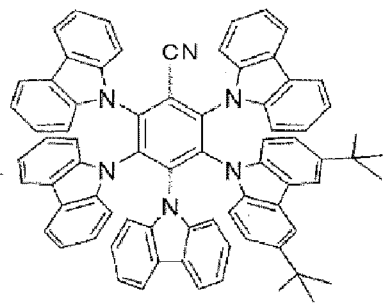

T14

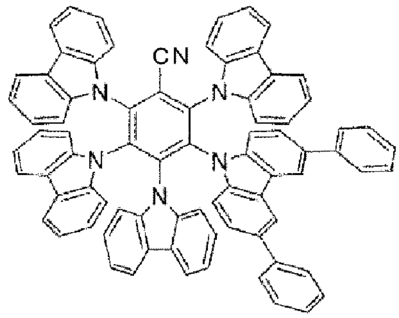

T15

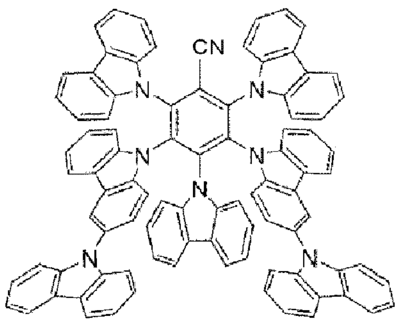

T16

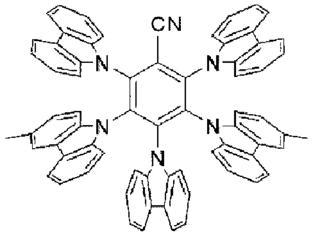

T17

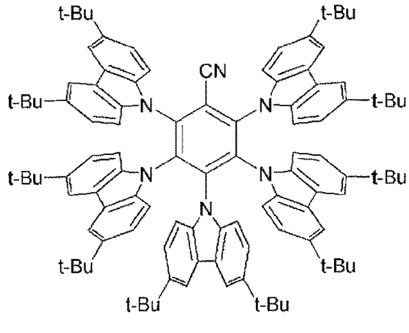

T18

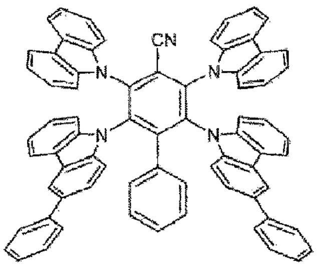

T19

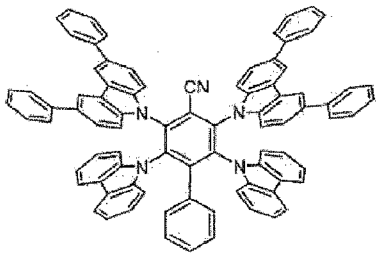

T20

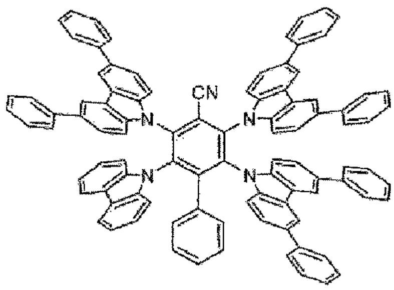

T21

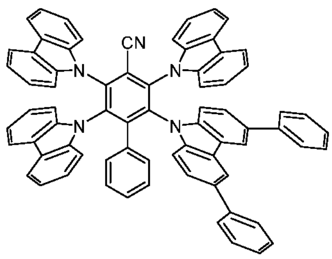

T22

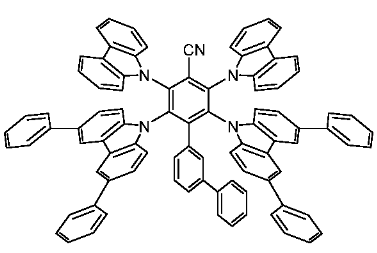

T23

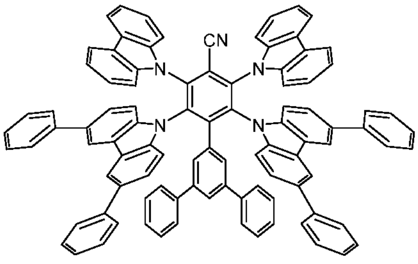

T24

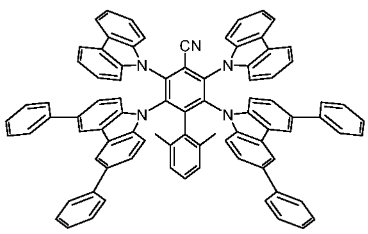

T25

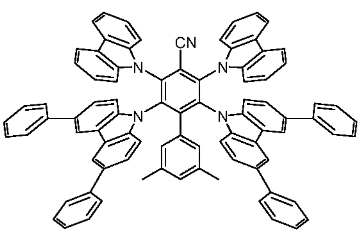

T26

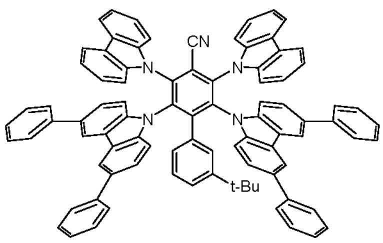

T27

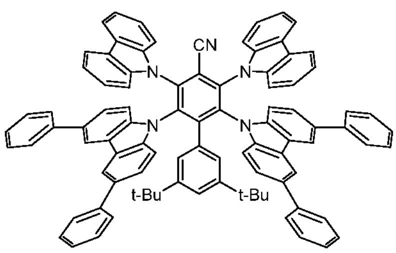

T28

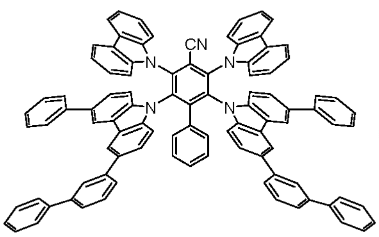

T29

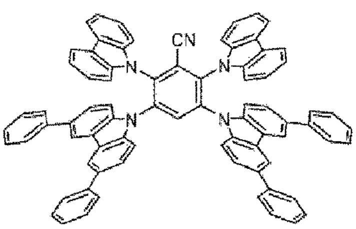

T30

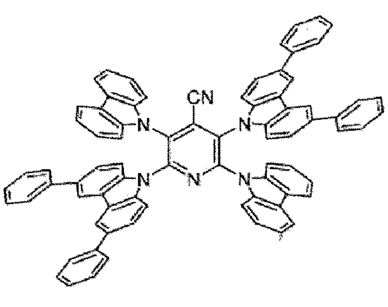

T31

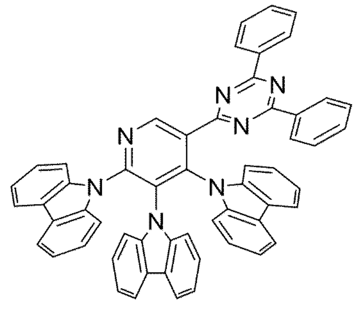

T32

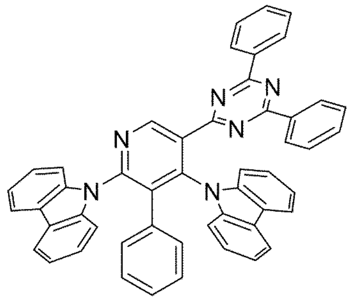

T33

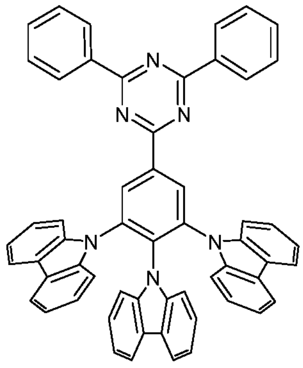

T34

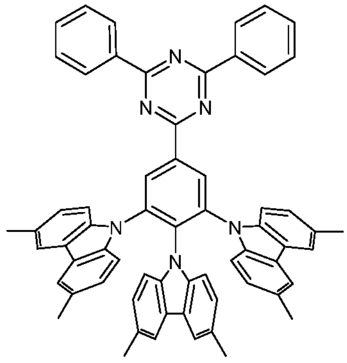

T35

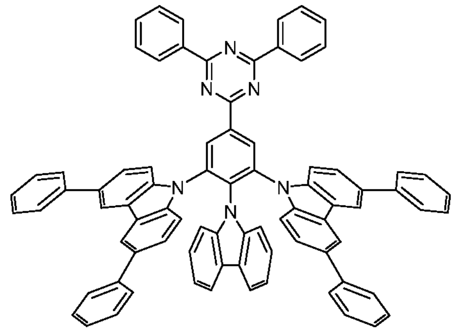

T36

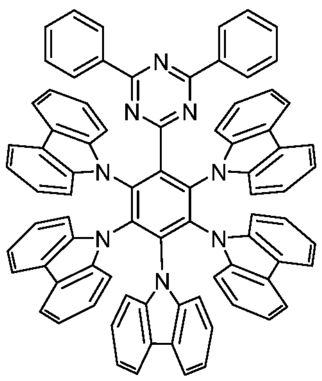

T37

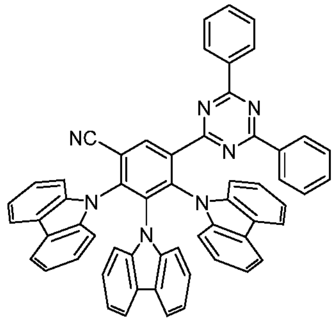

T38

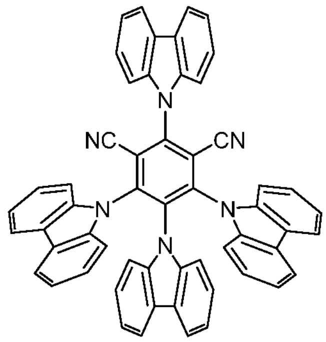

T39

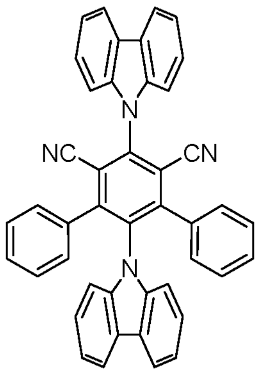

T40

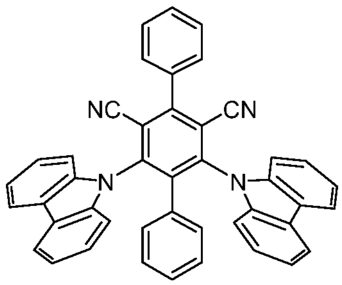

T41

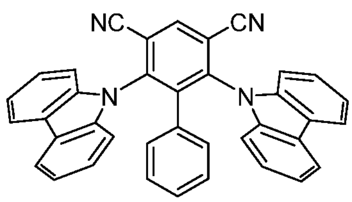

T42

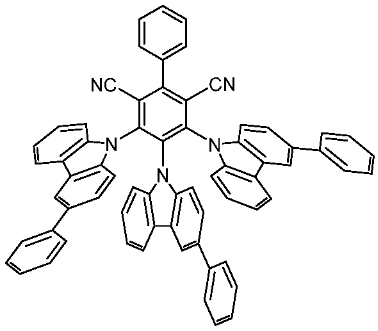

T43

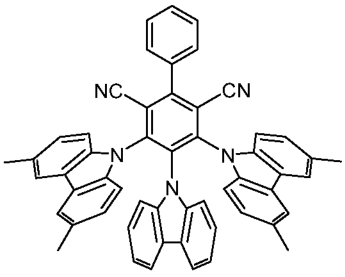

T44

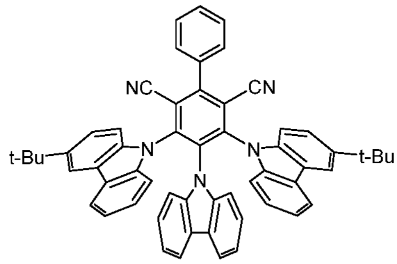

T45

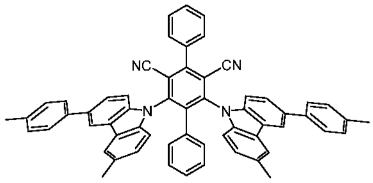

T46

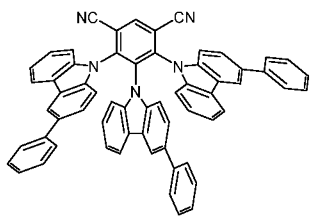

T47

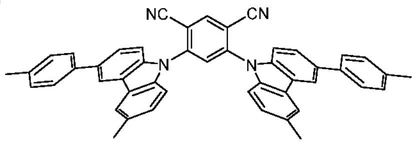

T48

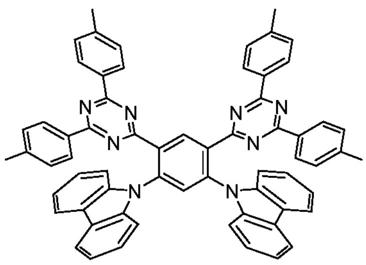

T49

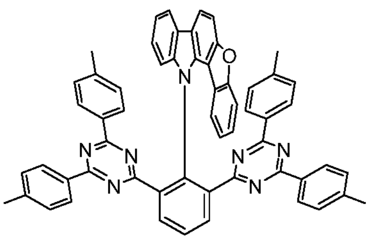

T50

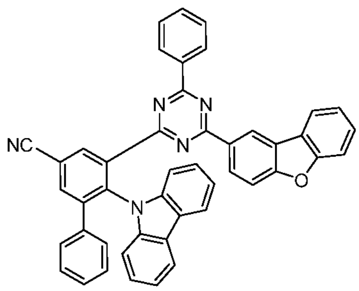

T51

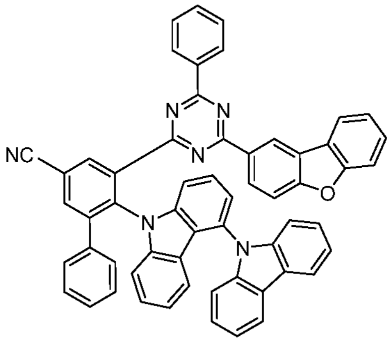

T52

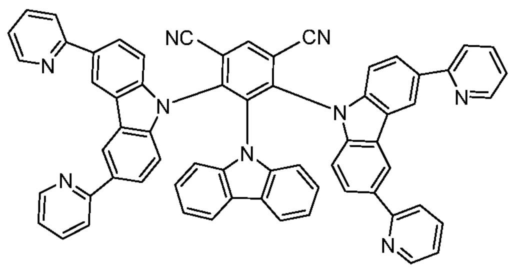

T53

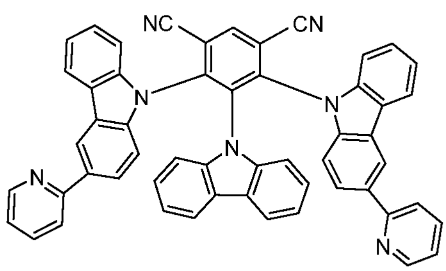

T54

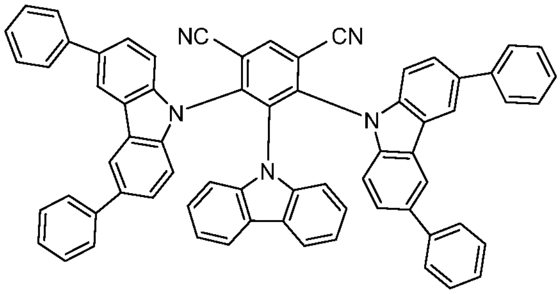

T55

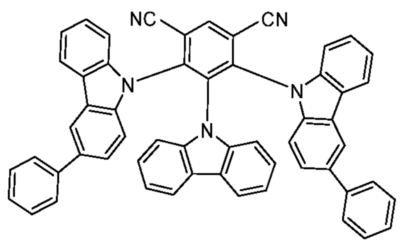

T56

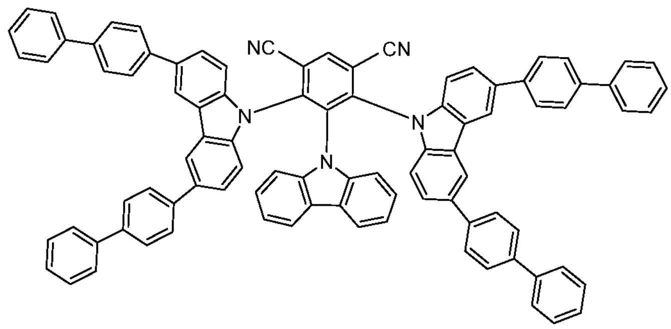

T57

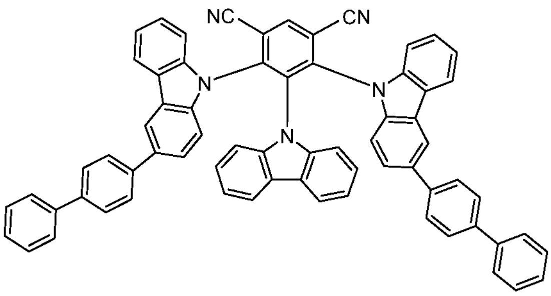

T58

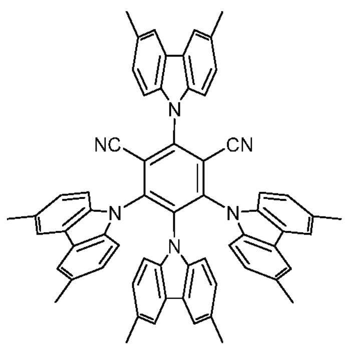

T59

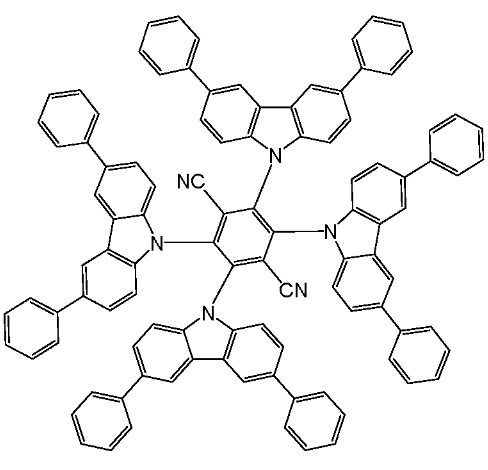

T60

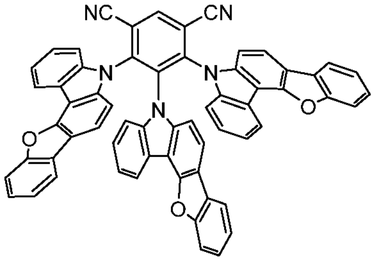

T61

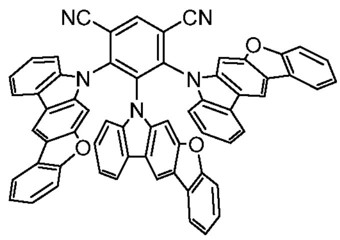

T62

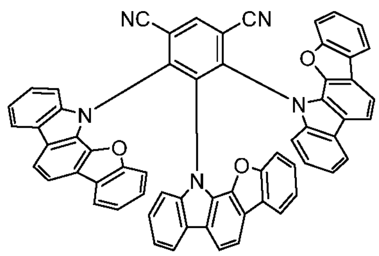

T63

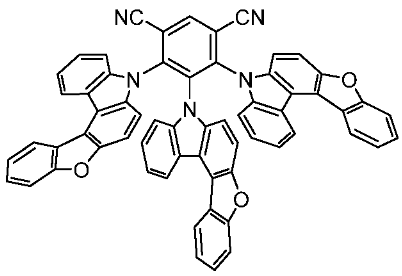

T64

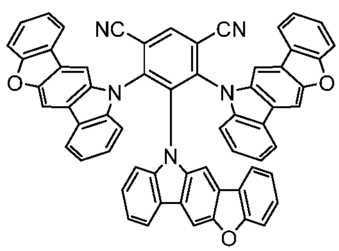

T65

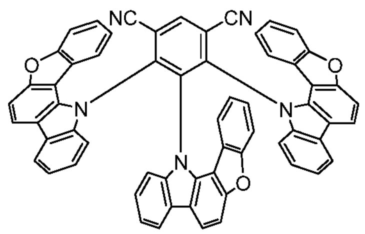

T66

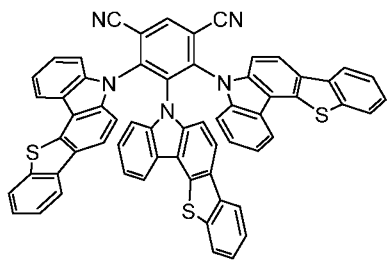

T67

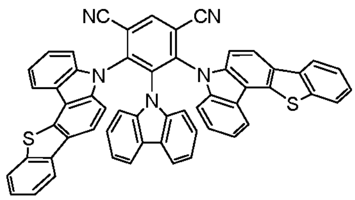

T68

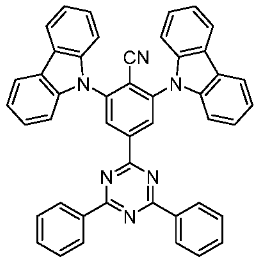

T69

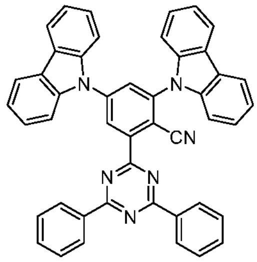

T70

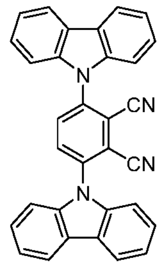

T71

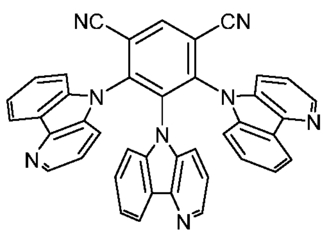

T72

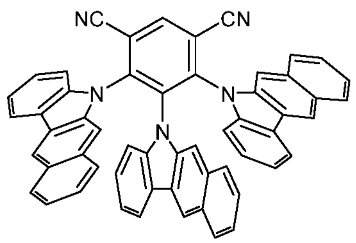

T73

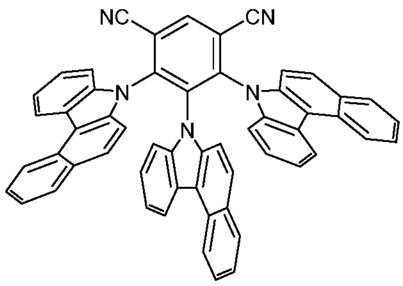

T74

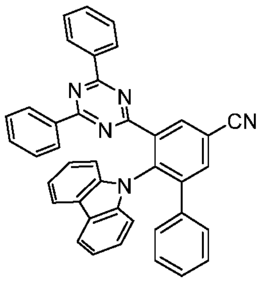

T75

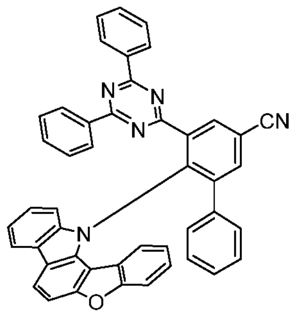

T76

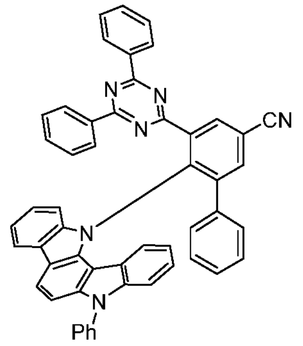

T77

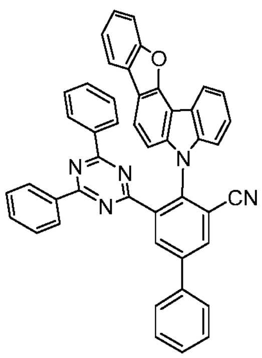

T78

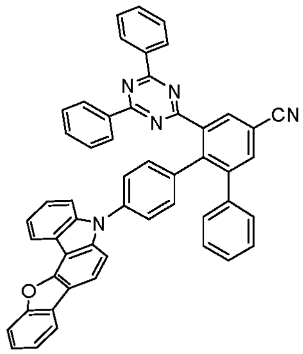

T79

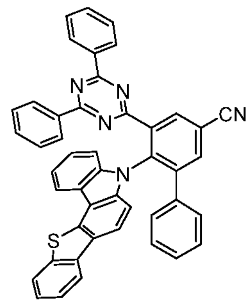

T80

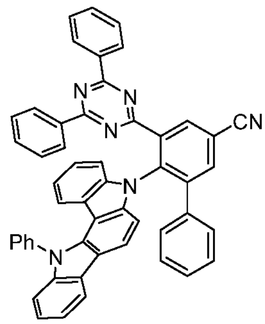

T81

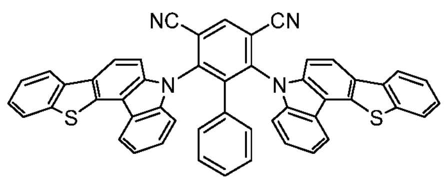

T82

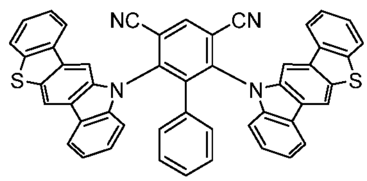

T83

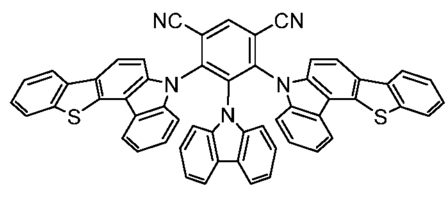

T84

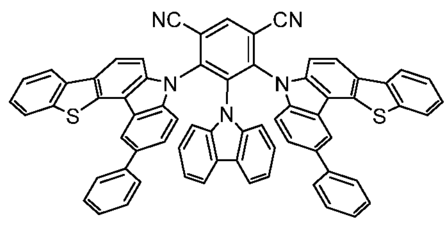

T85

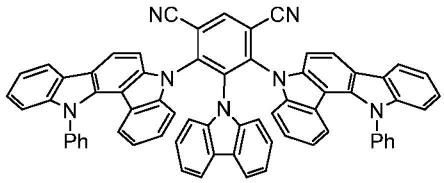

T86

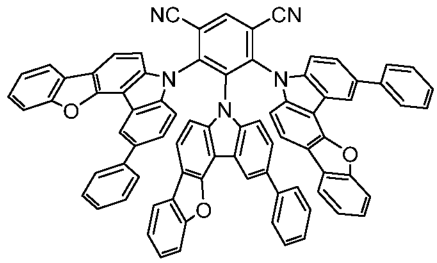

T87

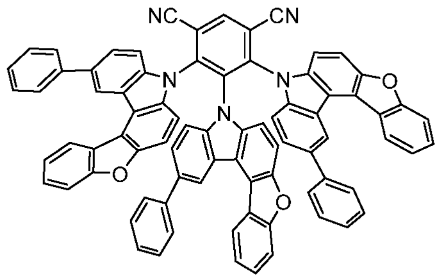

T88

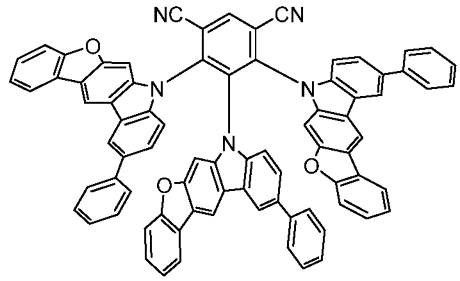

T89

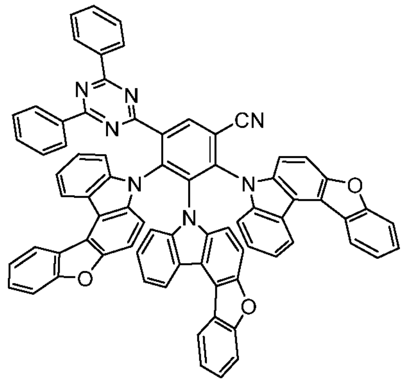

T90

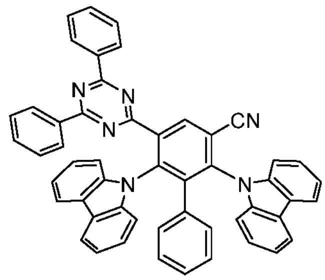

T91

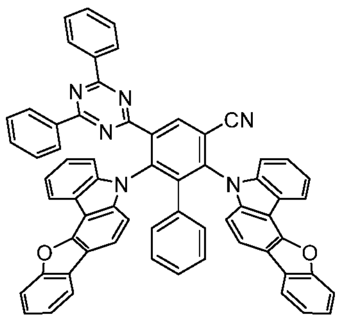

T92

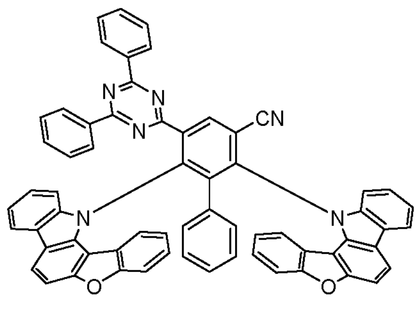

T93

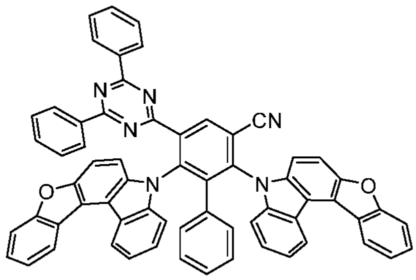

T94

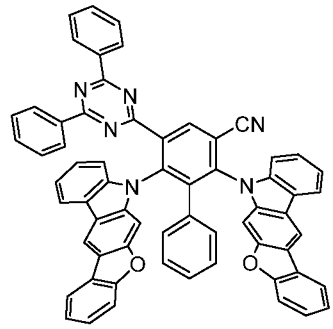

T95

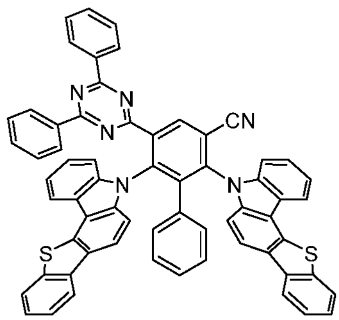

T96

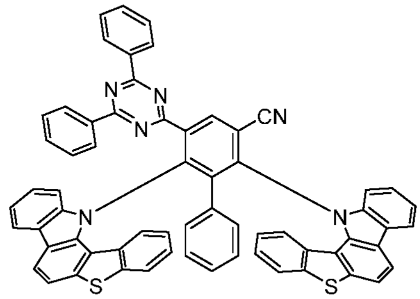

T97

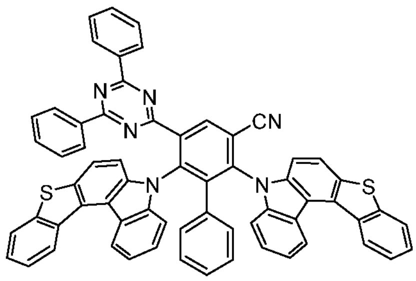

T98

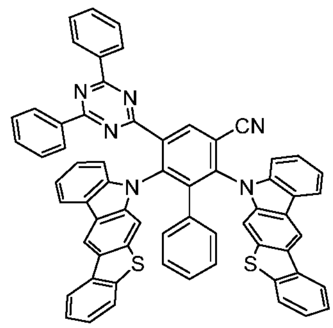

T99

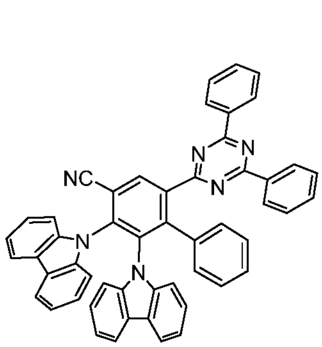

T100

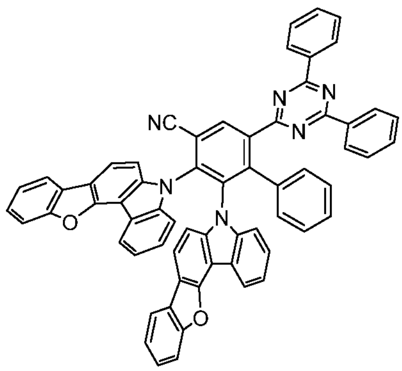

T101

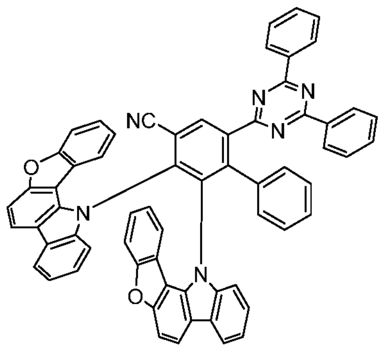

T102

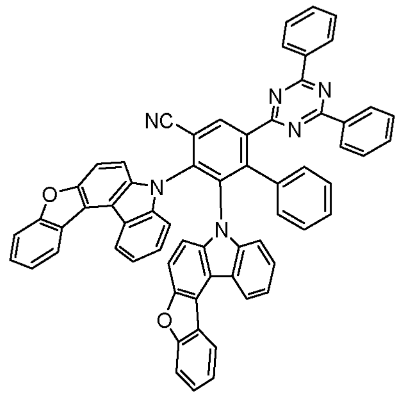

T103

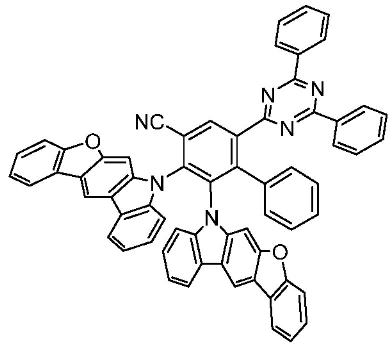

T104

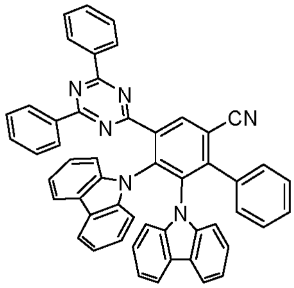

T105

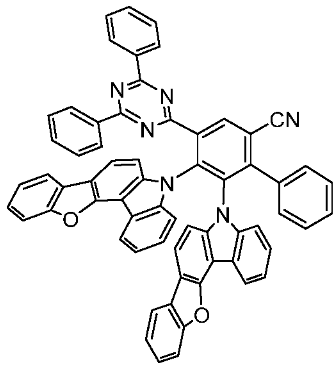

T106

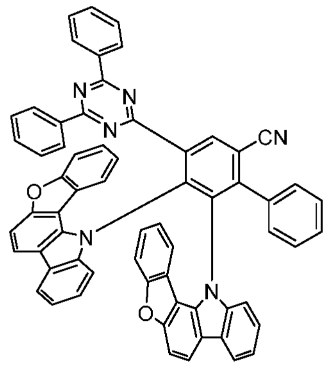

T107

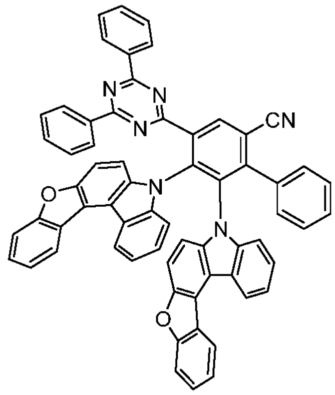

T108

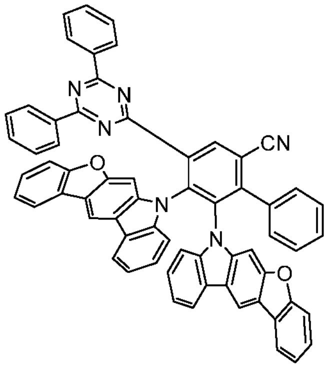

T109

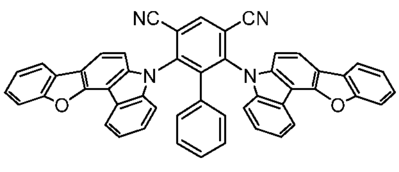

T110

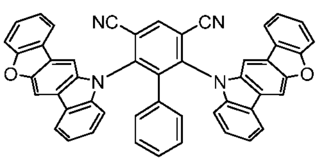

T111

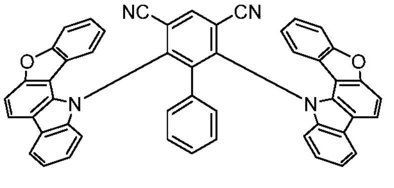

T112

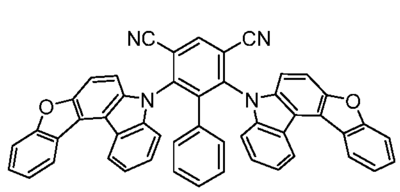
T113

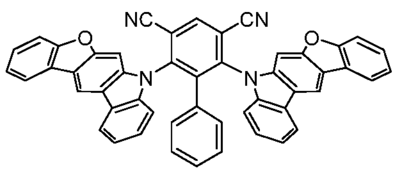
T114

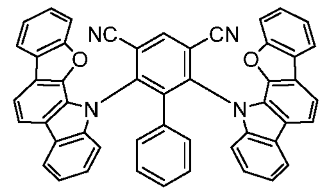
T115

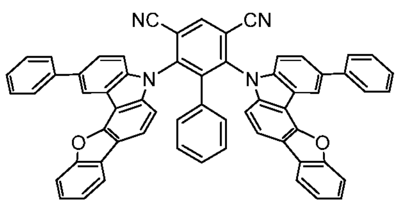
T116

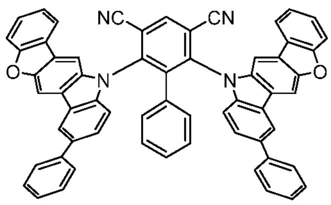
T117

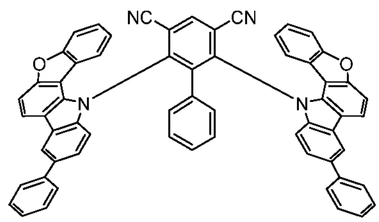
T118

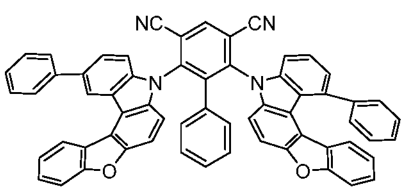
T119

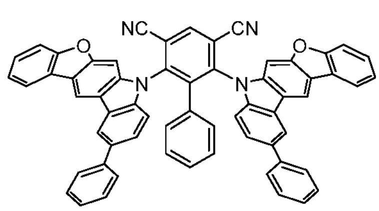
T120

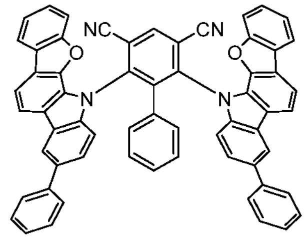
T121

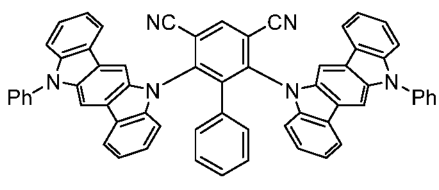
T122

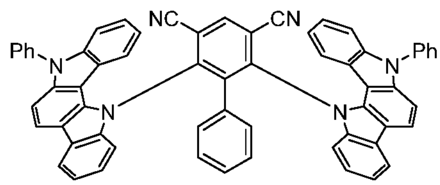
T123

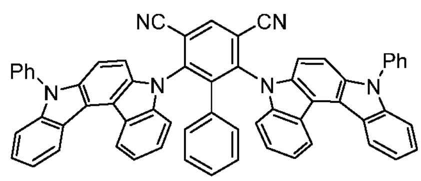
T124

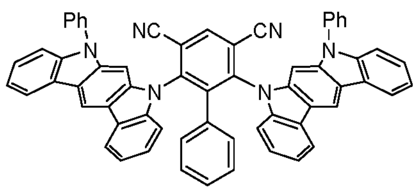
T125

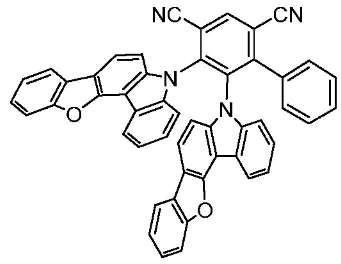

T126

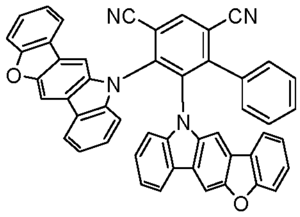

T127

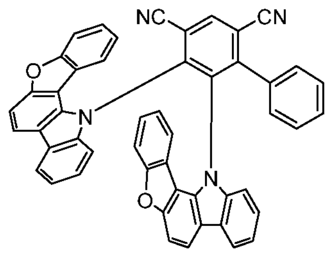

T128

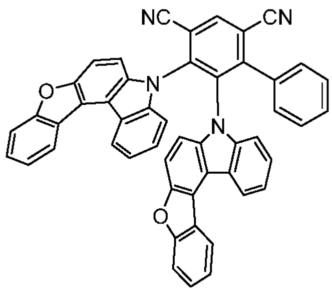

T129

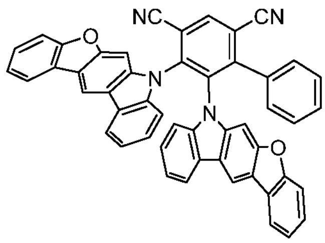

T130

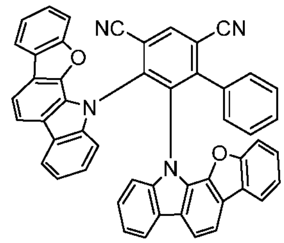

T131

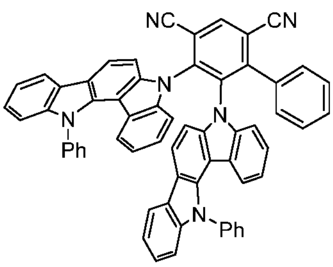

T132

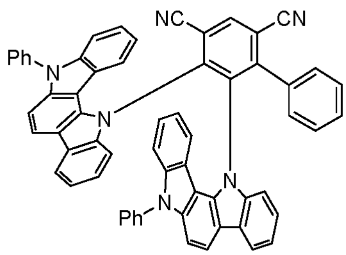

T133

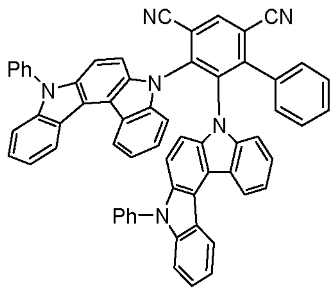

T134

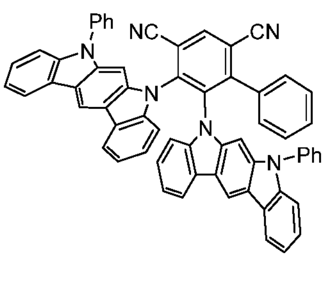

T135

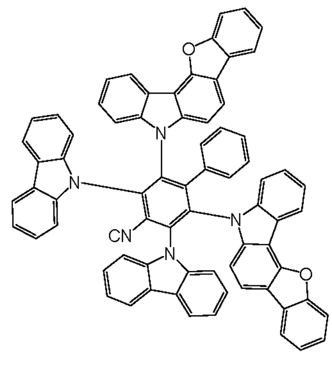

T136

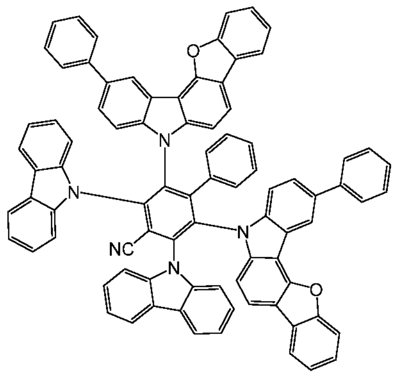

T137

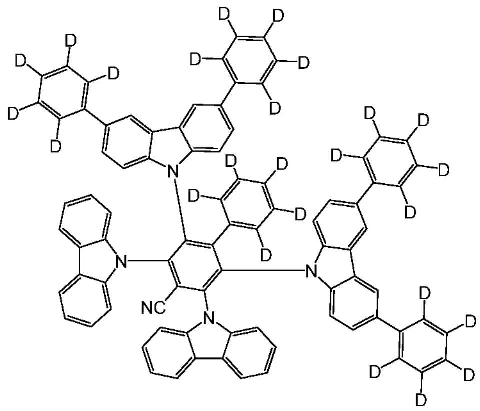

T138

The known delayed fluorescent materials other than above can be appropriately combined and used as the second organic compound. An unknown delayed fluorescent material can also be used.

As preferred delayed fluorescent materials, there can be mentioned compounds included in the general formulae described in WO2013/154064, paragraphs 0008 to 0048 and 0095 to 0133; WO2013/011954, paragraphs 0007 to 0047 and 0073~0085; WO2013/011955, paragraphs 0007 to 0033 and 0059 to 0066; WO2013/081088, paragraphs 0008 to 0071 and 0118 to 0133; JP 2013-256490 A, paragraphs 0009 to 0046 and 0093 to 0134; JP 2013-116975 A, paragraphs 0008 to 0020 and 0038 to 0040; WO2013/133359, paragraphs 0007 to 0032 and 0079 to 0084; WO2013/161437, paragraphs 0008 to 0054 and 0101~0121; JP 2014-9352 A, paragraphs 0007 to 0041 and 0060 to 0069; and JP 2014-9224 A, paragraphs 0008 to 0048 and 0067 to 0076; JP 2017-119663 A, paragraphs 0013 to 0025; JP 2017-119664 A, paragraphs 0013 to 0026; JP 2017-222623 A, paragraphs 0012 to 0025; JP 2017-226838 A, paragraphs 0010 to 0050; JP 2018-100411 A, paragraphs 0012 to 0043; WO2018/047853, paragraphs 0016 to 0044; and especially, exemplary compounds therein capable of emitting delayed fluorescence. In addition, also preferably employable here are light emitting materials capable of emitting delayed fluorescence, as described in JP 2013-253121 A, WO2013/133359, WO2014/034535, WO2014/115743, WO2014/122895, WO2014/126200, WO2014/136758, WO2014/133121, WO2014/136860, WO2014/196585, WO2014/189122, WO2014/168101, WO2015/008580, WO2014/203840, WO2015/002213, WO2015/016200, WO2015/019725, WO2015/072470, WO2015/108049, WO2015/080182, WO2015/072537, WO2015/080183, JP 2015-129240 A, WO2015/129714, WO2015/129715, WO2015/133501, WO2015/136880, WO2015/137244, WO2015/137202, WO2015/137136, WO2015/146541 and WO2015/159541. These patent publications described in this paragraph are hereby incorporated as a part of this description by reference.

(Third Organic Compound)

The third organic compound is a fluorescent material having lowest excited singlet energy that is lower than the first organic compound and the second organic compound. In one preferred embodiment of the present invention, the third organic compound is a fluorescent material having lowest excited triplet energy that is smaller than the first organic compound and the second organic compound. The third organic compound may be a delayed fluorescent material, or may be a compound that does not emit delayed fluorescent light. In the case where the third organic compound is a delayed fluorescent material, the lowest excited triplet energy thereof may be higher than the lowest excited triplet energy of the second organic compound. The third organic compound may be a compound having energy of the HOMO that is higher than the energy of the HOMO of the second organic compound or a compound having energy of the HOMO that is lower than the energy of the HOMO of the second organic compound. The third organic compound may be a compound having energy of the LUMO that is higher than the energy of the LUMO of the second organic compound or a compound having energy of the LUMO that is lower than the energy of the HOMO of the second organic compound. In one embodiment of the present invention, the third organic compound has energy of the HOMO that is lower than the second organic compound and energy of LUMO that is lower than the second organic compound.

The organic light emitting device using the third organic compound emits fluorescent light derived from the third organic compound. The light emission from the third organic compound generally includes delayed fluorescent light. The largest component of the light emission from the organic light emitting device of the present invention is the light emission from the third organic compound. Therefore, the light emission amount from the third organic compound is the largest in the light emission from the organic light emitting device of the present invention. In the light emission from the organic light emitting device of the present invention, 70% or more thereof may be the light emission from the third organic compound, 90% or more thereof may be the light emission from the third organic compound, or 99% or more

thereof may be the light emission from the third organic compound. The third organic compound transitions to the excited singlet state through reception of energy from the first organic compound in the excited singlet state, the second organic compound in the excited singlet state, and the second organic compound that transitions from the excited triplet state to the excited singlet state through reverse intersystem crossing. In a preferred embodiment of the present invention, the third organic compound transitions to the excited singlet state through reception of energy from the second organic compound in the excited singlet state and the second organic compound that transitions from the excited triplet state to the excited singlet state through reverse intersystem crossing. Thereafter, fluorescent light is emitted in returning the occurring excited singlet state of the third organic compound to the ground state.

The fluorescent material used as the third organic compound is not particularly limited, as far as being capable of emitting light through reception of energy from the first organic compound and the second organic compound, and the light emission may include any of fluorescent light, delayed fluorescent light, and phosphorescent light. It is preferred that the light emission includes fluorescent light and delayed fluorescent light, and it is more preferred that the largest component of the light emission from the third organic compound is fluorescent light. In one embodiment of the present invention, the organic light emitting device does not emit phosphorescent light, or the radiation amount of phosphorescent light thereof is 1% or less.

Two or more kinds of the third organic compounds may be used, as far as satisfying the conditions of the present invention. For example, the combination use of two or more kinds of the third organic compounds different in light emission color from each other enables light emission with intended color. One kind of the third organic compound may also be used to achieve monochromatic light emission from the third organic compound.

In the present invention, the maximum light emission wavelength of the compound that can be used as the third organic compound is not particularly limited. Accordingly, a light emitting material having a maximum light emission wavelength in the visible region (380 to 780 nm), a light emitting material having a maximum light emission wavelength in the infrared region (780 nm to 1 mm), a light emitting material having a maximum light emission wavelength in the ultraviolet region (for example, 280 to 380 nm), and the like can be appropriately selected and used. A fluorescent material having a maximum light emission wavelength in the visible region is preferably used. For example, within a range of 380 to 780 nm, a light emitting material having a maximum light emission wavelength in a range of 380 to 570 nm can be selected and used, a light emitting material having a maximum light emission wavelength in a range of 570 to 650 nm can be selected and used, a light emitting material having a maximum light emission wavelength in a range of 650 to 700 nm can be selected and used, and a light emitting material having a maximum light emission wavelength in a range of 700 to 780 nm can be selected and used.

In a preferred embodiment of the present invention, the second organic compound and the third organic compound are selected and combined so that the light emission wavelength region of the second organic compound and the absorption wavelength region of the third organic compound overlap each other. It is particularly preferred that the edge on the short wavelength side of the light emission spectrum of the second organic compound overlaps the edge on the long wavelength side of the absorption spectrum of the third organic compound.

The third organic compound preferably contains no other metal atom than a boron atom. For example, the third organic compound may be a compound that contains both a boron atom and a fluorine atom, may be a compound that contains a boron atom but no fluorine atom, or may be a compound that contains no metal atom. For example, the third organic compound selected may be a compound consisting of atoms selected from the group consisting of a carbon atom, a hydrogen atom, a deuterium atom, a nitrogen atom, an oxygen atom, a sulfur atom, a fluorine atom, and a boron atom. For example, the third organic compound selected may be a compound consisting of atoms selected from the group consisting of a carbon atom, a hydrogen atom, a deuterium atom, a nitrogen atom, an oxygen atom, a fluorine atom, and a boron atom. For example, the third organic compound selected may be a compound consisting of atoms selected from the group consisting of a carbon atom, a hydrogen atom, a deuterium atom, a nitrogen atom, an oxygen atom, a sulfur atom, and a boron atom. For example, the third organic compound selected may be a compound consisting of atoms selected from the group consisting of a carbon atom, a hydrogen atom, a deuterium atom, a nitrogen atom, and a boron atom. For example, the third organic compound selected may be a compound consisting of atoms selected from the group consisting of a carbon atom, a hydrogen atom, a deuterium atom, a nitrogen atom, an oxygen atom, and a sulfur atom. For example, the third organic compound selected may be a compound consisting of atoms selected from the group consisting of a carbon atom, a hydrogen atom, a deuterium atom, a nitrogen atom, and an oxygen atom.

Examples of the third organic compound include a compound having a multiple resonance effect of a boron atom and a nitrogen atom, and a compound including a condensed aromatic cyclic structure, such as anthracene, pyrene, and perylene.

In one preferred embodiment of the present invention, a compound represented by the following general formula (12) is used as the third organic compound.

General Formula (12)

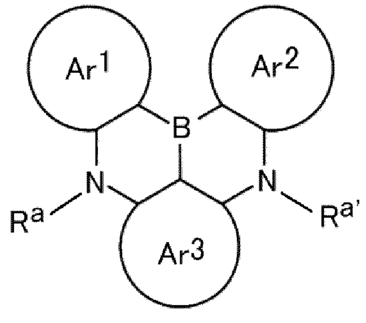

In the general formula (12), $Ar^1$ to $Ar^3$ each independently represent an aryl ring or a heteroaryl ring, in which at least one hydrogen atom in the ring may be substituted, and a ring may be condensed thereto. In the case where the hydrogen atom is substituted, the hydrogen atom is preferably substituted by one group or a group combining two or more groups selected from the group consisting of a deuterium atom, an aryl group, a heteroaryl group, and an alkyl group. In the case where a ring is condensed thereto, a benzene ring or a heteroaromatic ring (such as a furan ring, a thiophene ring, and a pyrrole ring) is preferably condensed. $R^a$ and $R^{a'}$ each independently represent a substituent, and preferably represent one group or a group combining two or more groups selected from the group consisting of a deuterium atom, an aryl group, a heteroaryl group, and an alkyl group. $R^a$ and $Ar^1$, $Ar^1$ and $Ar^2$, $Ar^2$ and $R^{a'}$, $R^{a'}$, and $Ar^3$, and $Ar^3$ and $R^a$ each may be bonded to each other to form a cyclic structure.

The compound represented by the general formula (12) preferably includes at least one carbazole structure. For example, one of the benzene rings constituting the carbazole structure may be the ring represented by $Ar^1$, one of the benzene rings constituting the carbazole structure may be the ring represented by $Ar^2$, and one of the benzene rings constituting the carbazole structure may be the ring represented by $Ar^3$. The carbazolyl group may be bonded to one or more of $Ar^1$ to $Ar^3$. For example, a substituted or unsubstituted carbazol-9-yl group may be bonded to the ring represented by $Ar^3$.

A condensed aromatic cyclic structure, such as anthracene, pyrene, and perylene, may be bonded to $Ar^1$ to $Ar^3$. $Ar^1$ to $Ar^3$ may be one ring constituting a condensed aromatic cyclic structure. At least one of $R^a$ and $R^{a'}$ may be a group having a condensed aromatic cyclic structure.

The compound may have multiple skeletons each represented by the general formula (12) existing therein. For example, the compound may have a structure including skeletons each represented by the general formula (12) bonded via a single bond or a linking group. The skeleton represented by the general formula (12) may have added thereto a structure showing a multiple resonance effect including benzene rings bonded via a boron atom, a nitrogen atom, an oxygen atom, or a sulfur atom.

In one preferred embodiment of the present invention, a compound including a BODIPY (4,4-difluoro-4-bora-3a,4a-diaza-s-indacene) structure is used as the third organic compound. For example, a compound represented by the following general formula (13) is used.

General Formula (13)

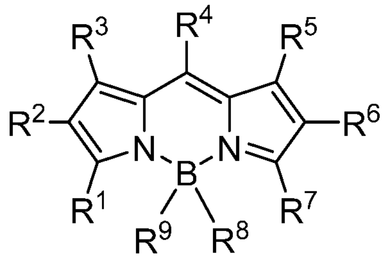

In the general formula (13), $R^1$ to $R^7$ each independently represent a hydrogen atom, a deuterium atom, or a substituent. At least one of $R^1$ to $R^7$ preferably represents a group represented by the following general formula (14).

General Formula (14)

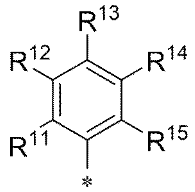

In the general formula (14), $R^{11}$ to $R^{15}$ each independently represent a hydrogen atom, a deuterium atom, or a substituent, and * indicates the bonding position.

The group represented by the general formula (14) may be one of $R^1$ to $R^7$ in the general formula (13), two thereof, or three thereof, and may be at least four thereof, for example, four or five thereof. In one preferred embodiment of the present invention, one of $R^1$ to $R^7$ is the group represented by the general formula (14). In one preferred embodiment of the present invention, at least $R^1$, $R^3$, $R^5$, and $R^7$ are the groups represented by the general formula (14). In one preferred embodiment of the present invention, only $R^1$, $R^3$, $R^4$, $R^5$, and $R^7$ are the groups represented by the general formula (14). In one preferred embodiment of the present invention, $R^1$, $R^3$, $R^4$, $R^5$, and $R^7$ are the groups represented by the general formula (14), and $R^2$ and $R^4$ are a hydrogen atom, a deuterium atom, an unsubstituted alkyl group (for example, having 1 to 10 carbon atoms), or an unsubstituted aryl group (for example, having 6 to 14 carbon atoms). In one embodiment of the present invention, all $R^1$ to $R^7$ are the groups represented by the general formula (14).

In one preferred embodiment of the present invention, $R^1$ and $R^7$ are the same as each other. In one preferred embodiment of the present invention, $R^3$ and $R^5$ are the same as each other. In one preferred embodiment of the present invention, $R^2$ and $R^6$ are the same as each other. In one preferred embodiment of the present invention, $R^1$ and $R^7$ are the same as each other, $R^3$ and $R^5$ are the same as each other, and $R^1$ and $R^3$ are different from each other. In one preferred embodiment of the present invention, $R^1$, $R^3$, $R^5$, and $R^7$ are the same as each other. In one preferred embodiment of the present invention, $R^1$, $R^4$, and $R^7$ are the same as each other, which are different from $R^3$ and $R^5$. In one preferred embodiment of the present invention, $R^3$, $R^4$, and $R^5$ are the same as each other, which are different from $R^1$ and $R^7$. In one preferred embodiment of the present invention, $R^1$, $R^3$, $R^5$, and $R^7$ are different from $R^4$.

For example, the substituent that $R^{11}$ to $R^{15}$ in the general formula (14) can represent can be selected from the substituent group A described later, can be selected from the substituent group B described later, can be selected from the substituent group C described later, or can be selected from the substituent group D described later. In the case where a substituted amino group is selected as the substituent, a di-substituted amino group is preferred, in which two substituent on the amino group each independently are preferably a substituted or unsubstituted aryl group, a substituted or unsubstituted heteroaryl group, or a substituted or unsubstituted alkyl group, and particularly preferably a substituted or unsubstituted aryl group (i.e., forming a diarylamino group). For example, the substituent that the two aryl groups of the diarylamino group can have can be selected from the substituent group A described later, can be selected from the substituent group B described later, can be selected from the substituent group C described later, or can be selected from the substituent group D described later. The two aryl groups of the diarylamino group may be bonded via a single bond or a linking group, and for the description of the linking group herein, reference may be made to the description for the linking group represented by $R^{33}$ and $R^{34}$. Specific examples of the diarylamino group include a substituted or unsubstituted carbazol-9-yl group. Examples of the substituted or unsubstituted carbazol-9-yl group include a group represented by the general formula (6), wherein $L^{11}$ represents a single bond.

In one preferred embodiment of the present invention, in the general formula (14), only $R^{13}$ is a substituent, and $R^{11}$, $R^{12}$, $R^{14}$, and $R^{15}$ are hydrogen atoms. In one preferred embodiment of the present invention, in the general formula (14), only $R^{11}$ is a substituent, and $R^{12}$, $R^{13}$, $R^{14}$, and $R^{15}$ are hydrogen atoms. In one preferred embodiment of the present invention, in the general formula (14), only $R^{11}$ and $R^{13}$ are substituents, and $R^{12}$, $R^{14}$, and $R^{15}$ are hydrogen atoms.

$R^1$ to $R^7$ in the general formula (13) each may include a group represented by the general formula (14), wherein all $R^{11}$ to $R^{15}$ are hydrogen atoms (i.e., a phenyl group). For example, $R^2$, $R^4$, and $R^6$ each may be a phenyl group.

In the general formula (13), $R^8$ and $R^9$ each independently preferably represent one group or a group combining two or more groups selected from the group consisting of a hydrogen atom, a deuterium atom, a halogen atom, an alkyl group (for example, having 1 to 40 carbon atoms), an alkoxy group (for example, having 1 to 40 carbon atoms), an aryloxy group (for example, having 6 to 30 carbon atoms), and a cyano group. In a preferred embodiment of the present invention, $R^8$ and $R^9$ are the same as each other. In a preferred embodiment of the present invention, $R^8$ and $R^9$ each represent a halogen atom, and particularly preferably a fluorine atom.

In one embodiment of the present invention, the total number of the substituted or unsubstituted alkoxy group, the substituted or unsubstituted aryloxy group, and the substituted or unsubstituted amino group existing in $R^1$ to $R^9$ in the general formula (13) is preferably 3 or more, and for example, a compound having the number of 3 or a compound

having the number of 4 may be used. In one more preferred embodiment, the total number of the substituted or unsubstituted alkoxy group, the substituted or unsubstituted aryloxy group, and the substituted or unsubstituted amino group existing in $R^1$ to $R^7$ in the general formula (13) is preferably 3 or more, and for example, a compound having the number of 3 or a compound having the number of 4 may be used. In this case, an alkoxy group, an aryloxy group, and an amino group may not exist in $R^8$ and $R^9$. In one further preferred embodiment, the total number of the substituted or unsubstituted alkoxy group, the substituted or unsubstituted aryloxy group, and the substituted or unsubstituted amino group existing in $R^1$, $R^3$, $R^4$, $R^5$, and $R^7$ in the general formula (13) is preferably 3 or more, and for example, a compound having the number of 3 or a compound having the number of 4 may be used. In this case, an alkoxy group, an aryloxy group, and an amino group may not exist in $R^2$, $R^6$, $R^8$, and $R^9$. In one preferred embodiment of the present invention, 3 or more substituted or unsubstituted alkoxy groups exist. In one preferred embodiment of the present invention, 4 or more substituted or unsubstituted alkoxy groups exist. In one preferred embodiment of the present invention, 1 or more substituted or unsubstituted alkoxy group and two or more substituted or unsubstituted aryloxy groups exist. In one preferred embodiment of the present invention, 2 or more substituted or unsubstituted alkoxy groups and one or more substituted or unsubstituted amino group exist. In one preferred embodiment of the present invention, a substituted or unsubstituted alkoxy group or a substituted or unsubstituted aryloxy group exists in each of $R^1$, $R^4$, and $R^7$. In one preferred embodiment of the present invention, a substituted or unsubstituted alkoxy group exists in each of $R^1$, $R^4$, and $R^7$.

In one embodiment of the present invention, the total number of the substituent that has a Hammett's $\sigma_p$ value of less than -0.2 existing in $R^1$ to $R^9$ in the general formula (13) is 3 or more. Examples of the substituent that has a Hammett's $\sigma_p$ value of less than -0.2 include a methoxy group (-0.27), an ethoxy group (-0.24), a n-propoxy group (-0.25), an isopropoxy group (-0.45), and an n-butoxy group (-0.32). A fluorine atom (0.06), a methyl group (-0.17), an ethyl group (-0.15), a tert-butyl group (-0.20), a n-hexyl group (-0.15), a cyclohexyl group (-0.15), and the like are not the substituent that has a Hammett's $\sigma_p$ value of less than -0.2.

In one embodiment of the present invention, a compound having 3 of substituents that have a Hammett's $\sigma_p$ value of less than -0.2 existing in $R^1$ to $R^9$ in the general formula (13) may be used, or a compound having 4 thereof may be used. In one more preferred embodiment, the total number of the substituent that has a Hammett's $\sigma_p$ value of less than -0.2 existing in $R^1$ to $R^7$ in the general formula (13) is 3 or more, and for example, a compound having 3 thereof may be used, or a compound having 4 thereof may be used. In this case, the substituent that has a Hammett's $\sigma_p$ value of less than - 0.2 may not exist in $R^8$ and $R^9$. In one further preferred embodiment, the total number of the substituent that has a Hammett's $\sigma_p$ value of less than -0.2 existing in $R^1$, $R^3$, $R^4$, $R^5$, and $R^7$ in the general formula (13) is 3 or more, and for example, a compound having 3 thereof may be used, or a compound having 4 thereof may be used. In this case, the substituent that has a Hammett's $\sigma_p$ value of less than -0.2 may not exist in $R^2$, $R^6$, $R^8$, and $R^9$. In a preferred embodiment of the present invention, the substituent that has a Hammett's $\sigma_p$ value of less than -0.2 exists in each of $R^1$, $R^4$, and $R^7$.

In the present invention, a compound including a carbazole structure may be selected as the third organic compound. A compound that does not include any of a carbazole structure, a dibenzofuran structure, and a dibenzothiophene structure may also be selected as the third organic compound.

Preferred examples of the compound that can be used as the third organic compound are shown below. In the following structural formulae of the example compounds, t-Bu represents a tert-butyl group.

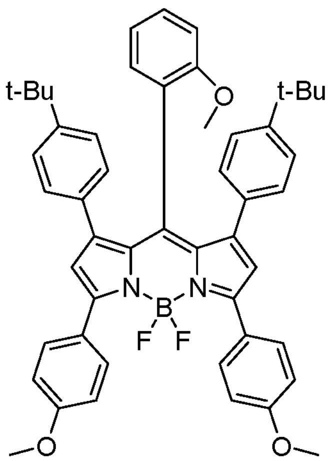

F1

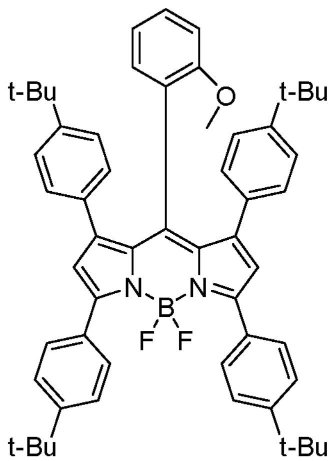

F2

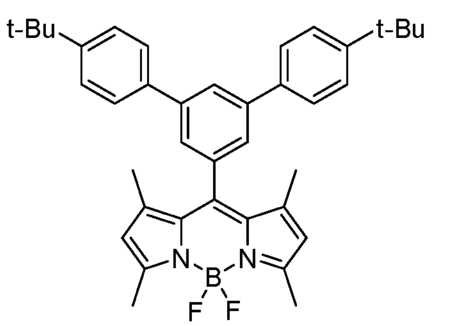

F3

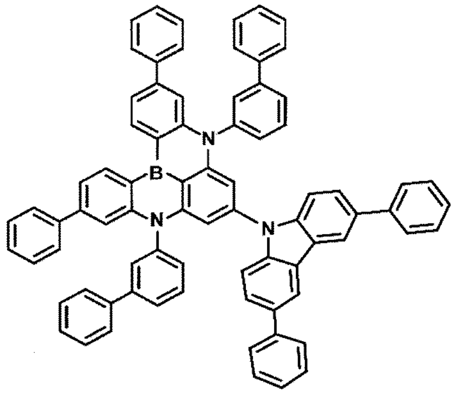

F4

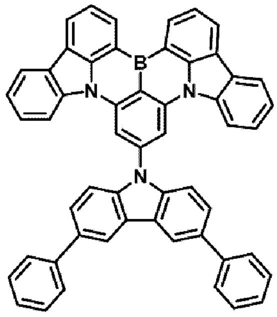

F5

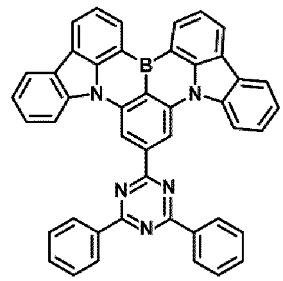

F6

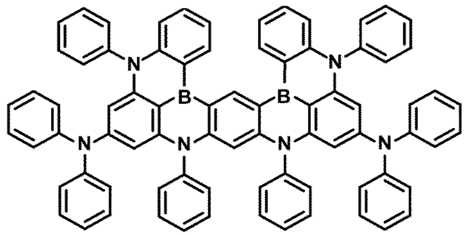

F7

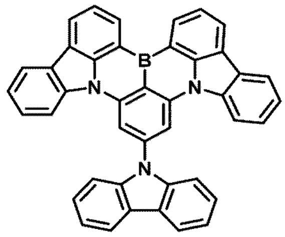

F8

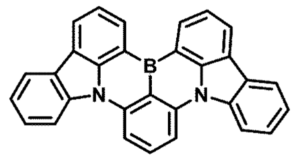

F9

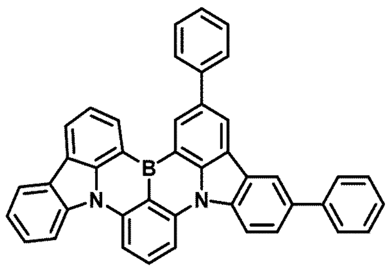

F10

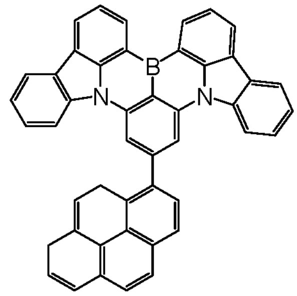

F11

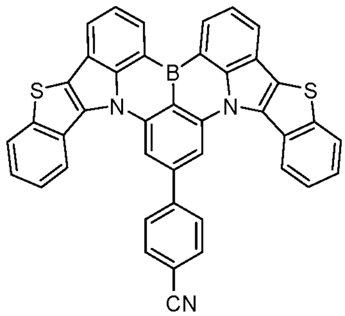

F12

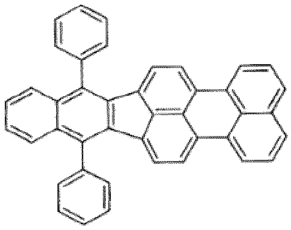

F13

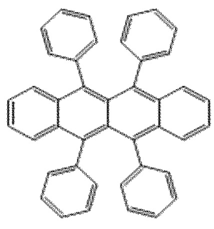

F14

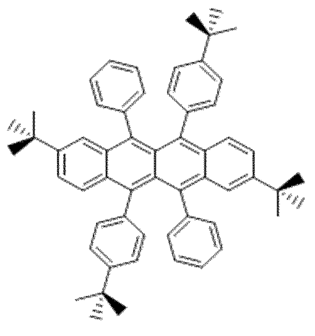

F15

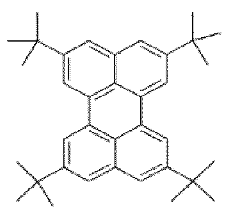

F16

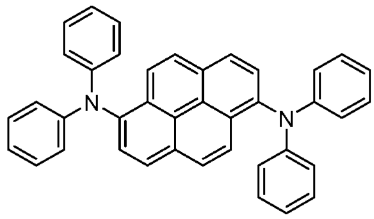

F17

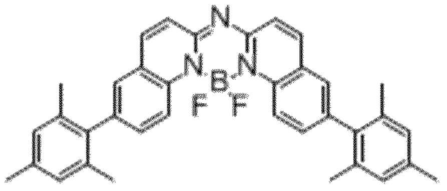

F18

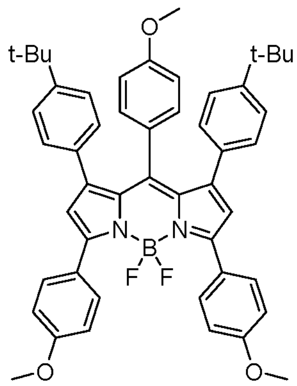

F19

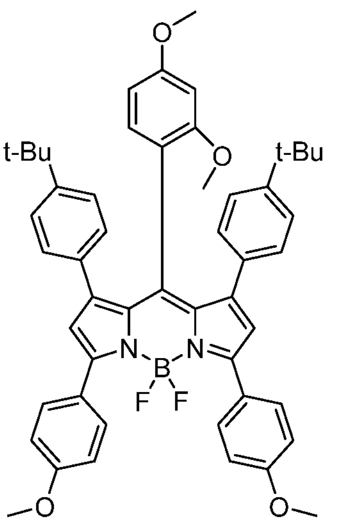

F20

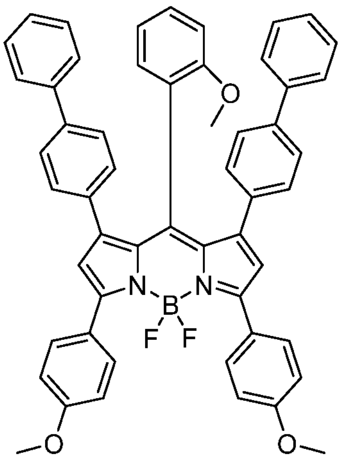

F21

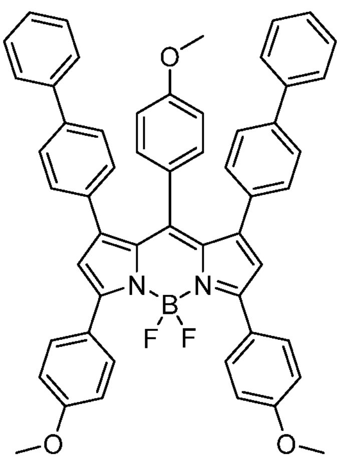

F22

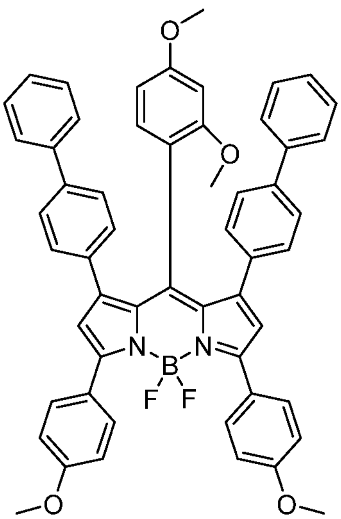

F23

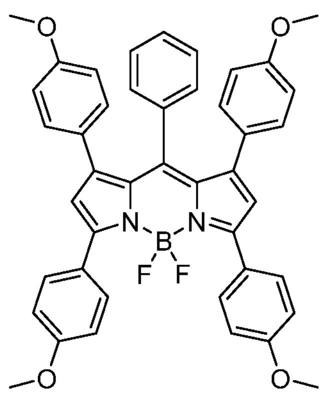

F24

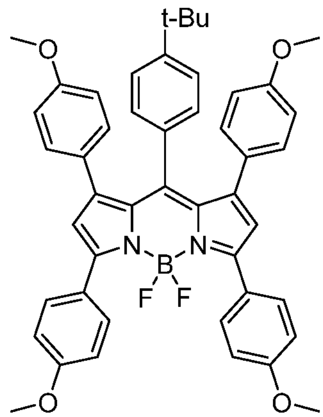

F25

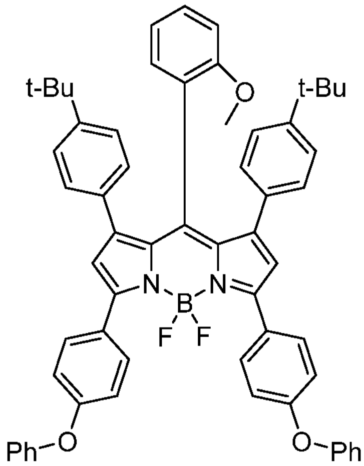

F26

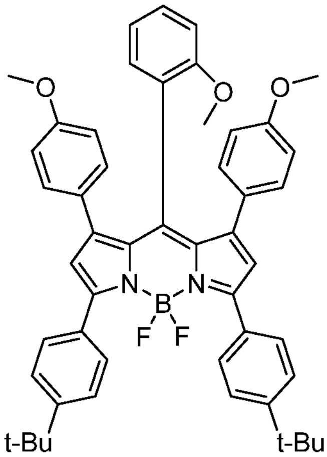

F27

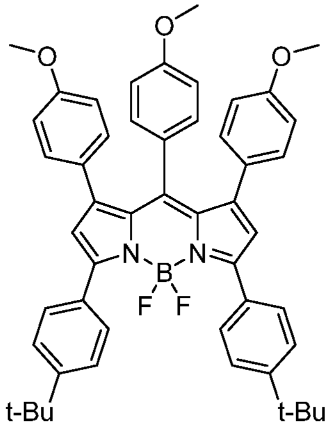

F28

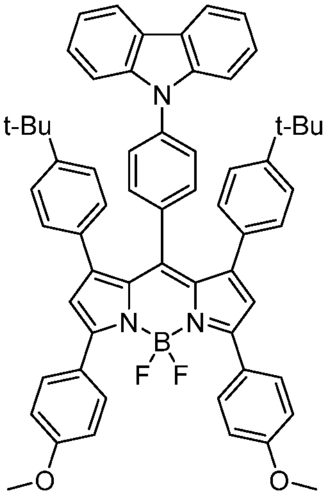

F29

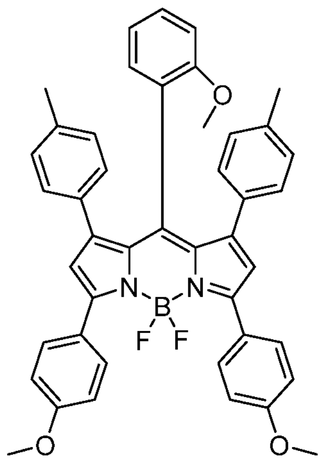

F30

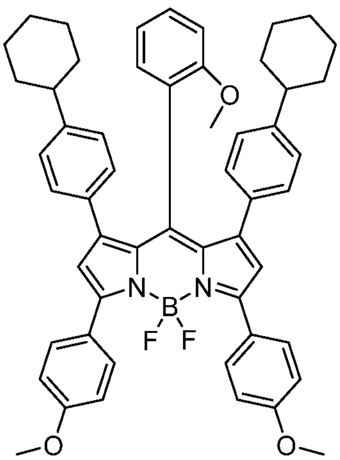

F31

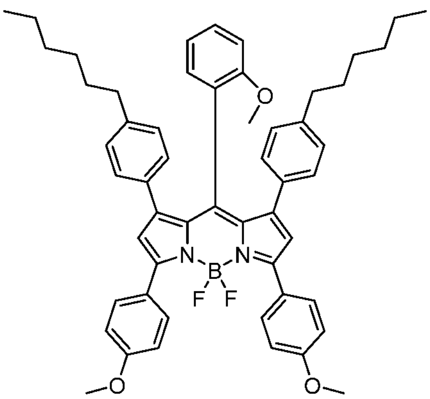

F32

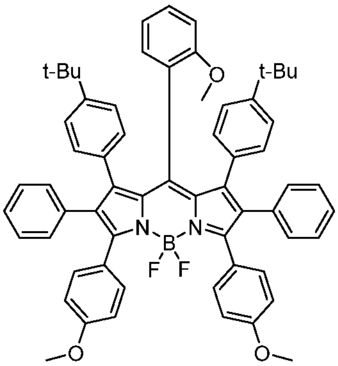

F33

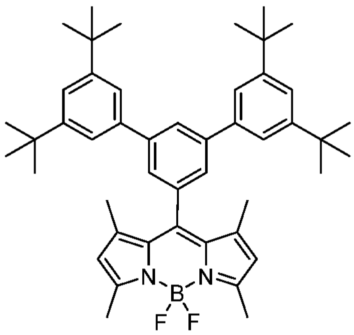

F34

Examples of derivatives of the example compounds include compounds obtained by substituting at least one hydrogen atom by a deuterium atom, an alkyl group, an aryl group, a heteroaryl group, or a diarylamino group.

The compounds described in WO 2015/022974, paragraphs 0220 to 0239, and the compound represented by the general formula (1) of WO 2021/015177, particularly the compounds described in paragraphs 0132 to 0194 and the

compounds described in paragraphs 0195 to 0255 thereof, can also be particularly preferably used as the third organic compound in the present invention.

Here, "alkyl group" can be linear, branched or cyclic. Two or more of a linear moiety, a cyclic moiety and a branched moiety can be in the group as mixed. The carbon number of the alkyl group can be, for example, 1 or more, 2 or more, or 4 or more. The carbon number can also be 30 or less, 20 or less, 10 or less, 6 or less, or 4 or less. Specific examples of the alkyl group include a methyl group, an ethyl group, an n-propyl group, an isopropyl group, an n-butyl group, an isobutyl group, a tert-butyl group, an n-pentyl group, an isopentyl group, an n-hexyl group, an isohexyl group, a 2-ethylhexyl group, an n-heptyl group, an isoheptyl group, an n-octyl group, an isooctyl group, an n-nonyl group, an isononyl group, an n-decanyl group, an isodecanyl group, a cyclopentyl group, a cyclohexyl group, and a cycloheptyl group. The alkyl group of a substituent can be further substituted with an aryl group.

"Alkenyl group" can be linear, branched or cyclic. Two or more of a linear moiety, a cyclic moiety and a branched moiety can be in the group as mixed. The carbon number of the alkyl group can be, for example, 2 or more, or 4 or more. The carbon number can also be 30 or less, 20 or less, 10 or less, 6 or less, or 4 or less. Specific examples of the alkenyl group include an ethenyl group, an n-propenyl group, an isopropenyl group, an n-butenyl group, an isobutenyl group, an n-pentenyl group, an isopentenyl group, an n-hexenyl group, an isohexenyl group, and a 2-ethylhexenyl group. The alkenyl group to be a substituent can be further substituted with an aryl group.

The "aryl group" and the "heteroaryl group" each may be a monocyclic ring or a condensed ring including two or more rings condensed. The number of rings condensed to form the condensed ring is preferably 2 to 6, and may be selected, for example, from 2 to 4. Specific examples of the ring include a benzene ring, a pyridine ring, a pyrimidine ring, a triazine ring, a napthalene ring, an anthracene ring, a phenanthrene ring, a triphenylene ring, a quinoline ring, a pyrazine ring, a quinoxaline ring, and a naphthyridine ring. Specific examples of the aryl group and the heteroaryl group include a phenyl group, a 1-naphtyl group, a 2-naphthyl group, a 1-anthracenyl group, a 2-anthracenyl group, a 9-anthracenyl group, a 2-pyridyl group, a 3-pyridyl group, and a 4-pyridyl group. The "arylene group" and the "heteroarylene group" may be groups obtained by changing the valence of the groups described for the aryl group and the heteroaryl group from 1 to 2.

In the description herein, the "substituent group A" means one group or a group combining two or more groups selected from the group consisting of a hydroxy group, a halogen atom (such as a fluorine atom, a chlorine atom, a bromine atom, and an iodine atom), an alkyl group (for example, having 1 to 40 carbon atoms), an alkoxy group (for example, having 1 to 40 carbon atoms), an alkylthio group (for example, having 1 to 40 carbon atoms), an aryl group (for example, having 6 to 30 carbon atoms), an aryloxy group (for example, having 6 to 30 carbon atoms), an arylthio group (for example, having 6 to 30 carbon atoms), a heteroaryl group (for example, having 5 to 30 ring skeleton-forming carbon atoms), a heteroaryloxy group (for example, having 5 to 30 ring skeleton-forming carbon atoms), a heteroarylthio group (for example, having 5 to 30 ring skeleton-forming carbon atoms), an acyl group (for example, having 1 to 40 carbon atoms), an alkenyl group (for example, having 1 to 40 carbon atoms), an alkynyl group (for example, having 1 to 40 carbon atoms), an alkoxycarbonyl group (for example, having 1 to 40 carbon atoms), an aryloxycarbonyl group (for example, having 1 to 40 carbon atoms), a heteroaryloxycarbonyl group (for example, having 1 to 40 carbon atoms), a silyl group (for example, a trialkylsilyl group having 1 to 40 carbon atoms), and a nitro group.

In the description herein, the "substituent group B" means one group or a group combining two or more groups selected from the group consisting of an alkyl group (for example, having 1 to 40 carbon atoms), an alkoxy group (for example, having 1 to 40 carbon atoms), an aryl group (for example, having 6 to 30 carbon atoms), an aryloxy group (for example, having 6 to 30 carbon atoms), a heteroaryl group (for example, having 5 to 30 ring skeleton-forming carbon atoms), a heteroaryloxy group (for example, having 5 to 30 ring skeleton-forming carbon atoms), and a diarylaminoamino group (for example, having 0 to 20 carbon atoms).

In the description herein, the "substituent group C" means one group or a group combining two or more groups selected from the group consisting of an alkyl group (for example, having 1 to 20 carbon atoms), an aryl group (for example, having 6 to 22 carbon atoms), a heteroaryl group (for example, having 5 to 20 ring skeleton-forming carbon atoms), and a diarylamino group (for example, having 12 to 20 carbon atoms).

In the description herein, the "substituent group D" means one group or a group combining two or more groups selected from the group consisting of an alkyl group (for example, having 1 to 20 carbon atoms), an aryl group (for example, having 6 to 22 carbon atoms), and a heteroaryl group (for example, having 5 to 20 ring skeleton-forming carbon atoms).

(Light Emitting Layer)

The light emitting layer of the organic light emitting device of the present invention contains the first organic compound, the second organic compound, and the third organic compound. The light emitting layer may have a configuration that does not contain a compound donating or receiving charge or energy or a metal element other than boron, in addition to these compounds. The light emitting layer may be constituted only by a compound consisting of atoms

selected from the group consisting of a carbon atom, a hydrogen atom, a deuterium atom, a nitrogen atom, a boron atom, a fluorine atom, an oxygen atom, and a sulfur atom. For example, the light emitting layer may be constituted only by a compound consisting of atoms selected from the group consisting of a carbon atom, a hydrogen atom, a deuterium atom, a nitrogen atom, a boron atom, a fluorine atom, and an oxygen atom. For example, the light emitting layer may be constituted only by a compound consisting of atoms selected from the group consisting of a carbon atom, a hydrogen atom, a deuterium atom, a nitrogen atom, a boron atom, a fluorine atom, and a sulfur atom. For example, the light emitting layer may be constituted only by a compound consisting of atoms selected from the group consisting of a carbon atom, a hydrogen atom, a deuterium atom, a nitrogen atom, and a boron atom. For example, the light emitting layer may be constituted only by a compound consisting of atoms selected from the group consisting of a carbon atom, a hydrogen atom, a deuterium atom, a nitrogen atom, an oxygen atom, and a sulfur atom. For example, the light emitting layer may be constituted only by a compound consisting of atoms selected from the group consisting of a carbon atom, a hydrogen atom, a deuterium atom, and a nitrogen atom. The light emitting layer may include the first organic compound constituted by atoms selected from the group consisting of a carbon atom, a hydrogen atom, a nitrogen atom, an oxygen atom, and a sulfur atom, the second organic compound constituted by atoms selected from the group consisting of a carbon atom, a hydrogen atom, a deuterium atom, a nitrogen atom, an oxygen atom, and a sulfur atom, and the third organic compound constituted by atoms selected from the group consisting of a carbon atom, a hydrogen atom, a deuterium atom, a nitrogen atom, a boron atom, a fluorine atom, an oxygen atom, and a sulfur atom. The light emitting layer may include the first organic compound constituted by atoms selected from the group consisting of a carbon atom, a hydrogen atom, a nitrogen atom, and an oxygen atom, the second organic compound constituted by atoms selected from the group consisting of a carbon atom, a hydrogen atom, a deuterium atom, and a nitrogen atom, and the third organic compound constituted by atoms selected from the group consisting of a carbon atom, a hydrogen atom, a deuterium atom, a nitrogen atom, a fluorine atom, and a boron atom.

The light emitting layer may be formed through vapor co-deposition of the first organic compound, the second organic compound, and optionally the third organic compound, or may be formed by a coating method using a solution having the first organic compound, the second organic compound, and optionally the third organic compound dissolved therein. In the formation of the light emitting layer through vapor co-deposition of the first organic compound, the second organic compound, and the third organic compound, it is possible that two or more of the first organic compound, the second organic compound, and the third organic compound are mixed in advance and the placed as a vapor deposition source in a crucible, and the light emitting layer is formed through vapor co-deposition with the vapor deposition source. For example, it is possible that the first organic compound and the second organic compound are mixed in advance to form a single vapor deposition source, and the light emitting layer is formed through vapor co-deposition using the vapor deposition source and the third organic compound as another vapor deposition source.

(Layer Configuration of Organic Light Emitting Device)

For example, the thickness of the light emitting layer may be 5 nm or more, may be 10 nm or more, may be 20 nm or more, or may be 40 nm or more, and may be 80 nm or less, or may be 60 nm or less.

Examples of the organic light emitting device of the present invention include an organic photoluminescent device (organic PL device) and an organic electroluminescent device (organic EL device). The organic photoluminescent device has a structure including a substrate having formed thereon at least a light emitting layer. The organic electroluminescent device has a structure including at least an anode, a cathode, and an organic layer formed between the anode and the cathode. The organic layer includes at least a light emitting layer, may include only a light emitting layer, or may include one or more layer of an organic layer in addition to the light emitting layer. Examples of the organic layer other than the light emitting layer include a hole transporting layer, a hole injection layer, an electron barrier layer, a hole barrier layer, an electron injection layer, an electron transporting layer, and an exciton barrier layer. The hole transporting layer may be a hole injection transporting layer having a hole injection function, and the electron transporting layer may be an electron injection transporting layer having an electron injection function. The present invention has a structure including the light emitting layer laminated on the surface of the base layer on the cathode side. The base layer may also function as an electron barrier layer. A specific example of the structure of the organic electroluminescent device is shown in Fig. 1. In Fig. 1, numeral 1 denotes a substrate, 2 denotes an anode, 3 denotes a hole injection layer, 4 denotes a hole transporting layer, 5 denotes a light emitting layer, 6 denotes an electron transporting layer, and 7 denotes a cathode.

In the case where the organic light emitting device of the present invention is a multi-wavelength emission type organic light emitting device, the light emission of the shortest wavelength may contain delayed fluorescent light, or the light emission of the shortest wavelength may not contain delayed fluorescent light.

In the following, the constituent members and the other layers than the light emitting layer of the organic electroluminescent device are described.

Substrate:

In some embodiments, the organic electroluminescent device of the invention is supported by a substrate, wherein the substrate is not particularly limited and may be any of those that have been commonly used in an organic electroluminescent device, for example those formed of glass, transparent plastics, quartz, and silicon.

Anode

In some embodiments, the anode of the organic electroluminescent device is made of a metal, an alloy, an electroconductive compound, or a combination thereof. In some embodiments, the metal, alloy, or electroconductive compound has a large work function (4 eV or more). In some embodiments, the metal is Au. In some embodiments, the electroconductive transparent material is selected from CuI, indium tin oxide (ITO), $SnO_2$, and ZnO. In some embodiments, an amorphous material capable of forming a transparent electroconductive film, such as IDIXO ($In_2O_3$-ZnO), is be used. In some embodiments, the anode is a thin film. In some embodiments the thin film is made by vapor deposition or sputtering. In some embodiments, the film is patterned by a photolithography method. In some embodiments, where the pattern may not require high accuracy (for example, approximately 100 μm or more), the pattern may be formed with a mask having a desired shape on vapor deposition or sputtering of the electrode material. In some embodiments, when a material can be applied as a coating, such as an organic electroconductive compound, a wet film forming method, such as a printing method and a coating method is used. In some embodiments, when the emitted light goes through the anode, the anode has a transmittance of more than 10%, and the anode has a sheet resistance of several hundred Ohm per square or less. In some embodiments, the thickness of the anode is from 10 to 1,000 nm. In some embodiments, the thickness of the anode is from 10 to 200 nm. In some embodiments, the thickness of the anode varies depending on the material used.

Cathode

In some embodiments, the cathode is made of an electrode material a metal having a small work function (4 eV or less) (referred to as an electron injection metal), an alloy, an electroconductive compound, or a combination thereof. In some embodiments, the electrode material is selected from sodium, a sodium-potassium alloy, magnesium, lithium, a magnesium-cupper mixture, a magnesium-silver mixture, a magnesium-aluminum mixture, a magnesium-indium mixture, an aluminum-aluminum oxide ($Al_2O_3$) mixture, indium, a lithium-aluminum mixture, and a rare earth metal. In some embodiments, a mixture of an electron injection metal and a second metal that is a stable metal having a larger work function than the electron injection metal is used. In some embodiments, the mixture is selected from a magnesium-silver mixture, a magnesium-aluminum mixture, a magnesium-indium mixture, an aluminum-aluminum oxide ($Al_2O_3$) mixture, a lithium-aluminum mixture, and aluminum. In some embodiments, the mixture increases the electron injection property and the durability against oxidation. In some embodiments, the cathode is produced by forming the electrode material into a thin film by vapor deposition or sputtering. In some embodiments, the cathode has a sheet resistance of several hundred Ohm per square or less. In some embodiments, the thickness of the cathode ranges from 10 nm to 5 μm. In some embodiments, the thickness of the cathode ranges from 50 to 200 nm. In some embodiments, for transmitting the emitted light, any one of the anode and the cathode of the organic electroluminescent device is transparent or translucent. In some embodiments, the transparent or translucent electroluminescent devices enhances the light emission luminance.

In some embodiments, the cathode is formed with an electroconductive transparent material, as described for the anode, to form a transparent or translucent cathode. In some embodiments, a device comprises an anode and a cathode, both being transparent or translucent.

Injection Layer

An injection layer is a layer between the electrode and the organic layer. In some embodiments, the injection layer decreases the driving voltage and enhances the light emission luminance. In some embodiments the injection layer includes a hole injection layer and an electron injection layer. The injection layer can be positioned between the anode and the light-emitting layer or the hole transporting layer, and between the cathode and the light-emitting layer or the electron transporting layer. In some embodiments, an injection layer is present. In some embodiments, no injection layer is present.

Preferred compound examples for use as a hole injection material are shown below.

$MoO_3$,

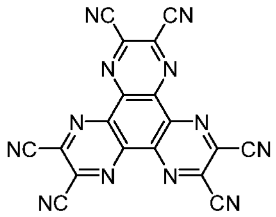
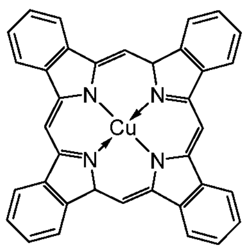
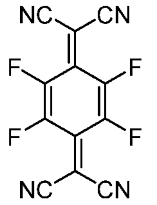
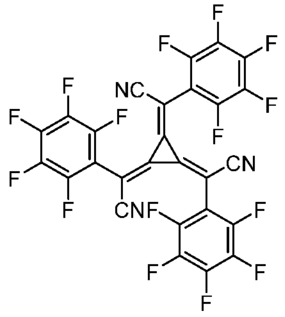

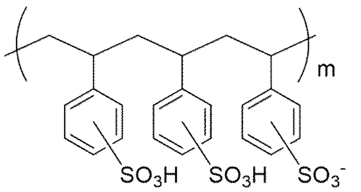
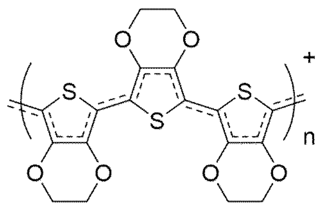

Next, preferred compound examples for use as an electron injection material are shown below.

LiF, CsF, 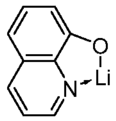

Barrier Layer

A barrier layer is a layer capable of inhibiting charges (electrons or holes) and/or excitons present in the light-emitting layer from being diffused outside the light-emitting layer. In some embodiments, the electron barrier layer is between the light-emitting layer and the hole transporting layer, and inhibits electrons from passing through the light-emitting layer toward the hole transporting layer. In some embodiments, the hole barrier layer is between the light-emitting layer and the electron transporting layer, and inhibits holes from passing through the light-emitting layer toward the electron transporting layer. In some embodiments, the barrier layer inhibits excitons from being diffused outside the light-emitting layer. In some embodiments, the electron barrier layer and the hole barrier layer are exciton barrier layers. As used herein, the term "electron barrier layer" or "exciton barrier layer" includes a layer that has the functions of both electron barrier layer and of an exciton barrier layer.

Hole Barrier Layer

A hole barrier layer acts as an electron transporting layer. In some embodiments, the hole barrier layer inhibits holes from reaching the electron transporting layer while transporting electrons. In some embodiments, the hole barrier layer enhances the recombination probability of electrons and holes in the light-emitting layer. The material for the hole barrier layer may be the same materials as the ones described for the electron transporting layer.

Preferred compound examples for use for the hole barrier layer are shown below.

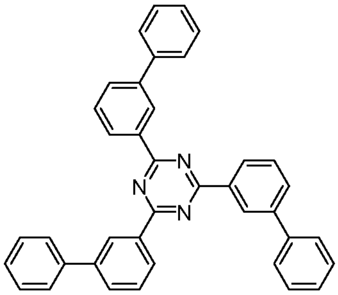

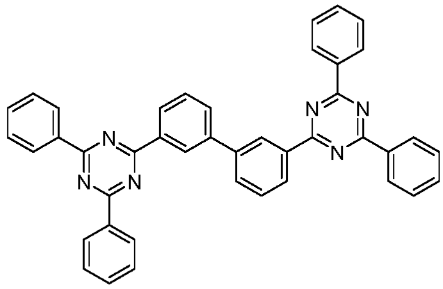

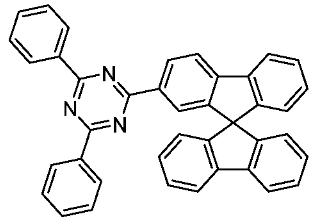

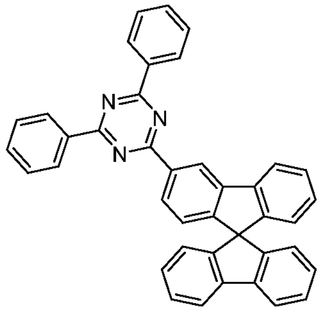

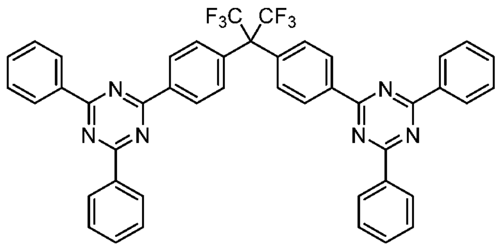

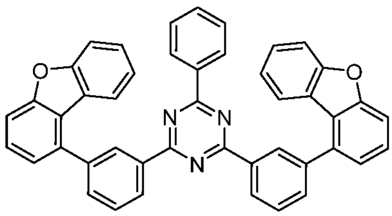

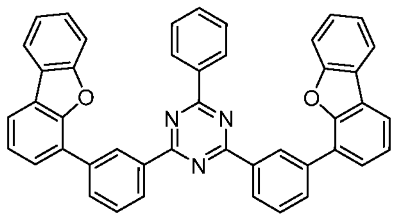

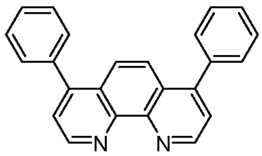

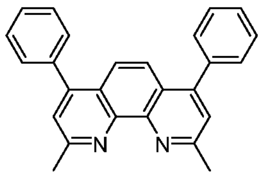

Electron Barrier Layer

As electron barrier layer transports holes. In some embodiments, the electron barrier layer inhibits electrons from reaching the hole transporting layer while transporting holes. In some embodiments, the electron barrier layer enhances the recombination probability of electrons and holes in the light-emitting layer. The material used for the electron barrier layer may be the same materials as the ones mentioned above for the hole transporting layer.

Preferred compound examples for use as the electron barrier material are shown below.

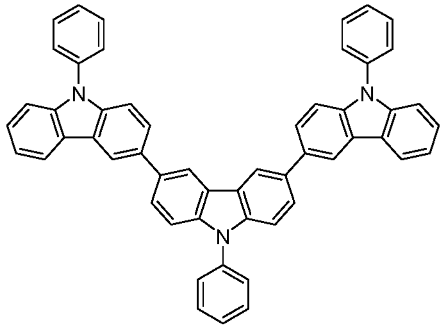
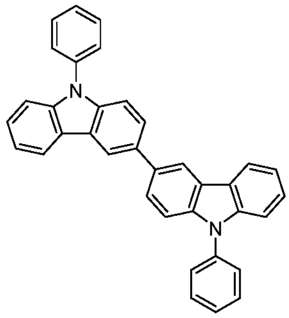
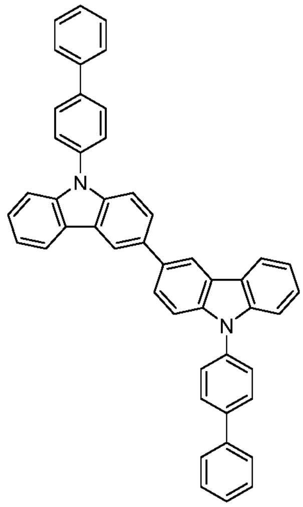
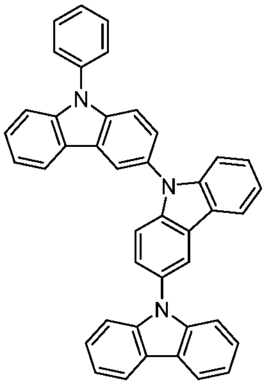
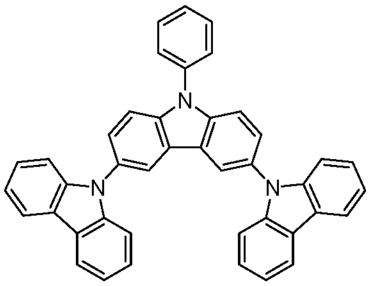
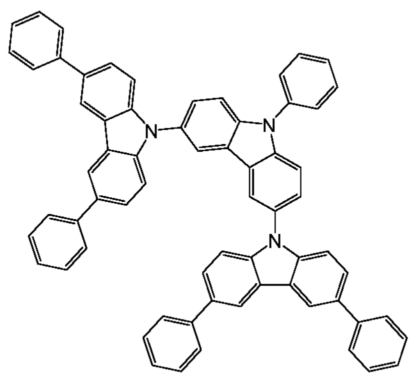
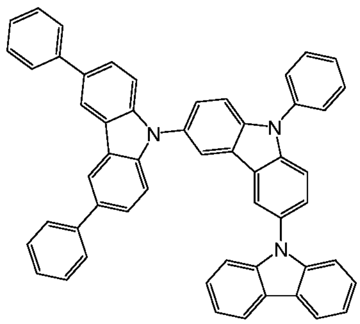
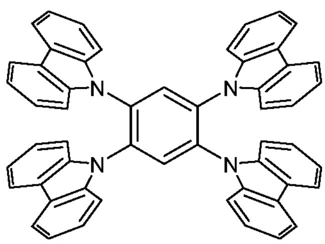
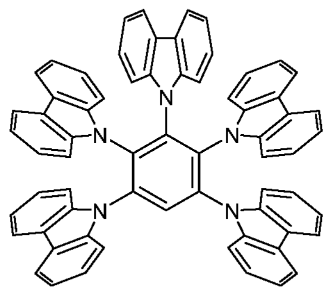

Exciton Barrier Layer

An exciton barrier layer inhibits excitons generated through recombination of holes and electrons in the light-emitting layer from being diffused to the charge transporting layer. In some embodiments, the exciton barrier layer enables effective confinement of excitons in the light-emitting layer. In some embodiments, the light emission efficiency of the device is enhanced. In some embodiments, the exciton barrier layer is adjacent to the light-emitting layer on any of the side of the anode and the side of the cathode, and on both the sides. In some embodiments, where the exciton barrier layer is on the side of the anode, the layer can be between the hole transporting layer and the light-emitting layer and adjacent to the light-emitting layer. In some embodiments, where the exciton barrier layer is on the side of the cathode, the layer can be between the light-emitting layer and the cathode and adjacent to the light-emitting layer. In some embodiments, a hole injection layer, an electron barrier layer, or a similar layer is between the anode and the exciton barrier layer that is adjacent to the light-emitting layer on the side of the anode. In some embodiments, a hole injection layer, an electron barrier layer, a hole barrier layer, or a similar layer is between the cathode and the exciton barrier layer that is adjacent to the light-emitting layer on the side of the cathode. In some embodiments, the exciton

barrier layer comprises excited singlet energy and excited triplet energy, at least one of which is higher than the excited singlet energy and the excited triplet energy of the light-emitting material, respectively.

Hole Transporting Layer

The hole transporting layer comprises a hole transporting material. In some embodiments, the hole transporting layer is a single layer. In some embodiments, the hole transporting layer comprises a plurality layers.

In some embodiments, the hole transporting material has one of injection or transporting property of holes and barrier property of electrons. In some embodiments, the hole transporting material is an organic material. In some embodiments, the hole transporting material is an inorganic material. Examples of known hole transporting materials that may be used herein include but are not limited to a triazole derivative, an oxadiazole derivative, an imidazole derivative, a carbazole derivative, an indolocarbazole derivative, a polyarylalkane derivative, a pyrazoline derivative, a pyrazolone derivative, a phenylenediamine derivative, an arylamine derivative, an amino-substituted chalcone derivative, an oxazole derivative, a styrylanthracene derivative, a fluorenone derivative, a hydrazone derivative, a stilbene derivative, a silazane derivative, an aniline copolymer and an electroconductive polymer oligomer, particularly a thiophene oligomer, or a combination thereof. In some embodiments, the hole transporting material is selected from a porphyrin compound, an aromatic tertiary amine compound, and a styrylamine compound. In some embodiments, the hole transporting material is an aromatic tertiary amine compound. Preferred compound examples for use as the hole transporting material are shown below.

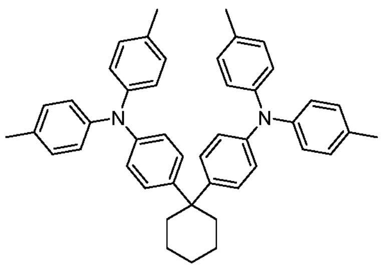

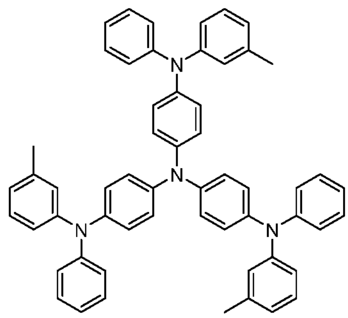

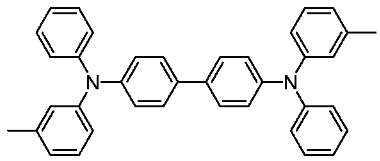

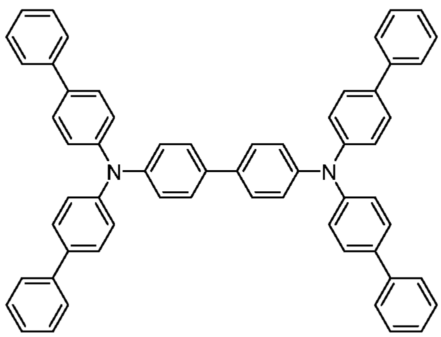

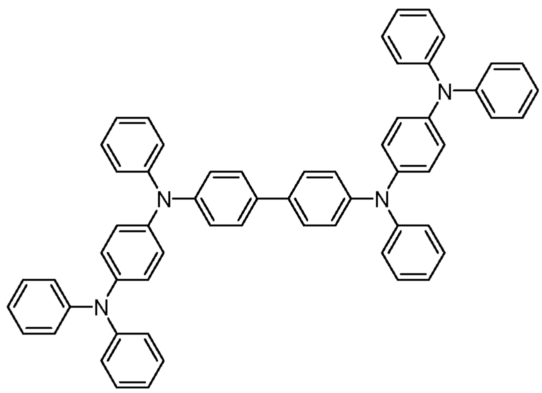

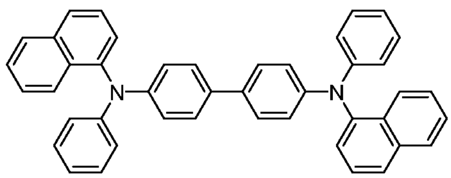

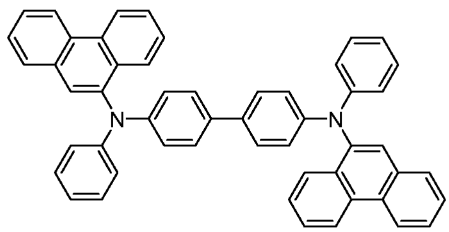

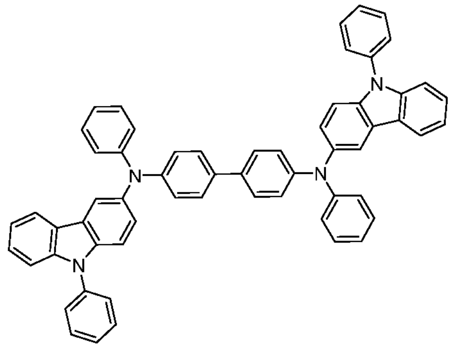
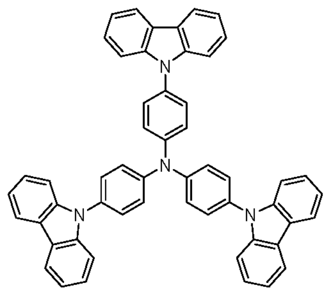
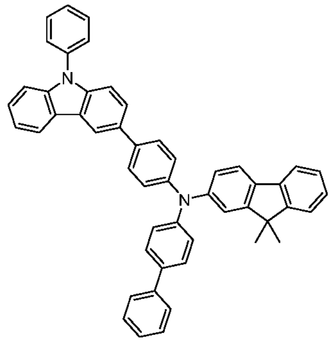

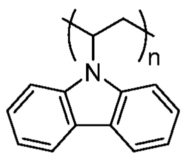
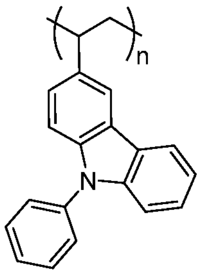
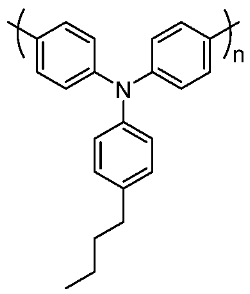

Electron Transporting Layer

The electron transporting layer comprises an electron transporting material. In some embodiments, the electron transporting layer is a single layer. In some embodiments, the electron transporting layer comprises a plurality of layer.

In some embodiments, the electron transporting material needs only to have a function of transporting electrons, which are injected from the cathode, to the light-emitting layer. In some embodiments, the electron transporting material also function as a hole barrier material. Examples of the electron transporting layer that may be used herein include but are not limited to a nitro-substituted fluorene derivative, a diphenylquinone derivative, a thiopyran dioxide derivative, carbodiimide, a fluorenylidene methane derivative, anthraquinodimethane, an anthrone derivatives, an azole derivative, an azine derivative, an oxadiazole derivative, or a combination thereof, or a polymer thereof. In some embodiments, the electron transporting material is a thiadiazole derivative, or a quinoxaline derivative. In some embodiments, the electron transporting material is a polymer material. Preferred compound examples for use as the electron transporting material are shown below.

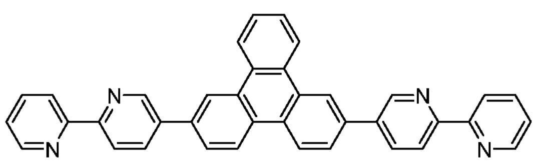
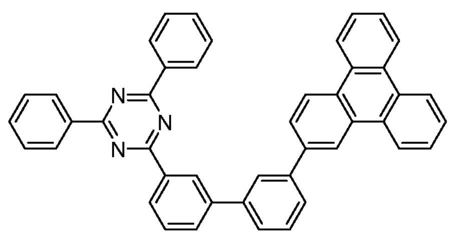

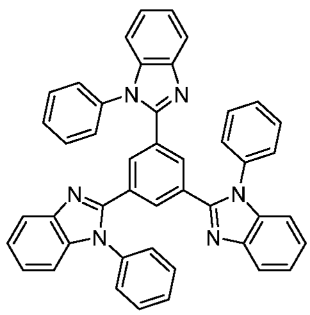
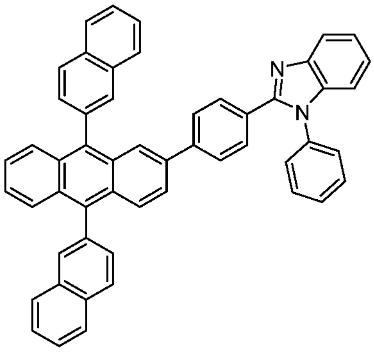
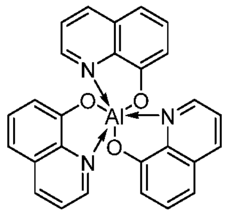

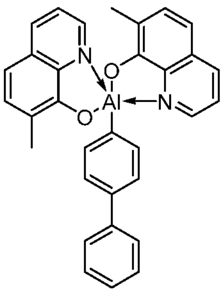
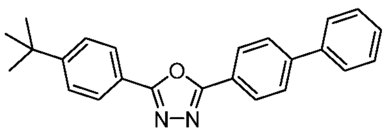
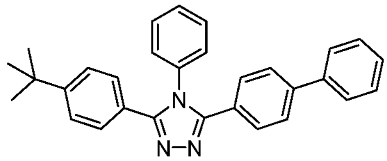

Hereinunder compound examples preferred as a material that can be added to the organic layers are shown. For example, these can be added as a stabilization material.

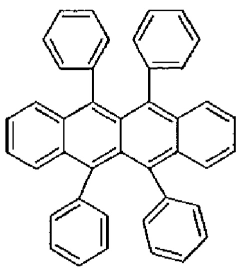
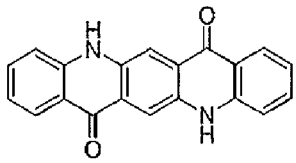
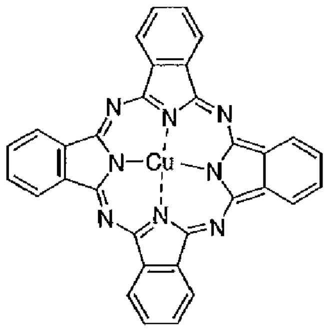

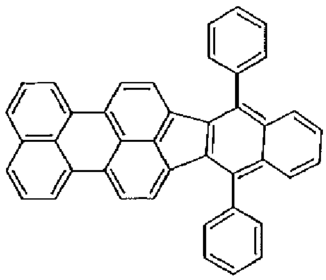
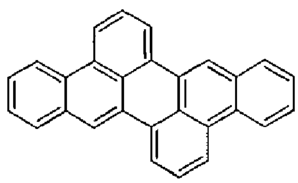

While the preferred materials that can be used in the organic electroluminescent device have been specifically exemplified, the material that can be used in the present invention are not interpreted as being limited by the aforementioned compounds. Evan though a compound is exemplified as a material having a particular function, the compound may be diverted as a material having another function.

Devices

In some embodiments, a light emitting layer is incorporated into a device. For example, the device includes, but is not limited to an OLED bulb, an OLED lamp, a television screen, a computer monitor, a mobile phone, and a tablet.

In some embodiments, an electronic device comprises an OLED comprising an anode, a cathode, and at least one organic layer comprising a light emitting layer between the anode and the cathode.

In some embodiments, compositions described herein may be incorporated into various light-sensitive or light-activated devices, such as a OLEDs or photovoltaic devices. In some embodiments, the composition may be useful in facilitating charge transfer or energy transfer within a device and/or as a hole-transport material. The device may be, for example, an organic light-emitting diode (OLED), an organic integrated circuit (O-IC), an organic field-effect transistor (O-FET), an organic thin-film transistor (O-TFT), an organic light-emitting transistor (O-LET), an organic solar cell (O-SC), an organic optical detector, an organic photoreceptor, an organic field-quench device (O-FQD), a light-emitting electrochemical cell (LEC) or an organic laser diode (O-laser).

Bulbs or Lamps

In some embodiments, an electronic device comprises an OLED comprising an anode, a cathode, and at least one organic layer comprising a light emitting layer between the anode and the cathode.

In some embodiments, a device comprises OLEDs that differ in color. In some embodiments, a device comprises an array comprising a combination of OLEDs. In some embodiments, the combination of OLEDs is a combination of three colors (e.g., RGB). In some embodiments, the combination of OLEDs is a combination of colors that are not red, green, or blue (for example, orange and yellow green). In some embodiments, the combination of OLEDs is a combination of two, four, or more colors.

In some embodiments, a device is an OLED light comprising:

a circuit board having a first side with a mounting surface and an opposing second side, and defining at least one aperture;
at least one OLED on the mounting surface, the at least one OLED configured to emanate light, comprising:
an anode, a cathode, and at least one organic layer comprising a light emitting layer between the anode and the cathode;
a housing for the circuit board; and
at least one connector arranged at an end of the housing, the housing and the connector defining a package adapted for installation in a light fixture.

In some embodiments, the OLED light comprises a plurality of OLEDs mounted on a circuit board such that light emanates in a plurality of directions. In some embodiments, a portion of the light emanated in a first direction is deflected to emanate in a second direction. In some embodiments, a reflector is used to deflect the light emanated in a first direction.

Displays or Screens

In some embodiments, the compounds of the invention can be used in a screen or a display. In some embodiments, the compounds of the invention are deposited onto a substrate using a process including, but not limited to, vacuum evaporation, deposition, vapor deposition, or chemical vapor deposition (CVD). In some embodiments, the substrate is a photoplate structure useful in a two-sided etch provides a unique aspect ratio pixel. The screen (which may also be referred to as a mask) is used in a process in the manufacturing of OLED displays. The corresponding artwork pattern design facilitates a very steep and narrow tie-bar between the pixels in the vertical direction and a large, sweeping bevel opening in the horizontal direction. This allows the close patterning of pixels needed for high definition displays while optimizing the chemical deposition onto a TFT backplane.

The internal patterning of the pixel allows the construction of a 3-dimensional pixel opening with varying aspect ratios in the horizontal and vertical directions. Additionally, the use of imaged "stripes" or halftone circles within the pixel area inhibits etching in specific areas until these specific patterns are undercut and fall off the substrate. At that point the entire pixel area is subjected to a similar etch rate but the depths are varying depending on the halftone pattern. Varying the size and spacing of the halftone pattern allows etching to be inhibited at different protection rates within the pixel allowing for a localized deeper etch needed to create steep vertical bevels.

A preferred material for the deposition mask is invar. Invar is a metal alloy that is cold rolled into long thin sheet in a steel mill. Invar cannot be electrodeposited onto a rotating mandrel as the nickel mask. A preferred and more cost feasible method for forming the open areas in the mask used for deposition is through a wet chemical etching.

In some embodiments, a screen or display pattern is a pixel matrix on a substrate. In some embodiments, a screen or display pattern is fabricated using lithography (e.g., photolithography and e-beam lithography). In some embodiments, a screen or display pattern is fabricated using a wet chemical etch. In further embodiments, a screen or display pattern is fabricated using plasma etching.

Methods of Manufacturing Devices Using the Disclosed Compounds

An OLED display is generally manufactured by forming a large mother panel and then cutting the mother panel in units of cell panels. In general, each of the cell panels on the mother panel is formed by forming a thin film transistor (TFT) including an active layer and a source/drain electrode on a base substrate, applying a planarization film to the TFT, and sequentially forming a pixel electrode, a light-emitting layer, a counter electrode, and an encapsulation layer, and then is cut from the mother panel.

An OLED display is generally manufactured by forming a large mother panel and then cutting the mother panel in units of cell panels. In general, each of the cell panels on the mother panel is formed by forming a thin film transistor (TFT) including an active layer and a source/drain electrode on a base substrate, applying a planarization film to the TFT, and sequentially forming a pixel electrode, a light-emitting layer, a counter electrode, and an encapsulation layer, and then is cut from the mother panel.

In another aspect, provided herein is a method of manufacturing an organic light-emitting diode (OLED) display, the method comprising:

forming a barrier layer on a base substrate of a mother panel;
forming a plurality of display units in units of cell panels on the barrier layer;
forming an encapsulation layer on each of the display units of the cell panels;
applying an organic film to an interface portion between the cell panels.

In some embodiments, the barrier layer is an inorganic film formed of, for example, SiNx, and an edge portion of the barrier layer is covered with an organic film formed of polyimide or acryl. In some embodiments, the organic film helps the mother panel to be softly cut in units of the cell panel.

In some embodiments, the thin film transistor (TFT) layer includes a light-emitting layer, a gate electrode, and a source/drain electrode. Each of the plurality of display units may include a thin film transistor (TFT) layer, a planarization film formed on the TFT layer, and a light-emitting unit formed on the planarization film, wherein the organic film applied to the interface portion is formed of a same material as a material of the planarization film and is formed at a same time as the planarization film is formed. In some embodiments, a light-emitting unit is connected to the TFT layer with a passivation layer and a planarization film therebetween and an encapsulation layer that covers and protects the light-emitting unit. In some embodiments of the method of manufacturing, the organic film contacts neither the display units nor the encapsulation layer.

Each of the organic film and the planarization film may include any one of polyimide and acryl. In some embodiments, the barrier layer may be an inorganic film. In some embodiments, the base substrate may be formed of polyimide. The method may further include, before the forming of the barrier layer on one surface of the base substrate formed of polyimide, attaching a carrier substrate formed of a glass material to another surface of the base substrate, and before the cutting along the interface portion, separating the carrier substrate from the base substrate. In some embodiments, the OLED display is a flexible display.

In some embodiments, the passivation layer is an organic film disposed on the TFT layer to cover the TFT layer. In some embodiments, the planarization film is an organic film formed on the passivation layer. In some embodiments, the planarization film is formed of polyimide or acryl, like the organic film formed on the edge portion of the barrier layer. In some embodiments, the planarization film and the organic film are simultaneously formed when the OLED display is manufactured. In some embodiments, the organic film may be formed on the edge portion of the barrier layer such that a portion of the organic film directly contacts the base substrate and a remaining portion of the organic film contacts the barrier layer while surrounding the edge portion of the barrier layer.

In some embodiments, the light-emitting layer includes a pixel electrode, a counter electrode, and an organic light-emitting layer disposed between the pixel electrode and the counter electrode. In some embodiments, the pixel electrode is connected to the source/drain electrode of the TFT layer.

In some embodiments, when a voltage is applied to the pixel electrode through the TFT layer, an appropriate voltage is formed between the pixel electrode and the counter electrode, and thus the organic light-emitting layer emits light, thereby forming an image. Hereinafter, an image forming unit including the TFT layer and the light-emitting unit is referred to as a display unit.

In some embodiments, the encapsulation layer that covers the display unit and prevents penetration of external moisture may be formed to have a thin film encapsulation structure in which an organic film and an inorganic film are alternately stacked. In some embodiments, the encapsulation layer has a thin film encapsulation structure in which a plurality of thin films are stacked. In some embodiments, the organic film applied to the interface portion is spaced apart from each of the plurality of display units. In some embodiments, the organic film is formed such that a portion of the organic film directly contacts the base substrate and a remaining portion of the organic film contacts the barrier layer while surrounding an edge portion of the barrier layer.

In one embodiment, the OLED display is flexible and uses the soft base substrate formed of polyimide. In some embodiments, the base substrate is formed on a carrier substrate formed of a glass material, and then the carrier substrate is separated.

In some embodiments, the barrier layer is formed on a surface of the base substrate opposite to the carrier substrate. In one embodiment, the barrier layer is patterned according to a size of each of the cell panels. For example, while the base substrate is formed over the entire surface of a mother panel, the barrier layer is formed according to a size of each of the cell panels, and thus a groove is formed at an interface portion between the barrier layers of the cell panels. Each of the cell panels can be cut along the groove.

In some embodiments, the method of manufacture further comprises cutting along the interface portion, wherein a groove is formed in the barrier layer, wherein at least a portion of the organic film is formed in the groove, and wherein the groove does not penetrate into the base substrate. In some embodiments, the TFT layer of each of the cell panels is formed, and the passivation layer which is an inorganic film and the planarization film which is an organic film are disposed on the TFT layer to cover the TFT layer. At the same time as the planarization film formed of, for example, polyimide or acryl is formed, the groove at the interface portion is covered with the organic film formed of, for example, polyimide or acryl. This is to prevent cracks from occurring by allowing the organic film to absorb an impact generated when each of the cell panels is cut along the groove at the interface portion. That is, if the entire barrier layer is entirely exposed without the organic film, an impact generated when each of the cell panels is cut along the groove at the interface portion is transferred to the barrier layer, thereby increasing the risk of cracks. However, in one embodiment, since the groove at the interface portion between the barrier layers is covered with the organic film and the organic film absorbs an impact that would otherwise be transferred to the barrier layer, each of the cell panels may be softly cut and cracks may be prevented from occurring in the barrier layer. In one embodiment, the organic film covering the groove at the interface portion and the planarization film are spaced apart from each other. For example, if the organic film and the planarization film are connected to each other as one layer, since external moisture may penetrate into the display unit through the planarization film and a portion where the organic film remains, the organic film and the planarization film are spaced apart from each other such that the organic film is spaced apart from the display unit.

In some embodiments, the display unit is formed by forming the light-emitting unit, and the encapsulation layer is disposed on the display unit to cover the display unit. As such, once the mother panel is completely manufactured, the carrier substrate that supports the base substrate is separated from the base substrate. In some embodiments, when a laser beam is emitted toward the carrier substrate, the carrier substrate is separated from the base substrate due to a difference in a thermal expansion coefficient between the carrier substrate and the base substrate.

In some embodiments, the mother panel is cut in units of the cell panels. In some embodiments, the mother panel is cut along an interface portion between the cell panels by using a cutter. In some embodiments, since the groove at the interface portion along which the mother panel is cut is covered with the organic film, the organic film absorbs an impact during the cutting. In some embodiments, cracks may be prevented from occurring in the barrier layer during the cutting.

In some embodiments, the methods reduce a defect rate of a product and stabilize its quality.

Another aspect is an OLED display including: a barrier layer that is formed on a base substrate; a display unit that is formed on the barrier layer; an encapsulation layer that is formed on the display unit; and an organic film that is applied to an edge portion of the barrier layer.

(Method for Designing Organic Light Emitting Device)

The present invention also provides a method for designing an organic light emitting device. The method for designing an organic light emitting device of the present invention is a method for designing an organic light emitting device having a light emitting layer containing the first organic compound, the second organic compound, and the third organic compound that satisfy the relationship of the expression (a), and the optional component. According to the designing method of the present invention, a delayed fluorescent material to be the second organic compound can be appropriately selected to form a light emitting layer having a high orientation.

In designing, firstly, the first organic compound, the third organic compound, and the optional component are selected (see S 1 in Fig. 2). The optional component herein is a component that does not correspond to any of the first organic compound, third organic compound, and the delayed fluorescent material. For example, a compound that has been confirmed to have good light emission characteristics or a compound that is predicted to have good light emission characteristics is selected as the third organic compound, and a host material that is considered to have good compatibility with the compound is selected as the first organic compound. The optional component is arbitrarily determined, or the optional component may not be used. In designing, the concentrations of the compounds contained in the light emitting layer are determined.

Subsequently, a thin film is formed by using the delayed fluorescent material as a candidate of the second organic compound along with the first organic compound and the optional component selected above, and is designated

as a delayed layer T. At this time, the concentration of the delayed fluorescent material is the same concentration of the second organic compound contained in the light emitting layer to be designed. The delayed layer T is measured for S(1,2). In the case where multiple delayed fluorescent materials exist as a candidate of the second organic compound, delayed layers are formed for the delayed fluorescent materials respectively, and each are measured for S(1,2) (S3, S4, and S2). In the designing method of the present invention, the delayed fluorescent material is evaluated using S(1,2) as an index, and a delayed fluorescent material that is useful as the second organic compound is selected. In selecting, for example, it is considered that the selection is performed in such a manner that a delayed fluorescent material that satisfies the expression (b) is evaluated to have high usefulness, or a delayed fluorescent material having small S(1,2) is evaluated to have high usefulness. The delayed fluorescent material thus selected is used as the second organic compound, with which the light emitting layer is designed by using the first organic compound, the third organic compound, and the optional component having been selected (S5). The configuration of the organic light emitting device other than the light emitting layer is then designed (S6), and thus the organic light emitting device including the light emitting layer can be designed.

In evaluating the delayed fluorescent material using S(1,2) as an index, S(1,3) may also be considered. Specifically, a thin film is formed by using the first organic compound, the third organic compound, and the optional component having been selected, and is designated as a fluorescent layer F. In this case, what is simple is that the concentration of the third organic compound is 6% by weight, but the concentration thereof may be less than 6% by weight as described above. The fluorescent layer F is measured for S(1,3), and the delayed fluorescent material is evaluated by comparing S(1,2) and S(1,3). For example, the evaluation can be performed by the fact that S(1,2) is smaller than S(1,3), or by the fact that S(1,2) is smaller than S(1,3) by a particular value or more. For example, the particular value may be set to 0.10 or 0.20. The evaluation can be performed in consideration of other factors than the comparison between S(1,2) and S(1,3).

A database built by accumulating the data of correspondence relationship of the delayed fluorescent materials and S(1,2) enables quick selection of the delayed fluorescent material that is suitable as the second organic compound, based on the value of S(1,2). The tendency in the relationship between the structure of the delayed fluorescent material and S(1,2) can be analyzed by using the database, and can be used for designing a novel delayed fluorescent material. A program performing the designing method of the present invention that is allowed to access the database enables the design of a light emitting device with higher efficiency.

The techniques described above can be appropriately modified as necessary.

## Examples

The present invention will be described more specifically with reference to examples below. The materials, the contents of the process, the procedures of the process, and the like shown below can be appropriately modified unless deviating from the substance of the present invention. Therefore, the scope of the present invention should not be interpreted as being limited by the specific examples shown below. The light emission capabilities were evaluated by using a source meter (2400 Series, available from Keithley, Tektronix, Inc.), a semiconductor parameter analyzer (E5273A, available from Agilent Technologies, Inc.), an optical power meter (1930C, available from Newport Corporation), an optical spectrometer (USB2000, available from Ocean Optics, Inc.), a spectroradiometer (SR-3, available from Topcon Corporation), and a streak camera (Model C4334, available from Hamamatsu Photonics K.K.). The first organic compounds, the second organic compounds, and the third organic compounds contained in the thin films shown in Tables 1 to 3 and the light emitting layer of Example 4 have lowest excited singlet energy satisfying the relationship of the expression (a).

### (Example 1)

On a quartz substrate, two or three of the first organic compound, the second organic compound, and the third organic compound were vapor-deposited each from separate vapor deposition sources by the vacuum vapor deposition method under condition of a vacuum degree of less than $1 \times 10^{-3}$ Pa, so as to form doped thin films having the compositions shown in Table 1. In Table 1, the film formed of the first organic compound and the third organic compound is referred to as a fluorescent layer F, the film formed of the first organic compound and the second organic compound is referred to as a delayed layer T, and the layer formed of the first organic compound, the second organic compound, and the third organic compound is referred to as a light emitting layer E.

The results of the measurement of the S values of the thin films thus formed are shown in Table 1. Assuming that the S value of the fluorescent layer F is S(1,3), the S value of the delayed layer T is S(1,2), and the S value of the light emitting layer E is S(1,2,3), the values of S(1,2)-S(1,3) and S(1,2,3)-S(1,3) are calculated and shown in Table 1. The layers in Table 1 are classified into Red, Green, and Blue based on the light emission color of the light emitting layer E.

Table 1

| | | First organic compound | | Second organic compound | | Third organic compound | | S value | S (1,2)-S (1,3) | S (1,2,3)-S (1,3) |
|---|---|---|---|---|---|---|---|---|---|---|
| | | Compound | Concentration (% by weight) | Compound | Concentration (% by weight) | Compound | Concentration (% by weight) | | | |
| Red 1 | Fluorescent layer F1 | H1 | 99.5 | - | - | F2 | 0.5 | -0.25 | | |
| | Delayed layer T1a | H1 | 60.0 | T8 | 40.0 | - | - | -0.35 | -0.10 | |
| | Light emitting layer E1a (invention) | H1 | 59.5 | T8 | 40.0 | F2 | 0.5 | -0.39 | | -0.14 |
| | Delayed layer T1b | H1 | 60.0 | T60 | 40.0 | - | - | -0.49 | -0.24 | |
| | Light emitting layer E1b (invention) | H1 | 59.5 | T60 | 40.0 | F2 | 0.5 | -0.44 | | -0.19 |
| Green 1 | Fluorescent layer F2 | H1 | 99.5 | - | - | F3 | 0.5 | 0.13 | | |
| | Delayed layer T2a | H1 | 55.0 | T4 | 45.0 | - | - | -0.32 | -0.45 | |
| | Light emitting layer E2a (invention) | H1 | 54.5 | T4 | 45.0 | F3 | 0.5 | 0.03 | | -0.10 |
| | Delayed layer T2b | H1 | 65.0 | T7 | 35.0 | - | - | -0.36 | -0.49 | |
| | Light emitting layer E2b (invention) | H1 | 64.5 | T7 | 35.0 | F3 | 0.5 | -0.11 | | -0.24 |
| Blue 1 | Fluorescent layer F3 | H1 | 94.0 | - | - | F4 | 6.0 | 0 | | |
| | Light emitting layer E3a (invention) | H1 | 69.5 | T1 | 30.0 | F4 | 0.5 | -045. | | -0.45 |
| | Light emitting layer E3b (invention) | H1 | 68.0 | T1 | 30.0 | F4 | 2.0 | -0.41 | | -0.41 |
| | Light emitting layer E3c (invention) | H1 | 64.0 | T1 | 30.0 | F4 | 6.0 | -0.36 | | -0.36 |
| Blue 2 | Fluorescent layer F4 | H1 | 94.0 | - | - | F5 | 6.0 | 0.23 | | |
| | Light emitting layer E4a (invention) | H1 | 69.5 | T1 | 30.0 | F5 | 0.5 | -0.27 | | -0.50 |
| | Light emitting layer E4b (invention) | H1 | 68.0 | T1 | 30.0 | F5 | 2.0 | -0.11 | | -0.34 |

(continued)

| | | First organic compound | | Second organic compound | | Third organic compound | | S value | S (1,2)-S (1,3) | S (1,2,3)-S (1,3) |
|---|---|---|---|---|---|---|---|---|---|---|
| | | Compound | Concentration (% by weight) | Compound | Concentration (% by weight) | Compound | Concentration (% by weight) | | | |
| Blue 3 | Fluorescent layer F5 | H1 | 94.0 | - | - | F7 | 6.0 | -0.44 | | |
| | Delayed layer T5a | H1 | 70.0 | T6 | 30.0 | - | - | 0.05 | 0.49 | |
| | Light emitting layer E5a (comparison) | H1 | 69.5 | T6 | 20.0 | F7 | 0.5 | 0.17 | | 0.61 |
| | Delayed layer T5b | H1 | 80.0 | T2 | 30.0 | - | - | -0.01 | 0.45 | |
| | Light emitting layer E5b (comparison) | H1 | 69.5 | T2 | 30.0 | F7 | 0.5 | -0.11 | | 0.33 |

The results of Red 1, Green 1, Blue 1, and Blue 2 in Table 1 show that in the case where S(1,2) of the delayed layer T is smaller than S(1,3) of the fluorescent layer F, the formation of the light emitting layer E using the delayed fluorescent material contained in the delayed layer T as the second organic compound can enhance the orientation of the light emitting layer E. In other words, in the case where S(1,2) of the delayed layer T is smaller than S(1,3) of the fluorescent layer F, a light emitting layer having a high orientation (i.e., a small S value) can be provided by using the delayed fluorescent material contained in the delayed layer T as the second organic compound, and forming the light emitting layer with the first organic compound and the third organic compound contained in the fluorescent layer F.

The results of Blue 3 in Table 1 show that in the case where S(1,2) of the delayed layer T is larger than S(1,3) of the fluorescent layer F, the formation of the light emitting layer E using the delayed fluorescent material contained in the delayed layer T as the second organic compound lowers the orientation of the light emitting layer E.

These results show that the formation of the light emitting layer E by using the delayed fluorescent material contained in the delayed layer T having small S(1,2) can allow the orientation of the light emitting layer E to be higher than the fluorescent layer F.

The measurement of photoluminescence quantum yields (PLQY) of the light emitting layer E1a, the light emitting layer E2a, and the light emitting layer E2b in Table 1 revealed that the photoluminescence quantum yields were as high as 81% for the light emitting layer E1a, 72% for the light emitting layer E2a, and 78% for the light emitting layer E2b. The comparison of the light emitting layer E2a and the light emitting layer E2b using the same third organic compound (fluorescent material) showed that the light emitting layer E2b having a higher orientation (i.e., a smaller S value) had a higher photoluminescence quantum yield.

(Example 2)

In Example 2, light emitting layers having a high orientation were formed by using the third organic compound of Blue 3 in Table 1.

On a quartz substrate, two or three of the first organic compound, the second organic compound, and the third organic compound were vapor-deposited each from separate vapor deposition sources by the vacuum vapor deposition method under condition of a vacuum degree of less than $1 \times 10^{-3}$ Pa, so as to form doped thin films having the compositions shown in Table 2. The results of the measurement of the S values of the thin films thus formed are shown in Table 2.

Table 2

| | | First organic compound | | Second organic compound | | Third organic compound | | S value |
|---|---|---|---|---|---|---|---|---|
| | | Compound | Concentration (% by weight) | Compound | Concentration (% by weight) | Compound | Concentration (% by weight) | |
| Blue 4 | Delayed layer T6a | mCBP | 70.0 | T1 | 30.0 | - | - | -0.38 |
| | Lightemittinglayer E6a | mCBP | 69.5 | T1 | 30.0 | F7 | 0.5 | -0.44 |
| | Delayed layer T6b | mCBP | 70.0 | T3 | 30.0 | - | - | -0.50 |
| | Lightemittinglayer E6b | mCBP | 69.5 | T3 | 30.0 | F7 | 0.5 | -0.49 |
| | Delayed layer T6c | mCBP | 70.0 | T5 | 30.0 | - | - | -0.29 |
| | Lightemittinglayer E6c | mCBP | 69.5 | T5 | 30.0 | F7 | 0.5 | -0.45 |

The results in Table 2 show that even in the light emitting layer using the same third organic compound as Blue 3, the use of the delayed fluorescent material of the delayed layer T having small S(1,2) as the second organic compound enables the formation of the light emitting layer E having sufficiently small S(1,2,3) and a high orientation.

(Example 3)

In Example 3, a light emitting layer (light emitting layer E7a) having a high orientation was formed by using a different first organic compound from Examples 1 and 2. Doped thin films having the compositions shown in Table 3 were formed and measured for the S value in the same manner as in Examples 1 and 2. As shown in Table 3, even in the case where the different first organic compound is used, the use of the delayed fluorescent material of the delayed layer T having small S(1,2) as the second organic compound enables the formation of the light emitting layer E having sufficiently small S(1,2,3) and a high orientation.

In Example 3, furthermore, a light emitting layer E8a was formed by changing the first organic compound and the third organic compound as shown in Table 3. It was confirmed that the light emitting layer E8a had a high orientation.

Table 3

| | | First organic compound | | Second organic compound | | Third organic compound | | S value |
|---|---|---|---|---|---|---|---|---|
| | | Compound | Concentration (% by weight) | Compound | Concentration (% by weight) | Compound | Concentration (% by weight) | |
| Red 2 | Delayed layer T7a | H27 | 60.0 | T8 | 40.0 | - | - | -0.38 |
| | Light emitting layer E7a | H27 | 59.5 | T8 | 40.0 | F2 | 0.5 | -0.45 |
| | Light emitting layer E7b | H1 | 59.5 | T8 | 40.0 | F1 | 0.5 | -0.38 |

(Example 4)

In Example 4, organic electroluminescent devices were produced and evaluated.

Thin films were laminated by the vacuum vapor deposition method at a vacuum degree of $1 \times 10^{-6}$ Pa on a glass substrate having formed thereon an anode formed of indium tin oxide (ITO) having a thickness of 100 nm. HATCN was formed on ITO to a thickness of 5 nm, and NPD was formed thereon to a thickness of 85 nm. Subsequently, EB1 was formed thereon to a thickness of 10 nm, and further thereon, H1 (39.5% by weight) and H41 (20.0% by weight) as the first organic compound, T8 (40.0% by weight) as the second organic compound, and F2 (0.5% by weight) as the third organic compound were vapor-co-deposited from separate vapor deposition sources to form a light emitting layer having a thickness of 40 nm. HB1 was further formed thereon to a thickness of 10 nm, and further thereon, ET1 was formed to a thickness of 35 nm. Furthermore, Liq was formed to a thickness of 2 nm, and then aluminum (Al) was vapor deposited to a thickness of 100 nm to form a cathode. An organic electroluminescent device of the present invention was produced according to the aforementioned procedures.

The measurement of the external quantum efficiency (EQE) of the organic electroluminescent device revealed that the external quantum efficiency thereof was as high as 14.1%.

For comparison, an organic electroluminescent device was produced in the same manner as in Example 4 except that the light emitting layer was formed with H1 (40.0% by weight) and H41 (20.0% by weight) as the first organic compound and T8 (40.0% by weight) as the second organic compound. The measurement of the external quantum efficiency (EQE) of the comparative device revealed that the external quantum efficiency thereof was 4.8%.

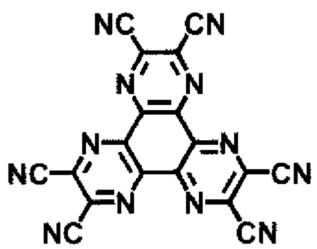
HATCN

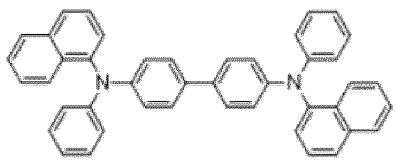
NPD

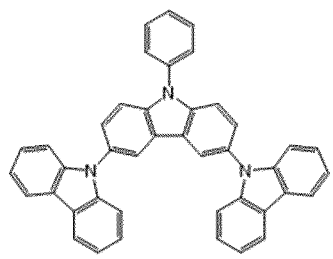
EB1

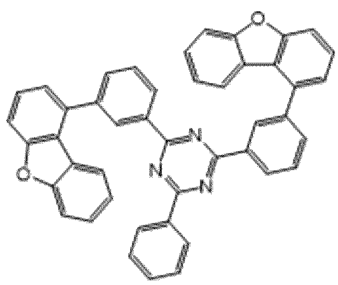
HB1

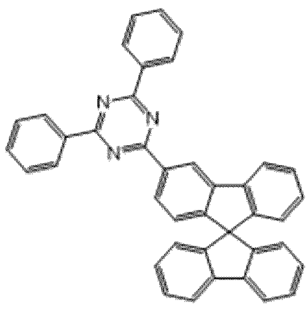
ET1

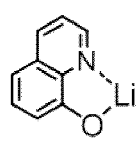
Liq

Industrial Applicability

The present invention can provide an organic light emitting device containing a light emitting material having a high orientation in a light emitting layer containing a delayed fluorescent material. The use of the designing method, the program, or the database of the present invention enables the convenient design of an organic light emitting device having a light emitting layer having a high orientation. For this reason, the present invention has high industrial applicability.

Reference Sign List

1: Substrate

2: Anode
3: Hole injection layer
4: Hole transporting layer
5: Light emitting layer
6: Electron transporting layer
7: Cathode

**Claims**

1. An organic light emitting device comprising a light emitting layer containing a first organic compound, a second organic compound, a third organic compound, and an optional component,

the second organic compound being a delayed fluorescent material,
the organic light emitting device satisfying the relationship of the following expression (a) and expression (b):

$$E_{S1}(1) > E_{S1}(2) > E_{S1}(3) \qquad (a)$$

$$S(1,2,3) < S(1,3) \qquad (b)$$

wherein

$E_{S1}(1)$ represents lowest excited singlet energy of the first organic compound,
$E_{S1}(2)$ represents lowest excited singlet energy of the second organic compound,
$E_{S1}(3)$ represents lowest excited singlet energy of the third organic compound,
S(1,2,3) represents an S value of the light emitting layer, and
S(1,3) represents an S value of a layer obtained by replacing the light emitting layer by a layer containing the first organic compound, the third organic compound, and the optional component.

2. The organic light emitting device according to claim 1, wherein S(1,2,3) is smaller than S(1,3) by 0.03 or more.

3. The organic light emitting device according to claim 1, wherein S(1,2,3) is smaller than S(1,3) by 0.05 or more.

4. The organic light emitting device according to any one of claims 1 to 3, wherein the organic light emitting device satisfies the relationship of the following expression (c):

$$S(1,2) < S(1,3) \qquad (c)$$

wherein

S(1,2) represents an S value of a layer obtained by replacing the light emitting layer by a layer containing the first organic compound, the second organic compound, and the optional component, and
S(1,3) represents an S value of a layer obtained by replacing the light emitting layer by a layer containing the first organic compound, the third organic compound, and the optional component.

5. The organic light emitting device according to any one of claims 1 to 4, wherein S(1,2) is -0.25 or less.

6. The organic light emitting device according to any one of claims 1 to 5, wherein the light emitting layer has a concentration of the third organic compound of 6% by weight or less.

7. The organic light emitting device according to any one of claims 1 to 6, wherein the third organic compound is a compound having a multiple resonance effect of a boron atom and a nitrogen atom.

8. The organic light emitting device according to any one of claims 1 to 6, wherein the third organic compound is a compound including a 4,4-difluoro-4-bora-3a,4a-diaza-s-indacene structure.

**9.** The organic light emitting device according to any one of claims 1 to 8, wherein the second organic compound is a compound including a structure including a benzene ring having an acceptor group containing a nitrogen-containing heteroaryl group or a cyano group and a donor group containing a diarylamino group in which two aryl groups constituting the diarylamino group may be bonded to each other, that are bonded to the benzene ring.

**10.** The organic light emitting device according to any one of claims 1 to 9, wherein the first organic compound is a compound including two or more structures selected from the group consisting of a carbazole ring, a dibenzofuran ring, and a dibenzothiophene ring.

**11.** The organic light emitting device according to any one of claims 1 to 10, wherein the organic light emitting device is an organic electroluminescent device.

**12.** A method for designing an organic light emitting device including a light emitting layer containing a first organic compound, a second organic compound, and a third organic compound that satisfy the relationship of the following expression (a), and an optional component,
the method comprising examining and selecting a delayed fluorescent material as a candidate of the second organic compound using S(1,3) as an index and S(1,2,3) as a reference:

$$E_{S1}(1) > E_{S1}(2) > E_{S1}(3) \qquad (a)$$

wherein

$E_{S1}(1)$ represents lowest excited singlet energy of the first organic compound,
$E_{S1}(2)$ represents lowest excited singlet energy of the second organic compound,
$E_{S1}(3)$ represents lowest excited singlet energy of the third organic compound,
S(1,2,3) represents an S value of a layer containing the first organic compound, the delayed fluorescent material examined as a candidate, the third organic compound, and the optional component, as the light emitting layer, and
S(1,3) represents an S value of a layer containing the first organic compound, the third organic compound, and the optional component, as the light emitting layer.

**13.** The designing method according to claim 12, wherein the designing method includes examining and selecting a delayed fluorescent material that satisfies the relationship of the following expression (c) as a candidate of the second organic compound:

$$S(1,2) < S(1,3) \qquad (c)$$

wherein

S(1,2) represents an S value of a layer containing the first organic compound, the delayed fluorescent material examined as a candidate, and the optional component, as the light emitting layer, and
S(1,3) represents an S value of a layer containing the first organic compound, the third organic compound, and the optional component, as the light emitting layer.

**14.** A program comprising instructions for performing the method according to claim 12 or 13.

**15.** A database comprising data of the relationship between the delayed fluorescent material and S(1,2,3) in claim 12.

**16.** The database according to claim 15, wherein the database further comprises data of S(1,2).

FIG. 1

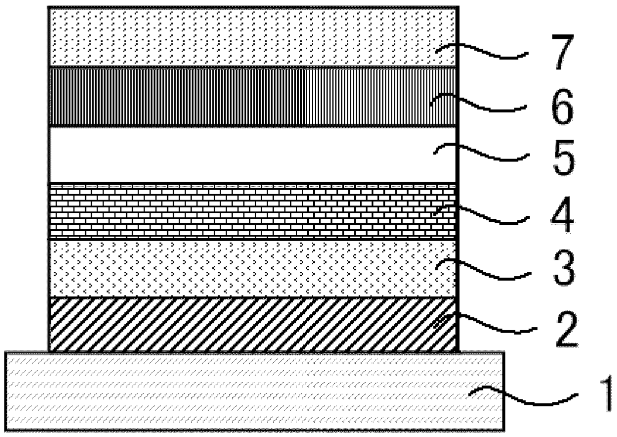
7
6
5
4
3
2
1

FIG. 2

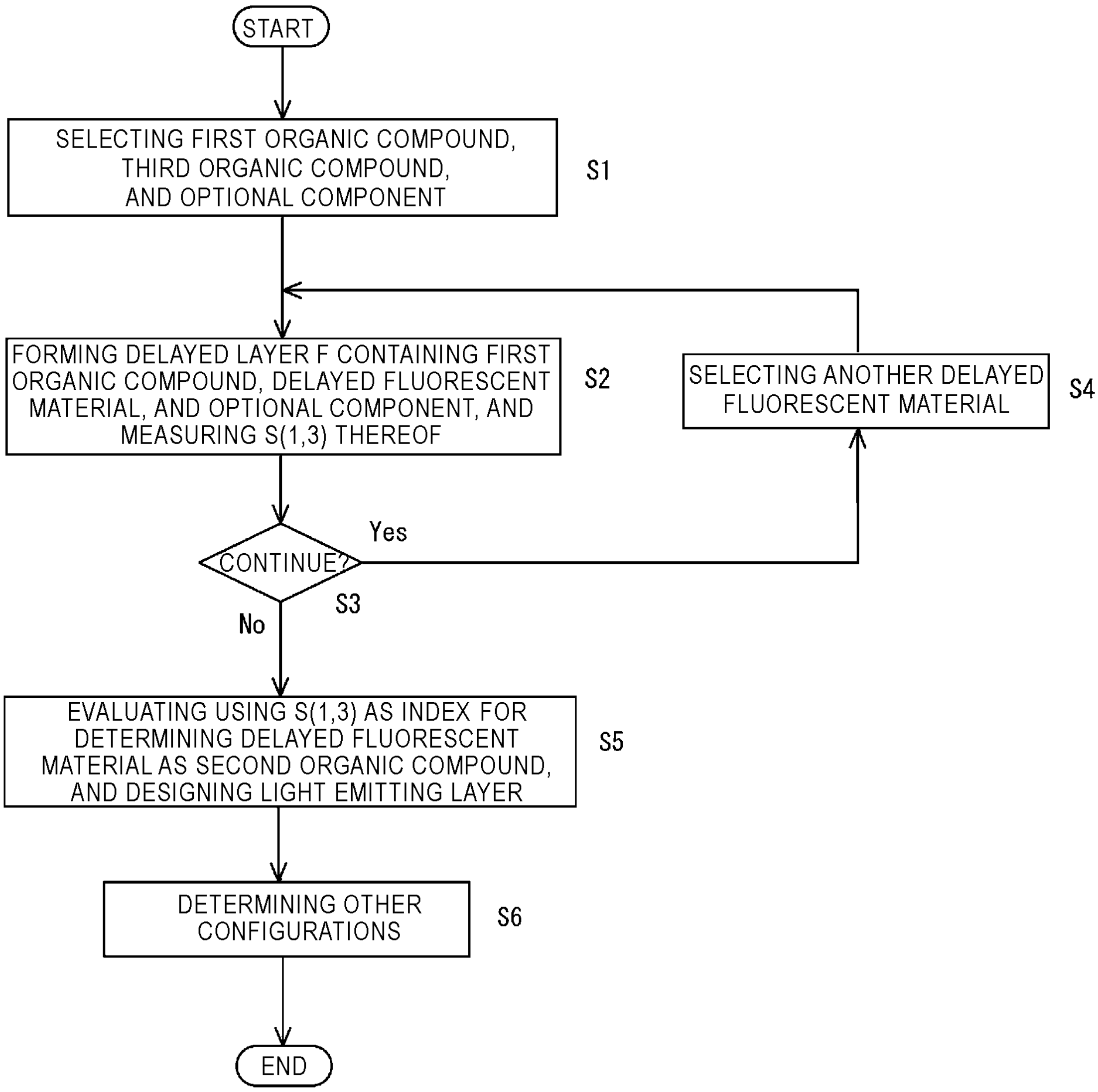
START
SELECTING FIRST ORGANIC COMPOUND, THIRD ORGANIC COMPOUND, AND OPTIONAL COMPONENT
S1
FORMING DELAYED LAYER F CONTAINING FIRST ORGANIC COMPOUND, DELAYED FLUORESCENT MATERIAL, AND OPTIONAL COMPONENT, AND MEASURING S(1,3) THEREOF
S2
SELECTING ANOTHER DELAYED FLUORESCENT MATERIAL
S4
Yes
CONTINUE?
S3
No
EVALUATING USING S(1,3) AS INDEX FOR DETERMINING DELAYED FLUORESCENT MATERIAL AS SECOND ORGANIC COMPOUND, AND DESIGNING LIGHT EMITTING LAYER
S5
DETERMINING OTHER CONFIGURATIONS
S6
END

## INTERNATIONAL SEARCH REPORT

International application No.
**PCT/JP2022/026567**

**A. CLASSIFICATION OF SUBJECT MATTER**

***H01L 51/50***(2006.01)i; ***C09K 11/06***(2006.01)i
FI: H05B33/14 B; C09K11/06 660; C09K11/06 645

According to International Patent Classification (IPC) or to both national classification and IPC

**B. FIELDS SEARCHED**

Minimum documentation searched (classification system followed by classification symbols)

H01L51/50; C09K11/06

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | US 2021/0119145 A1 (LG DISPLAY CO., LTD.) 22 April 2021 (2021-04-22) abstract, paragraphs [0080], [0087], [0097], [0100], [0102], [0107]-[0109], [0163], fig. 5 | 1-11 |
| A | | 12-16 |
| X | JP 2019-204947 A (CYNORA GMBH) 28 November 2019 (2019-11-28) paragraphs [0074], [0109]-[0112] | 1-7, 9-11 |
| A | | 12-16 |
| X | WO 2020/040298 A1 (KWANSEI GAKUIN EDUCATIONAL FOUNDATION) 27 February 2020 (2020-02-27) abstract, paragraphs [0379]-[0381], [0386]-[0391], [0401]-[0406] | 1-7, 9-11 |
| A | | 12-16 |
| X | US 2020/0185632 A1 (LG DISPLAY CO., LTD.) 11 June 2020 (2020-06-11) paragraphs [0207], [0221], [0225], [0227], [0231]-[0233], tables 1-2, fig. 3, 6 | 1-7, 9-11 |
| A | | 12-16 |
| A | JP 2015-109405 A (IDEMITSU KOSAN CO., LTD.) 11 June 2015 (2015-06-11) entire text, all drawings | 1-16 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 July 2022** | **09 August 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/026567**

| Patent document cited in search report | Publication date (day/month/year) | Patent family member(s) | Publication date (day/month/year) |
|---|---|---|---|
| US 2021/0119145 A1 | 22 April 2021 | KR 10-2021-0046539 A | |
| | | CN 112687816 A | |
| JP 2019-204947 A | 28 November 2019 | US 2019/0341571 A1 paragraphs [0104], [0155]-[0159], tables 1-2 | |
| | | EP 3565018 A1 | |
| | | KR 10-2019-0127581 A | |
| WO 2020/040298 A1 | 27 February 2020 | KR 10-2021-0050537 A | |
| | | CN 113169285 A | |
| US 2020/0185632 A1 | 11 June 2020 | KR 10-2020-0071313 A | |
| | | CN 111312911 A | |
| JP 2015-109405 A | 11 June 2015 | US 2016/0211466 A1 entire text, all drawings | |
| | | WO 2015/060352 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014043541 A
- JP 2015179809 A
- WO 2013154064 A
- WO 2015080183 A
- WO 2015129715 A
- JP 2017119663 A
- JP 2017119664 A
- WO 2013081088 A
- WO 2013011954 A
- WO 2013011955 A
- JP 2013256490 A
- JP 2013116975 A
- WO 2013133359 A
- WO 2013161437 A
- JP 2014009352 A
- JP 2014009224 A
- JP 2017 A
- JP 119663 A
- JP 2017222623 A
- JP 2017226838 A
- JP 2018100411 A
- WO 2018047853 A
- JP 2013253121 A
- WO 2014034535 A
- WO 2014115743 A
- WO 2014122895 A
- WO 2014126200 A
- WO 2014136758 A
- WO 2014133121 A
- WO 2014136860 A
- WO 2014196585 A
- WO 2014189122 A
- WO 2014168101 A
- WO 2015008580 A
- WO 2014203840 A
- WO 2015002213 A
- WO 2015016200 A
- WO 2015019725 A
- WO 2015072470 A
- WO 2015108049 A
- WO 2015080182 A
- WO 2015072537 A
- JP 2015129240 A
- WO 2015129714 A
- WO 2015133501 A
- WO 2015136880 A
- WO 2015137244 A
- WO 2015137202 A
- WO 2015137136 A
- WO 2015146541 A
- WO 2015159541 A
- WO 2015022974 A
- WO 2021015177 A

### Non-patent literature cited in the description

- **UOYAMA et al.** *Nature,* 2012, vol. 492, 234
- **HANSCH, C.** *Chem. Rev.,* 1991, vol. 91, 165-195